# EUROPEAN PATENT APPLICATION

(11) **EP 4 580 379 A1**
(43) Date of publication of application: **02.07.2025**
(21) Application number: 24223495.3
(22) Date of filing: 27.12.2024
(51) Int. Cl.: H10K 85/30, H10K 85/60, H10K 101/20

(54) **LIGHT-EMITTING DEVICE COMPRISING CONDENSED CYCLIC COMPOUND, ELECTRONIC APPARATUS COMPRISING THE LIGHT-EMITTING DEVICE, AND THE CONDENSED CYCLIC COMPOUND**

(30) Priority: 29.12.2023 KR 20230197604
(71) Applicant: Samsung Display Co., Ltd., Yongin-si, Gyeonggi-do 17113 (KR)
(72) Inventor: SIM, Munki, 17113 Yongin-si (KR); KIM, Taeil, 17113 Yongin-si (KR); PAK, Sunyoung, 17113 Yongin-si (KR); PARK, Junha, 17113 Yongin-si (KR); JUN, Mieun, 17113 Yongin-si (KR); JUNG, Minjung, 17113 Yongin-si (KR); HAN, Giwoong, 17113 Yongin-si (KR); HUR, Seonhyoung, 17113 Yongin-si (KR)
(74) Representative: Crow, Martin

(57) **Abstract**

Embodiments provide a condensed cyclic compound, a light-emitting device that comprises the condensed cyclic compound, and an electronic apparatus that comprises the light-emitting device. The light-emitting device comprises a first electrode, a second electrode facing the first electrode, and an interlayer between the first electrode and the second electrode and comprising an emission layer, wherein the interlayer comprises the condensed cyclic compound. The condensed cyclic compound comprises a boron (B) atom, a ratio of a surface area to volume of the condensed cyclic compound has a value less than or equal to about 0.9 Å⁻¹, and a molecular weight of the condensed cyclic compound is greater than or equal to about 1,000 g/mol.

## Description

### CROSS-REFERENCE TO RELATED APPLICATION(S)

This application claims priority to and benefits of Korean Patent Application No. 10-2023-0197604 under 35 U.S.C. §119, filed on December 29, 2023, in the Korean Intellectual Property Office, the entire contents of which are incorporated herein by reference.

### BACKGROUND

### 1. Technical Field

Embodiments relate to a light-emitting device comprising a condensed cyclic compound, an electronic apparatus comprising the light-emitting device, and the condensed cyclic compound.

### 2. Description of the Related Art

Light-emitting devices are self-emission devices that, as compared with devices of the related art, have wide viewing angles, high contrast ratios, short response times, and excellent characteristics in terms of luminance, driving voltage, and response speed, and produce full-color images.

The light-emitting devices may have a structure in which a first electrode is located on a substrate, and a hole transport region, an emission layer, an electron transport region, and a second electrode may be sequentially formed on the first electrode. Holes provided from the first electrode may move toward the emission layer through the hole transport region, and electrons provided from the second electrode may move toward the emission layer through the electron transport region. Carriers, such as the holes and the electrons, recombine in the emission layer to produce excitons. These excitons may transition from an excited state to a ground state, thereby generating light.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Embodiments comprise a light-emitting device comprising a condensed cyclic compound, an electronic apparatus comprising the light-emitting device, and the condensed cyclic compound.

Additional aspects will be set forth in part in the description which follows and, in part, will be apparent from the description, or may be learned by practice of the embodiments of the disclosure.

According to embodiments, a light-emitting device may comprise
a first electrode, a second electrode facing the first electrode, and an interlayer between the first electrode and the second electrode and comprising an emission layer, wherein
the interlayer may comprise a condensed cyclic compound,
the condensed cyclic compound may comprise a boron (B) atom,
a ratio of a surface area to volume of the condensed cyclic compound may have a value less than or equal to about 0.9 Å⁻¹, and
a molecular weight of the condensed cyclic compound may be greater than or equal to about 1,000 g/mol.

In an embodiment, the first electrode may be an anode; the second electrode may be a cathode; the interlayer may further comprise a hole transport region between the first electrode and the emission layer, and an electron transport region between the emission layer and the second electrode; the hole transport region may comprise a hole injection layer, a hole transport layer, an emission auxiliary layer, an electron blocking layer, or any combination thereof; and the electron transport region may comprise a hole blocking layer, an electron transport layer, an electron injection layer, or any combination thereof.

In an embodiment, the emission layer may comprise the condensed cyclic compound.

In an embodiment, the condensed cyclic compound in the emission layer may be a thermally activated delayed fluorescence (TADF) emitter; and the emission layer may emit delayed fluorescence.

In an embodiment, a first compound may comprise: the condensed cyclic compound; and a second compound comprising a group represented by Formula 20, a third compound comprising at least one π electron-deficient nitrogen-containing C₁-C₆₀ cyclic group, a fourth compound comprising a transition metal, or any combination thereof, wherein

the first compound, the second compound, the third compound, and the fourth compound may be different from each other, where Formula 20 is explained below.

In an embodiment, the emission layer may comprise the first compound comprising the condensed cyclic compound, and at least one of the second compound and the third compound; and the emission layer may optionally further comprise the fourth compound.

In an embodiment, the third compound may comprise a pyridine group, a pyrimidine group, a pyrazine group, a pyridazine group, a triazine group, or any combination thereof.

According to embodiments, an electronic apparatus may comprise the light-emitting device.

In an embodiment, the electronic apparatus may further comprise a thin-film transistor, wherein the thin-film transistor may comprise a source electrode and a drain electrode, and the first electrode of the light-emitting device may be electrically connected to the source electrode or the drain electrode.

According to embodiments, a condensed cyclic compound may comprise a core comprising at least one cyclic group comprising a boron (B) atom and a nitrogen (N) atom each as a ring-forming atom, wherein
a ratio of a surface area to volume of the condensed cyclic compound may have a value less than or equal to about 0.9 Å⁻¹, and
a molecular weight of the condensed cyclic compound may be greater than or equal to about 1,000 g/mol.

In an embodiment, a sublimation temperature of the condensed cyclic compound may be less than or equal to about 370 °C.

In an embodiment, at least one of hydrogen atoms of the core of the condensed cyclic compound may be substituted with a substituent having a molecular weight greater than or equal to about 153 g/mol.

In an embodiment, the core may comprise at least two nitrogen (N) atoms, and one of the at least two nitrogen atoms may be substituted with a substituent having a molecular weight greater than or equal to about 153 g/mol.

In an embodiment, the substituent having a molecular weight greater than or equal to about 153 g/mol may comprise a group represented by Formula A, which is explained below.

In an embodiment, the core may comprise a boron (B) atom and at least two nitrogen (N) atoms, and one of the at least two nitrogen (N) atoms may be substituted with a substituent that has a molecular weight greater than or equal to about 153 g/mol, and comprises two or more rings. In an embodiment, the core may comprise two boron (B) atoms and at least two nitrogen (N) atoms. In an embodiment, the core may comprise two boron (B) atoms and at least two nitrogen (N) atoms, and one of the at least two nitrogen (N) atoms may be substituted with a substituent that has a molecular weight greater than or equal to about 153 g/mol, and comprises two or more rings.

In an embodiment, in the substituent, the two or more rings may each independently be a C₆-C₆₀ aryl group unsubstituted or substituted with at least one R₁₀ₐ, a C₁-C₆₀ heteroaryl group unsubstituted or substituted with at least one R₁₀ₐ, a non-aromatic condensed polycyclic group unsubstituted or substituted with at least one R₁₀ₐ, or a non-aromatic condensed heteropolycyclic group unsubstituted or substituted with at least one R₁₀ₐ, wherein R₁₀ₐ is explained below.

In an embodiment, the condensed cyclic compound may be represented by Formula 1, which is explained below.

In an embodiment, Ar₂ may be a group represented by Formula B, which is explained below.

In an embodiment, Ar₁₁ and Ar₁₂ may each independently be a C₆-C₆₀ aryl group, a C₁-C₆₀ heteroaryl group, a non-aromatic condensed polycyclic group, or a non-aromatic condensed heteropolycyclic group.

In an embodiment, a1 to a3 may each independently be an integer from 1 to 10; at least one of R₁ in the number of a1 may not be hydrogen; at least one of R₂ in the number of a2 may not be hydrogen; and at least one of R₃ in the number of a3 may not be hydrogen.

It is to be understood that the embodiments above are described in a generic and explanatory sense only and not for the purpose of limitation, and the disclosure is not limited to the embodiments described above.

### BRIEF DESCRIPTION OF THE DRAWINGS

The accompanying drawings are included to provide a further understanding of the embodiments, and are incorporated in and constitute a part of this specification. The drawings illustrate embodiments of the disclosure and principles thereof. The above and other aspects and features of the disclosure will be more apparent by describing in detail embodiments thereof with reference to the accompanying drawings, in which:
FIG. 1 is a schematic cross-sectional view of a light-emitting device according to an embodiment;
FIG. 2 is a schematic cross-sectional view of an electronic apparatus according to an embodiment;
FIG. 3 is a schematic cross-sectional view of an electronic apparatus according to another embodiment;
FIG. 4 is a schematic perspective view of electronic equipment comprising a light-emitting device according to an embodiment;
FIG. 5 is a schematic perspective view of an exterior of a vehicle as an electronic equipment comprising a light-emitting device according to an embodiment; and
FIGS. 6A to 6C are each a schematic diagram of an interior of a vehicle according to various embodiments.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, the sizes, thicknesses, ratios, and dimensions of the elements may be exaggerated for ease of description and for clarity. Like reference numbers and/or like reference characters refer to like elements throughout.

In the description, it will be understood that when an element (or region, layer, part, etc.) is referred to as being "on", "connected to", or "coupled to" another element, it can be directly on, connected to, or coupled to the other element, or one or more intervening elements may be present therebetween. In a similar sense, when an element (or region, layer, part, etc.) is described as "covering" another element, it can directly cover the other element, or one or more intervening elements may be present therebetween.

In the description, when an element is "directly on," "directly connected to," or "directly coupled to" another element, there are no intervening elements present. For example, "directly on" may mean that two layers or two elements are disposed without an additional element such as an adhesion element therebetween.

As used herein, the expressions used in the singular such as "a," "an," and "the," are intended to include the plural forms as well, unless the context clearly indicates otherwise.

As used herein, the term "and/or" comprises any and all combinations of one or more of the associated listed items. For example, "A and/or B" may be understood to mean "A, B, or A and B." The terms "and" and "or" may be used in the conjunctive or disjunctive sense and may be understood to be equivalent to "and/or".

In the specification and the claims, the term "at least one of" is intended to include the meaning of "at least one selected from the group consisting of" for the purpose of its meaning and interpretation. For example, "at least one of A, B, and C" may be understood to mean A only, B only, C only, or any combination of two or more of A, B, and C, such as ABC, ACC, BC, or CC. When preceding a list of elements, the term, "at least one of," modifies the entire list of elements and does not modify the individual elements of the list.

It will be understood that, although the terms first, second, etc. may be used herein to describe various elements, these elements should not be limited by these terms. These terms are only used to distinguish one element from another element. Thus, a first element could be termed a second element without departing from the teachings of the disclosure. Similarly, a second element could be termed a first element, without departing from the scope of the disclosure.

The spatially relative terms "below", "beneath", "lower", "above", "upper", or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

The terms "about" or "approximately" as used herein is inclusive of the stated value and means within an acceptable range of deviation for the recited value as determined by one of ordinary skill in the art, considering the measurement in question and the error associated with measurement of the recited quantity (for example, the limitations of the measurement system). For example, "about" may mean within one or more standard deviations, or within ±20%, ±10%, or ±5% of the stated value.

It should be understood that the terms "comprises," "comprising," "includes," "including," "have," "having," "contains," "containing," and the like are intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined or implied herein, all terms (including technical and scientific terms) used have the same meaning as commonly understood by those skilled in the art to which this disclosure pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification.

In an embodiment, a light-emitting device (for example, an organic light-emitting device) may comprise: a first electrode; a second electrode facing the first electrode; and an interlayer between the first electrode and the second electrode and comprising an emission layer, wherein the interlayer may comprise a condensed cyclic compound.

Hereinafter, the condensed cyclic compound will be described.

In an embodiment, a ratio of a surface area to volume of the condensed cyclic compound may have a value less than or equal to about 0.9 Å⁻¹.

The value of a ratio of surface area to volume of the condensed cyclic compound may be calculated by using the program Material Studio 2018, referring to the method of calculating a molecular surface area as described in J.Appl.Cryst.(1983), 16, 548-558.

According to an embodiment, a ratio of a surface area to volume of the condensed cyclic compound may have a value less than or equal to about 0.89 Å⁻¹. For example, the ratio of a surface area to volume of the condensed cyclic compound may have a value less than or equal to about 0.88 Å⁻¹. For example, a ratio of a surface area to volume of the condensed cyclic compound may have a value less than or equal to about 0.87 Å⁻¹. For example, a ratio of a surface area to volume of the condensed cyclic compound may have a value less than or equal to about 0.85 Å⁻¹.

In an embodiment, a molecular weight of the condensed cyclic compound may be greater than or equal to about 1,000 g/mol.

According to an embodiment, the molecular weight of the condensed cyclic compound may be greater than or equal to about 1,010 g/mol. For example, the molecular weight of the condensed cyclic compound may be greater than or equal to about 1,020 g/mol. For example, the molecular weight of the condensed cyclic compound may be greater than or equal to about 1,030 g/mol. For example, the molecular weight of the condensed cyclic compound may be greater than or equal to about 1,040 g/mol. For example, the molecular weight of the condensed cyclic compound may be greater than or equal to about 1,050 g/mol.

The smaller the value of a ratio of a surface area to volume of a molecule, which is namely the surface area divided by the volume, the closer the shape of the molecule may be to the form of a sphere. In an embodiment, a compound may have a shape in which a substituent of the compound surrounds and protects a core so that, for example, when the core of the compound comprises a boron (B) atom, the substituent may protect the empty p orbital of boron, thus increasing the stability of the compound.

In an embodiment, even if the ratio of a surface area to volume of the compound has a small value, when the molecular weight of the compound is less than or equal to about 1,000 g/mol, the substituent of the compound may not be large enough and the substituent may not exist in the protective position of the core, thus decreasing the effect that the substituent protects the core.

The smaller the value of a ratio of the surface area to volume of the molecule, the smaller the surface area of the molecule, which means that the distance between the central core and the outermost of the molecule may increase. As the surface area of a molecule decreases, the number of surrounding molecules that may interact with each other decreases, and as the distance between the central core and the outermost of the molecule increases, the distance between molecules increases. Therefore, interactions with adjacent molecules may be reduced, and thus intermolecular pi-pi stacking and Dexter energy transfer (DET) may be reduced, and the sublimation temperature may also be reduced.

Light-emitting devices that comprise such condensed cyclic compounds may have improved luminescence efficiency and lifespan characteristics.

In an embodiment, a sublimation temperature of the condensed cyclic compound may be less than or equal to about 370 °C.

The sublimation temperature of the condensed cyclic compound may be a value measured by sublimating 1 g of the condensed cyclic compound.

According to an embodiment, a sublimation temperature of the condensed cyclic compound may be less than or equal to about 370 °C. For example, the sublimation temperature of the condensed cyclic compound may be less than or equal to about 365 °C. For example, the sublimation temperature of the condensed cyclic compound may be less than or equal to about 360 °C. For example, the sublimation temperature of the condensed cyclic compound may be less than or equal to about 355 °C. For example, sublimation temperature of the condensed cyclic compound may be less than or equal to about 350 °C.

In an embodiment, the condensed cyclic compound may comprise a boron (B) atom. In an embodiment, the condensed cyclic compound may comprise at least two boron (B) atoms.

According to an embodiment, the condensed cyclic compound may comprise a core comprising at least one cyclic group comprising a boron (B) atom and a nitrogen (N) atom each as a ring-forming atom. According to an embodiment, the condensed cyclic compound may comprise a core comprising at least one cyclic group comprising at least two boron (B) atoms and a nitrogen (N) atom each as a ring-forming atom.

According to an embodiment, at least one of hydrogen atoms of the core of the condensed cyclic compound may be substituted with a substituent having a molecular weight greater than or equal to about 153 g/mol.

According to an embodiment, the core may comprise at least two nitrogen (N) atoms, and one of the at least two nitrogen atoms may be substituted with a substituent having a molecular weight greater than or equal to about 153 g/mol.

According to an embodiment, the substituent having a molecular weight greater than or equal to about 153 g/mol may comprise a group represented by Formula A:

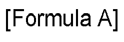

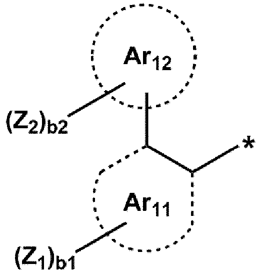

In Formula A,
Ar₁₁ and Ar₁₂ may each independently be a C₃-C₆₀ carbocyclic group or a C₁-C₆₀ heterocyclic group,
Z₁ and Z₂ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁ )(Q₂), - B(Q₁)(Q₂), -C(=O)(Q₁), -S(=O)₂(Q₁), or -P(=O)(Q₁)(Q₂),
two or more neighboring ones of Z₁ in the number of b1 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of Z₂ in the number of b2 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of Z₁ and Z₂ may be optionally bonded to each other to form a C₅-C₃₀ carbocyclic group unsubstituted or substituted with at least one R_{10b} or a C₁-C₃₀ heterocyclic group unsubstituted or substituted with at least one R_{10b},
b1 and b2 may each independently be an integer from 0 to 10,
* indicates a binding site to a neighboring atom, and
R₁₀ₐ, R_{10b}, and Q₁ to Q₃ may each be the same as described herein.

According to another embodiment, the core may comprise a boron (B) atom and at least two nitrogen (N) atoms, and one of the at least two nitrogen (N) atoms may be substituted with a substituent that may have a molecular weight greater than or equal to about 153 g/mol, and that may comprise two or more rings.

According to another embodiment, the core may comprise at least two boron (B) atoms and at least two nitrogen (N) atoms, and one of the at least two nitrogen (N) atoms may be substituted with a substituent that may have a molecular weight greater than or equal to about 153 g/mol, and that may comprise two or more rings.

According to another embodiment, in the substituent, the two or more rings may each independently be a C₆-C₆₀ aryl group unsubstituted or substituted with at least one R₁₀ₐ, a C₁-C₆₀ heteroaryl group unsubstituted or substituted with at least one R₁₀ₐ, a non-aromatic condensed polycyclic group unsubstituted or substituted with at least one R₁₀ₐ, or a non-aromatic condensed heteropolycyclic group unsubstituted or substituted with at least one R₁₀ₐ. R₁₀ₐ may be the same as described herein.

In an embodiment, in the substituent, the two or more rings may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each unsubstituted or substituted with at least one R₁₀ₐ.

According to an embodiment, at least one hydrogen of the condensed cyclic compound may be substituted with deuterium.

According to an embodiment, the condensed cyclic compound may be represented by Formula 1:

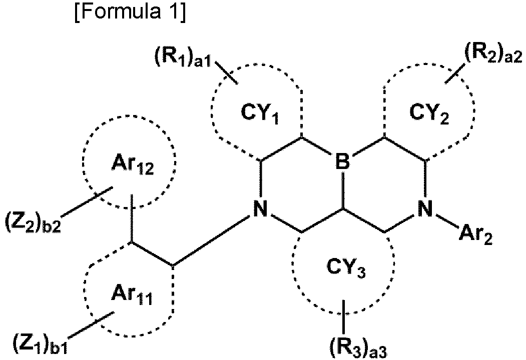

In Formula 1, ring CY₁ to ring CY₃, Ar₁₁, and Ar₁₂ may each independently be a C₃-C₆₀ carbocyclic group or a C₁-C₆₀ heterocyclic group.

According to an embodiment, Ar₁₁ and Ar₁₂ may each independently be a C₆-C₆₀ aryl group, a C₁-C₆₀ heteroaryl group, a non-aromatic condensed polycyclic group, or a non-aromatic condensed heteropolycyclic group.

According to an embodiment, ring CY₁ to ring CY₃, Ar₁₁, and Ar₁₂ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzoimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In Formula 1, Ar₂ may be a C₃-C₆₀ carbocyclic group unsubstituted or substituted with at least one R₁₀ₐ or a C₁-C₆₀ heterocyclic group unsubstituted or substituted with at least one R₁₀ₐ. R₁₀ₐ may be the same as described herein.

According to an embodiment, Ar₂ may be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each unsubstituted or substituted with at least one R₁₀ₐ.

According to an embodiment, Ar₂ may be a group represented by Formula B:

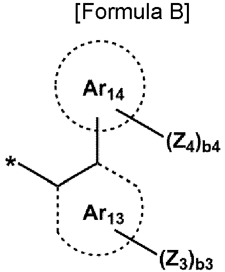

In Formula B,
Ar₁₃ and Ar₁₄ may each independently be a C₃-C₆₀ carbocyclic group or a C₁-C₆₀ heterocyclic group,
Z₃ and Z₄ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁ )(Q₂), - B(Q₁)(Q₂), -C(=O)(Q₁), -S(=O)₂(Q₁), or -P(=O)(Q₁)(Q₂),
two or more neighboring ones of Z₃ in the number of b3 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of Z₄ in the number of b4 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of Z₃ and Z₄ may be optionally bonded to each other to form a C₅-C₃₀ carbocyclic group unsubstituted or substituted with at least one R_{10b} or a C₁-C₃₀ heterocyclic group unsubstituted or substituted with at least one R_{10b},
b3 and b4 may each independently be an integer from 0 to 10,
* indicates a binding site to a neighboring atom, and
R₁₀ₐ, R_{10b}, and Q₁ to Q₃ may be the same as described herein.

According to an embodiment, Ar₁₃ and Ar₁₄ may each independently be a C₆-C₆₀ aryl group, a C₁-C₆₀ heteroaryl group, a non-aromatic condensed polycyclic group, or a non-aromatic condensed heteropolycyclic group.

In Formula 1, R₁ to R₃, Z₁, and Z₂ may each independently be hydrogen, deuterium, - F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂ )(Q₃), - N(Q₁)(Q₂), -B(Q₁)(Q₂), -C(=O)(Q₁), -S(=O)₂(Q₁), or-P(=O) (Q₁)(Q₂). R₁₀ₐ and Q₁ to Q₃ may each be the same as described herein.

According to an embodiment, R₁ to R₃, Z₁, and Z₂ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with at least one of deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a 1,2,3,4-tetrahydronaphthalenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinolinyl group, a carbazolyl group, a phenanthrolinyl group, a benzoimidazolyl group, a benzofuranyl group, a benzothiophenyl group, an isobenzothiazolyl group, an benzooxazolyl group, an isobenzooxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with at least one of deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a 1,2,3,4-tetrahydronaphthalenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinolinyl group, a carbazolyl group, a phenanthrolinyl group, a benzoimidazolyl group, a benzofuranyl group, a benzothiophenyl group, an isobenzothiazolyl group, a benzoxazolyl group, an isobenzooxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), and - P(=O)(Q₃₁)(Q₃₂); or
-Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂), and
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, or -CD₂CDH₂; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with at least one of deuterium, a C₁-C₁₀ alkyl group, a phenyl group, a biphenyl group, a pyridinyl group, a pyrimidinyl group, a pyridazinyl group, a pyrazinyl group, and a triazinyl group.

According to an embodiment, R₁ to R₃, Z₁, and Z₂ may each independently be:
hydrogen, deuterium, -F, -Cl, -Br, -I, -CD₃, -CD₂H, -CDH₂, -CF₃, -CF₂H, - CFH₂, a C₁-C₆₀ alkyl group, a C₂-C₆₀ alkenyl group, a C₂-C₆₀ alkynyl group, or a C₁-C₆₀ alkoxy group; or
a group represented by any one of Formulae 9-1 to 9-61, 9-201 to 9-240, 10-1 to 10-129, and 10-201 to 10-355:

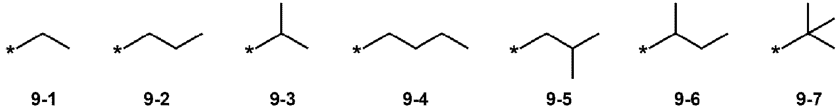

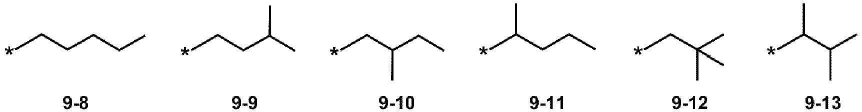

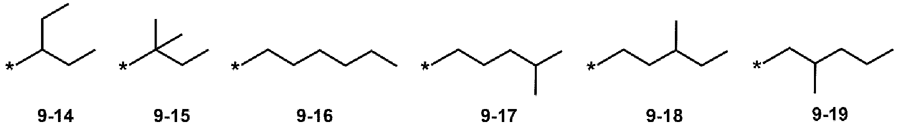

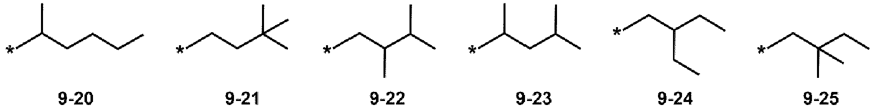

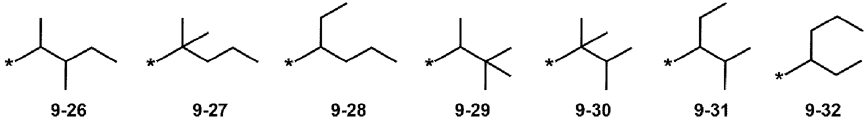

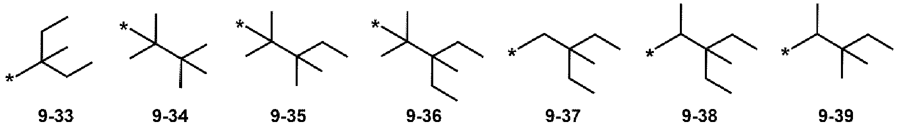

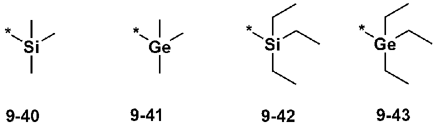

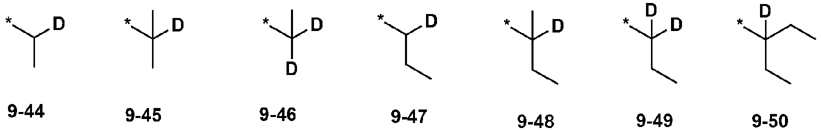

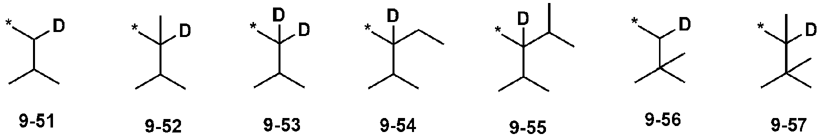

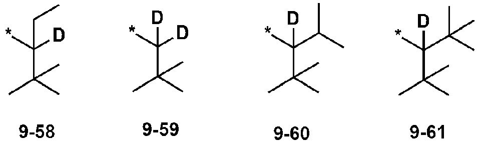

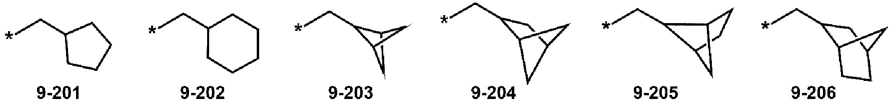

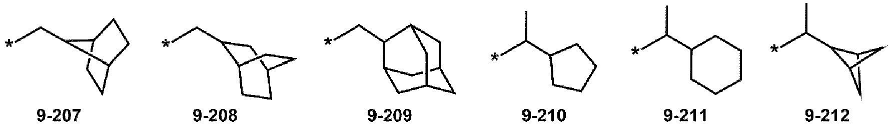

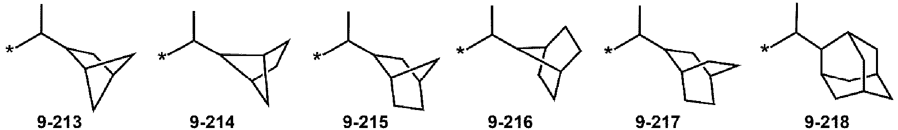

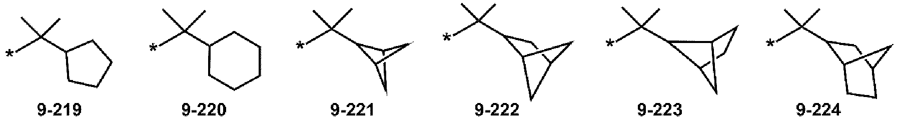

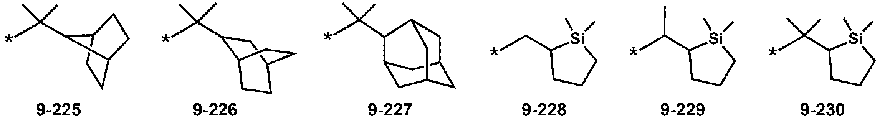

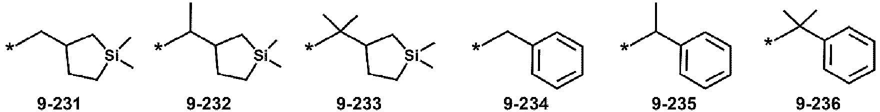

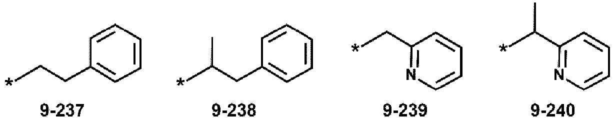

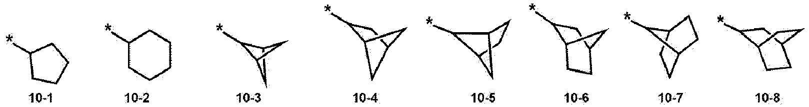

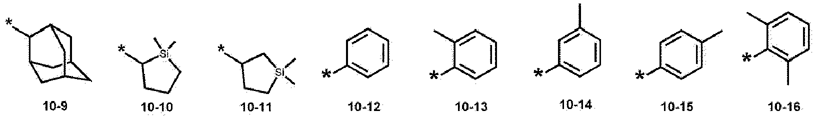

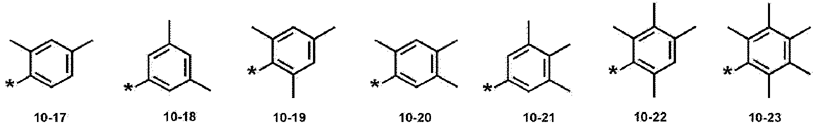

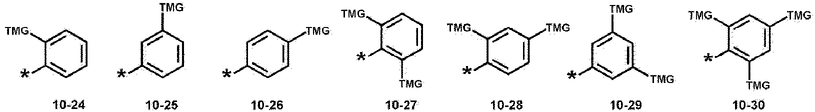

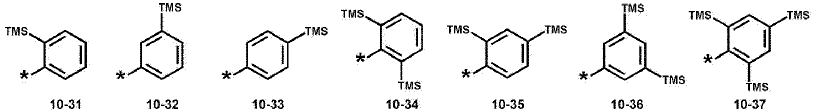

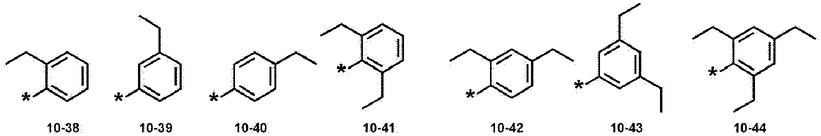

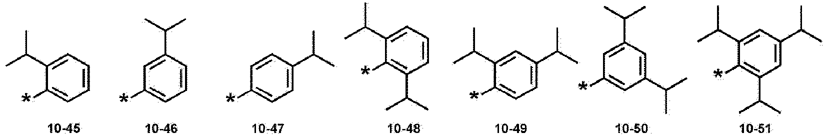

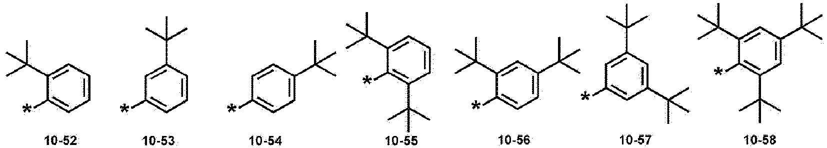

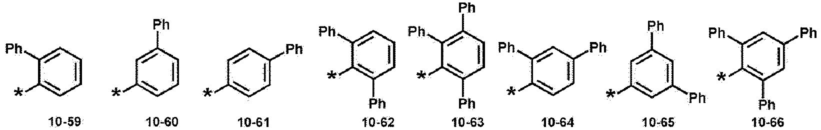

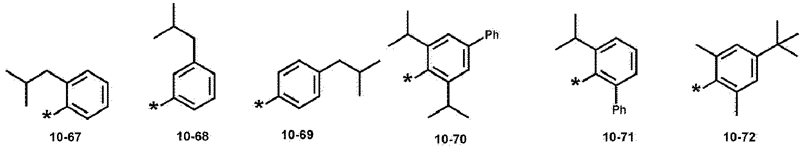

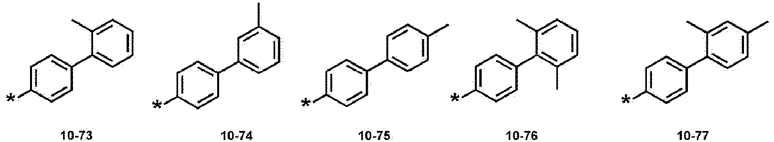

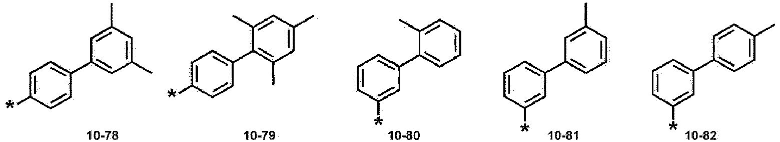

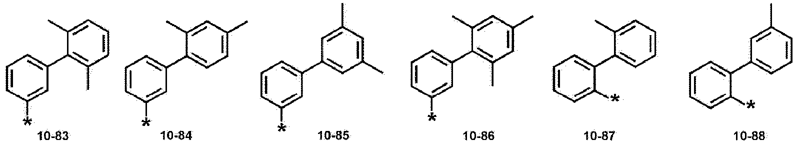

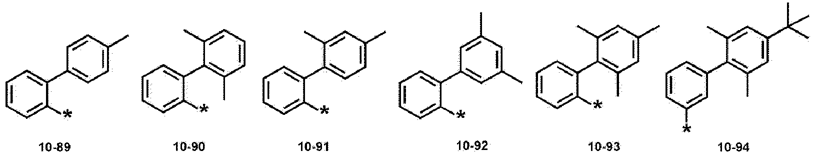

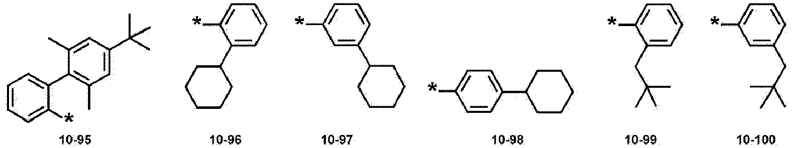

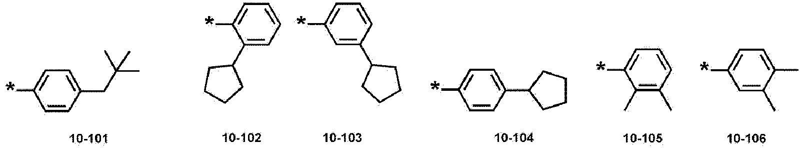

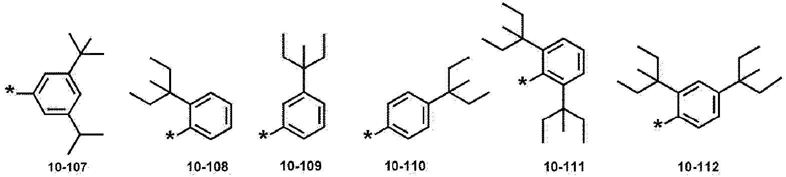

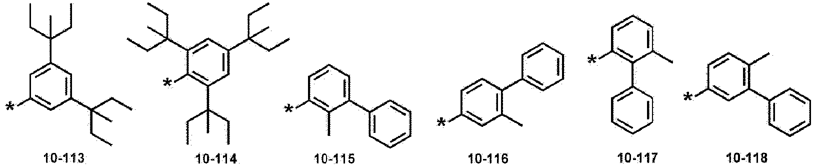

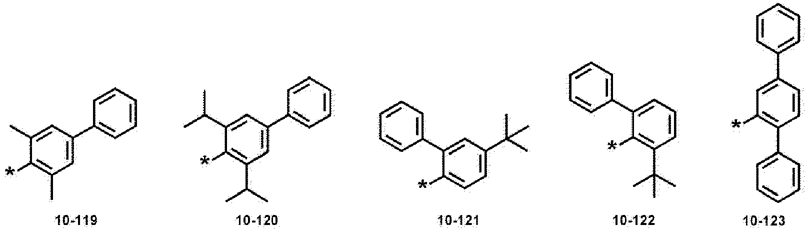

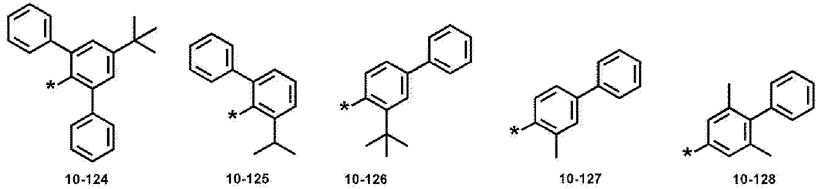

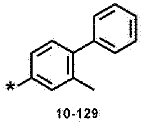

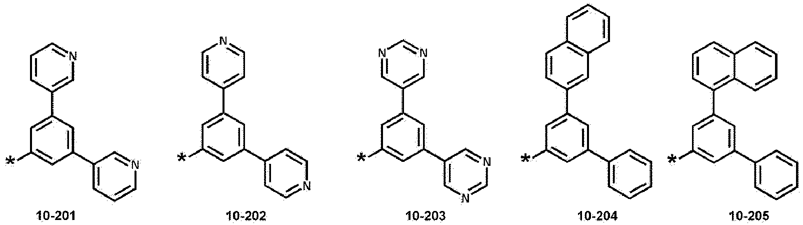

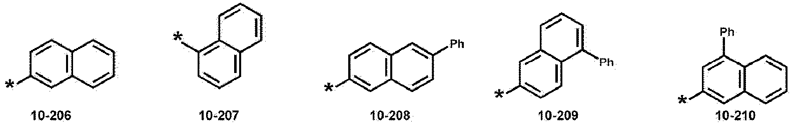

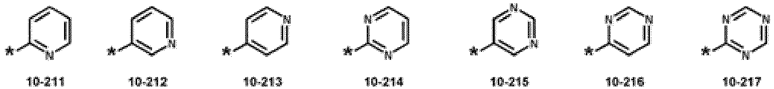

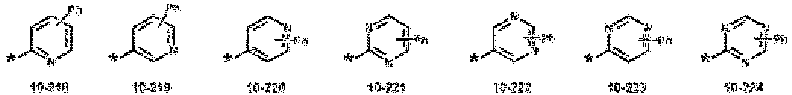

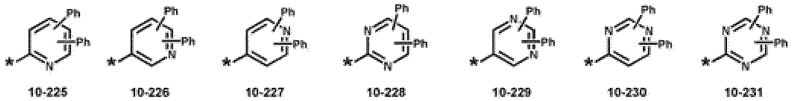

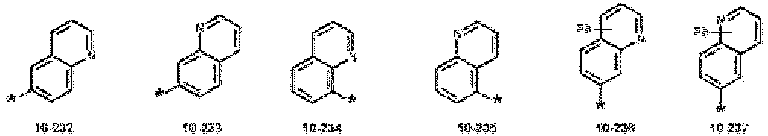

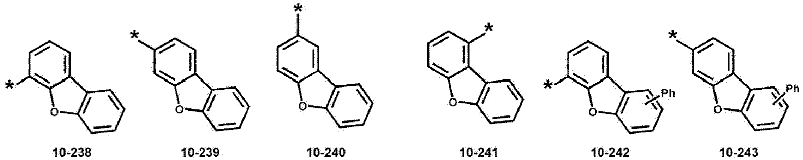

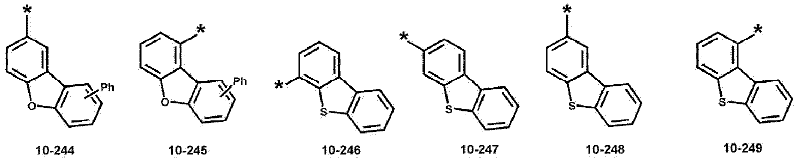

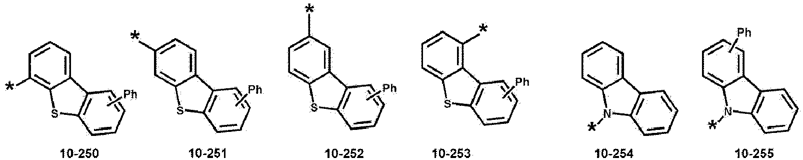

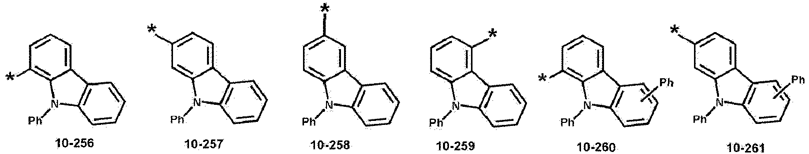

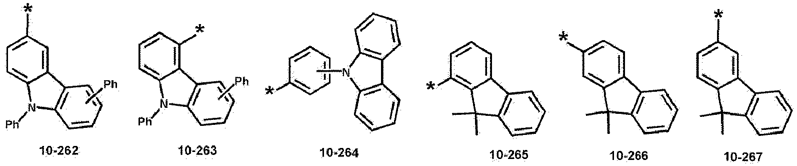

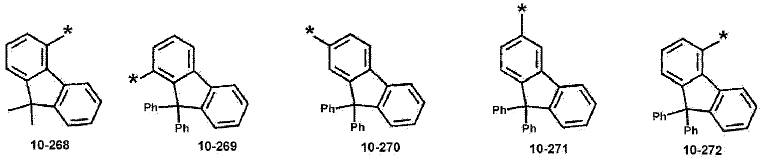

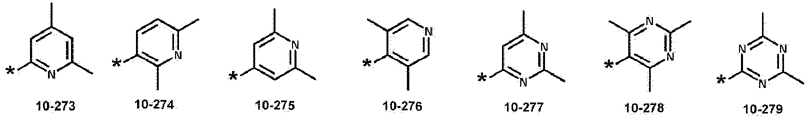

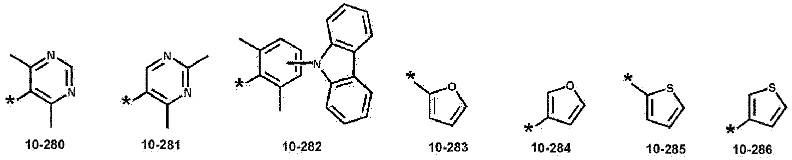

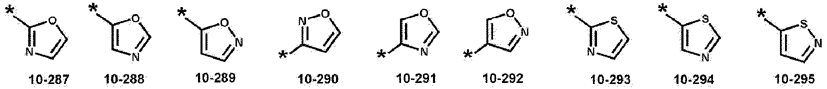

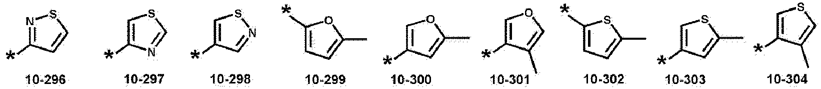

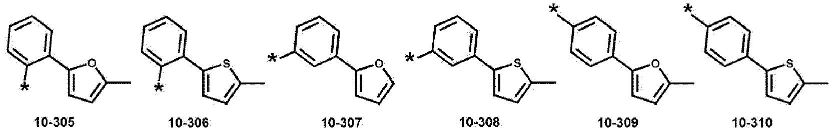

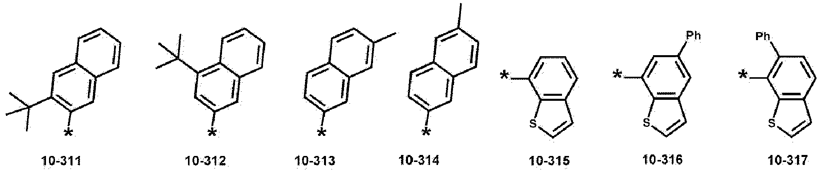

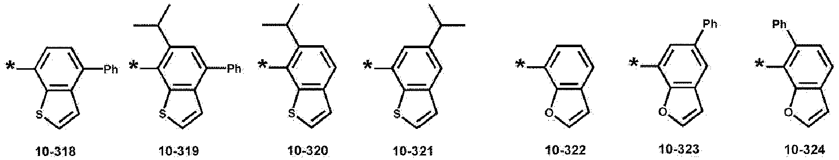

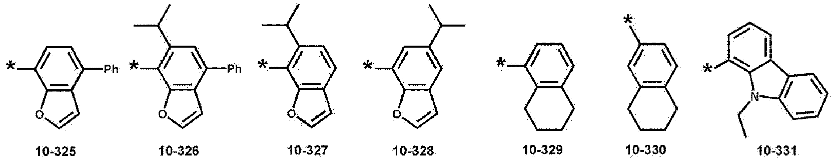

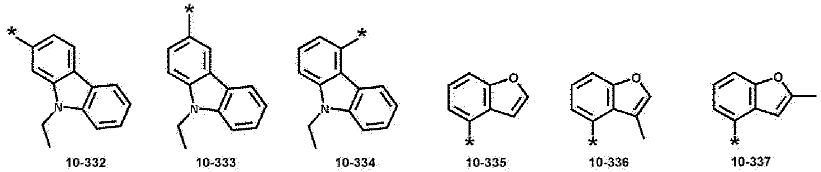

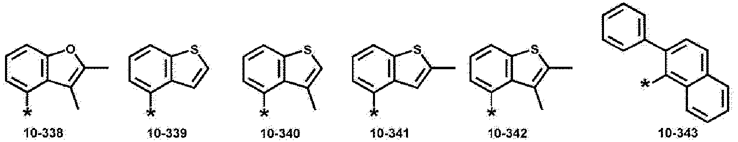

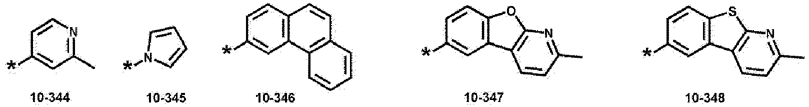

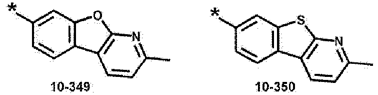

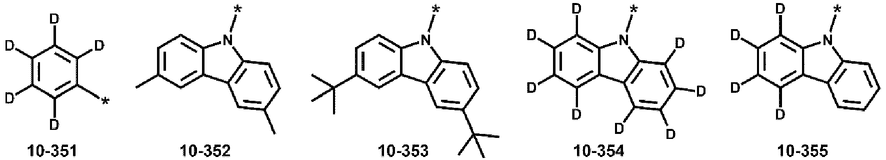

In Formulae 9-1 to 9-61, 9-201 to 9-240, 10-1 to 10-129, and 10-201 to 10-355, * indicates a binding site to a neighboring atom, Ph may be a phenyl group, TMS may be a trimethylsilyl group, and TMG may be a trimethylgermyl group.

In Formula 1, two or more neighboring ones of R₁ in the number of a1 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b}.

In Formula 1, two or more neighboring ones of R₂ in the number of a2 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b}.

In Formula 1, two or more neighboring ones of R₃ in the number of a3 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b}.

In Formula 1, two or more neighboring ones of Z₁ in the number of b1 may be optionally bonded to each other to form a C₅-C₃₀ carbocyclic group unsubstituted or a substituted with at least one R_{10b} or a C₁-C₃₀ heterocyclic group unsubstituted or substituted with at least one R_{10b}.

In Formula 1, two or more neighboring ones of Z₂ in the number of b2 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b}.

In Formula 1, two or more neighboring ones of Z₁ and Z₂ may be optionally bonded to each other to form a C₅-C₃₀ carbocyclic group unsubstituted or substituted with at least one R_{10b} or a C₁-C₃₀ heterocyclic group unsubstituted or substituted with at least one R_{10b}.

R_{10b} may be the same as described herein.

In Formula 1, a1 to a3, b1, and b2 may each independently be an integer from 0 to 10.

According to an embodiment, in Formula 1, a1 to a3 may each independently be an integer of 1 to 10, and
at least one of R₁ in the number of a1 may not be hydrogen, at least one of R₂ in the number of a2 may not be hydrogen, and at least one of R₃ in the number of a3 may not be hydrogen.

According to an embodiment, the condensed cyclic compound may be represented by any one of Formulae 1-1, 1-2, and 1-3:

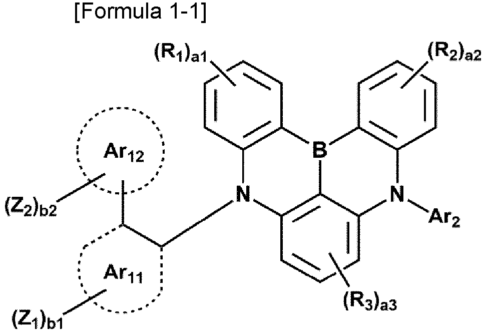

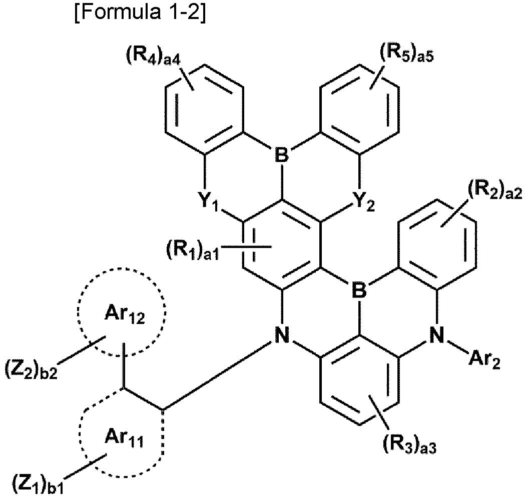

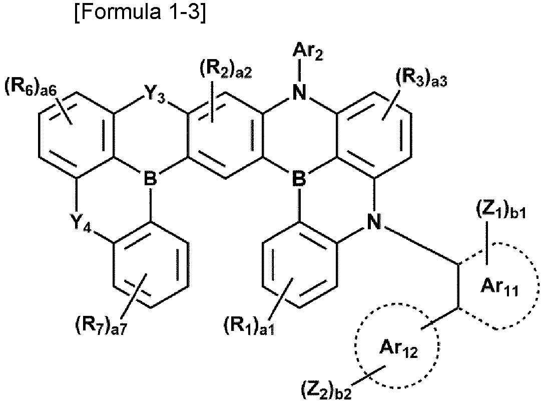

In Formulae 1-1 to 1-3,
Y₁ may be O, S, or N(Ar₃), and Y₂ may be O, S, or N(Ar₄),
Y₃ may be O, S, or N(Ar₅), and Y₄ may be O, S, or N(Ar₆),
Ar₃ to Ar₆ may each be a C₃-C₆₀ carbocyclic group unsubstituted or substituted with at least one R₁₀ₐ or a C₁-C₆₀ heterocyclic group unsubstituted or substituted with at least one R₁₀ₐ,
Ar₂, Ar₁₁, Ar₁₂, Z₁, Z₂, b1, b2, R₁ to R₃, and R₁₀ₐ may each be the same as described with respect to Formula 1,
R₄ to R₇ may each independently be the same as described with respect to R₁ in Formula 1,
two or more neighboring ones of R₄ in the number of a4 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of R₅ in the number of a5 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of R₆ in the number of a6 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of R₇ in the number of a7 may be optionally bonded to each other to form a C₅-C₃₀ carbocyclic group unsubstituted or substituted with at least one R_{10b} or a C₁-C₃₀ heterocyclic group unsubstituted or substituted with at least one R_{10b},
R_{10b} may be the same as described with respect to Formula 1,
in Formula 1-1, a1 and a2 may each independently be an integer from 0 to 4, and a3 may be an integer from 0 to 3,
in Formula 1-2, a1 may be 0 or 1, a2, a4, and a5 may each independently be an integer from 0 to 4, and a3 may be an integer from 0 to 3, and
in Formula 1-3, a1 and a7 may each independently be an integer from 0 to 4, a3 and a6 may each independently be an integer from 0 to 3, and a2 may be an integer from 0 to 2.

According to an embodiment, Y₁ and Y₂ in Formula 1-2 may be identical to each other.

According to an embodiment, Y₁ and Y₂ in Formula 1-2 may be different from each other.

According to an embodiment, Y₃ and Y₄ in Formula 1-3 may be identical to each other.

According to an embodiment, Y₃ and Y₄ in Formula 1-3 may be different from each other.

According to an embodiment, the condensed cyclic compound may be any one of Compounds 1 to 32:

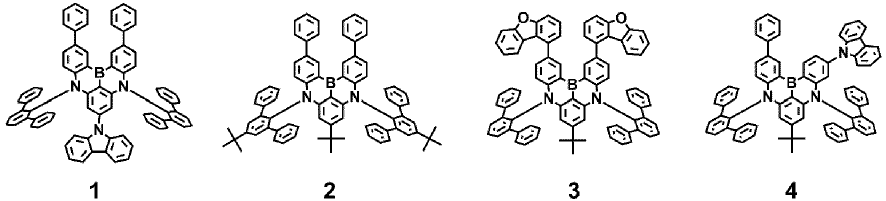

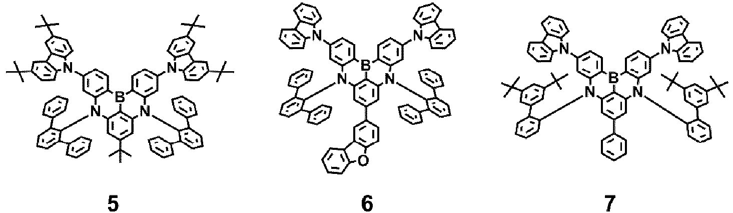

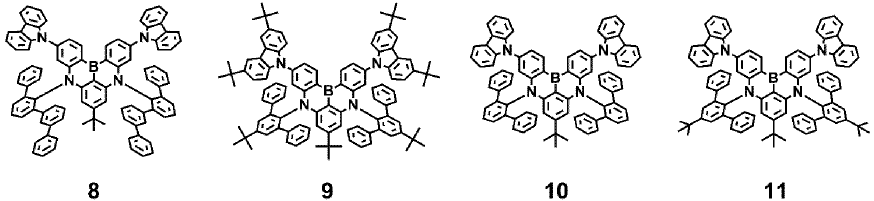

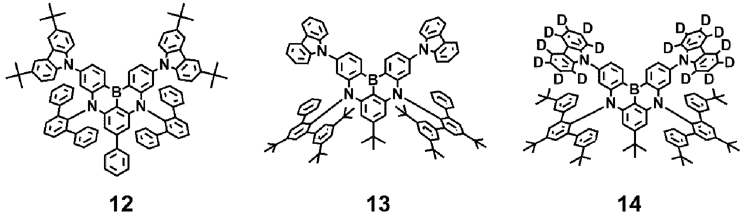

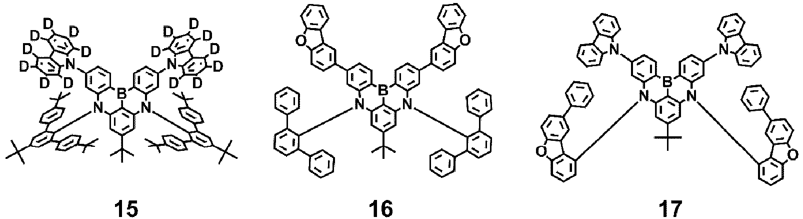

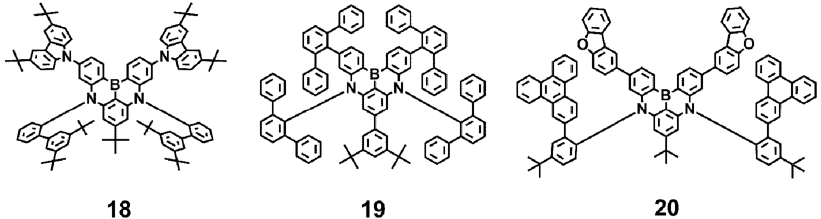

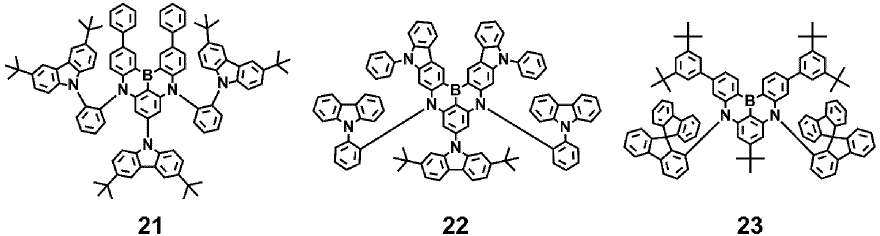

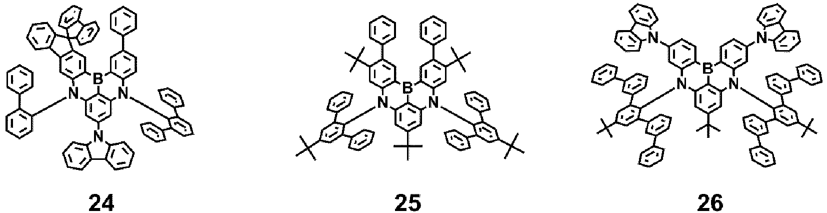

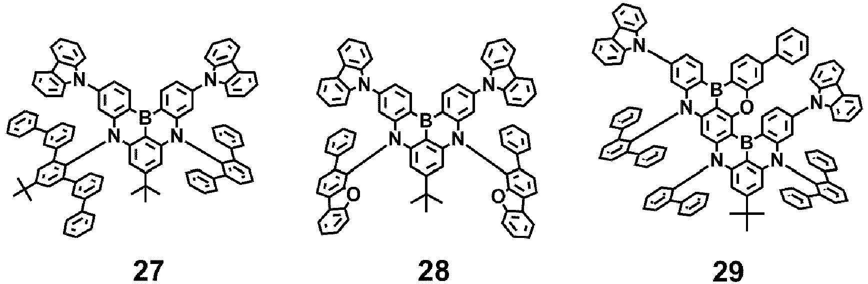

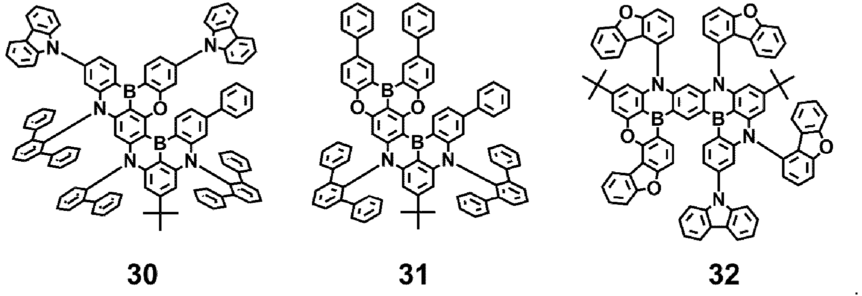

Synthesis methods of the condensed cyclic compound may be recognizable by one of ordinary skill in the art by referring to the Synthesis Examples and/or Examples provided below.

According to an embodiment,
the first electrode of the light-emitting device may be an anode,
the second electrode of the light-emitting device may be a cathode,
the interlayer may further comprise a hole transport region between the first electrode and the emission layer, and an electron transport region between the emission layer and the second electrode,
the hole transport region may comprise a hole injection layer, a hole transport layer, an emission auxiliary layer, an electron blocking layer, or any combination thereof, and
the electron transport region may comprise a buffer layer, a hole blocking layer, an electron control layer, an electron transport layer, an electron injection layer, or any combination thereof.

According to another embodiment, the condensed cyclic compound may be comprised between the first electrode and the second electrode of the light-emitting device. Thus, the interlayer of the light-emitting device may comprise the condensed cyclic compound. For example, in an embodiment, the emission layer of the interlayer may comprise the condensed cyclic compound.

According to another embodiment, the condensed cyclic compound in the emission layer may be a thermally activated delayed fluorescence (TADF) emitter, and the emission layer may emit delayed fluorescence. The emission layer may emit red light, green light, blue light, and/or white light. For example, the emission layer may emit blue light. The blue light may have a maximum emission wavelength in a range of about 400 nm to about 490 nm. For example, the blue light may have a maximum emission wavelength in a range of about 420 nm to about 480 nm. For example, blue light may have a maximum emission wavelength in a range of about 430 nm to about 480 nm. The emission layer may further comprise a host, and an amount of the host may be greater than an amount of the condensed cyclic compound represented by Formula 1.

According to another embodiment, the light-emitting device may comprise a capping layer outside the first electrode or outside the second electrode.

For example, the light-emitting device may further comprise at least one of a first capping layer outside the first electrode and a second capping layer outside the second electrode, and at least one of the first capping layer and the second capping layer may comprise the condensed cyclic compound represented by Formula 1. The first capping layer and/or second capping layer may be the same as described herein.

The wording "(interlayer and/or capping layer) may comprise a condensed cyclic compound" as used herein may be understood as "(interlayer and/or capping layer) may comprise one kind of condensed cyclic compound represented by Formula 1 or two or more different kinds of condensed cyclic compounds, each represented by Formula 1".

In an embodiment, the interlayer and/or the capping layer may only comprise Compound 1 as the condensed cyclic compound. In an embodiment, Compound 1 may be present in the emission layer of the light-emitting device. In another embodiment, the interlayer may comprise, as the condensed cyclic compound, Compound 1 and Compound 2. In an embodiment, Compound 1 and Compound 2 may be present in a same layer (for example, all of Compound 1 and Compound 2 may be present in the emission layer), or may be present in different layers (for example, Compound 1 may be present in the emission layer, and Compound 2 may be present in the electron transport region).

The term "interlayer" as used herein refers to a single layer and/or multiple layers located between the first electrode and the second electrode of the light-emitting device.

According to an embodiment,
the emission layer in the light-emitting device may comprise:
a first compound comprising the condensed cyclic compound; and
a second compound comprising a group represented by Formula 20, a third compound comprising at least one π electron-deficient nitrogen-containing C₁-C₆₀ cyclic group, a fourth compound comprising a transition metal, or any combination thereof, wherein
the first compound, the second compound, the third compound, and the fourth compound may be different from each other:

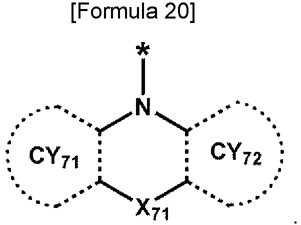

In Formula 20,
ring CY₇₁ and ring CY₇₂ may each independently be a π electron-rich C₃-C₆₀ cyclic group or a pyridine group,
X₇₁ may be: a single bond; or a linking group comprising O, S, N, B, C, Si, or any combination thereof,
* indicates a binding site to a neighboring atom, and
CBP and mCBP may be excluded from the second compound:

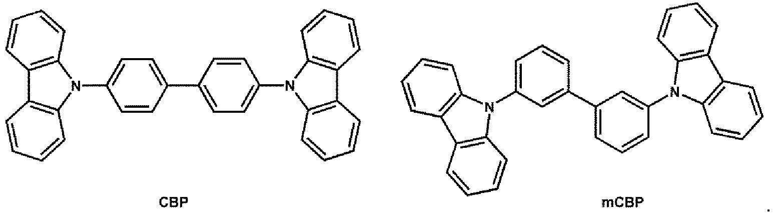

### [Second compound to fourth compound]

According to an embodiment, the emission layer may comprise a first compound and at least one of a second compound and a third compound.

According to another embodiment, the emission layer may comprise a first compound and a fourth compound.

According to another embodiment, the emission layer may comprise the first compound, the second compound, the third compound, and the fourth compound.

According to another embodiment, when the emission layer comprises the first compound, the second compound, the third compound, and the fourth compound,

an amount of the first compound may be in a range of about 0.1 % to about 5 %, based on 100 % of a total amount of the first compound to the fourth compound. For example, the amount of the first compound may be in a range of about 0.5 % to about 4 %, based on 100 % of a total amount of the first compound to the fourth compound. For example, the amount of the first compound may be in a range of about 1 % to about 3 %, based on 100 % of a total amount of the first compound to the fourth compound.

An amount of the second compound and the third compound (sum of the second compound and the third compound) may be in a range of about 50 % to about 90 %, based on 100 % of a total amount of the first compound to the fourth compound. For example, the amount of the second compound and the third compound may be in a range of about 55 % to about 89 %, based on 100 % of a total amount of the first compound to the fourth compound. For example, the amount of the second compound and the third compound may be in a range of about 60 % to about 88 %, based on 100 % of a total amount of the first compound to the fourth compound.

An amount of the fourth compound may be in a range of about 10 % to about 30 %, based on 100 % of a total amount of the first compound to the fourth compound. For example, the amount of the fourth compound may be in a range of about 11 % to about 28 %, based on 100 % of a total amount of the first compound to the fourth compound. For example, the amount of the fourth compound may be in a range of about 12 % to about 26 %, based on 100 % of a total amount of the first compound to the fourth compound. For example, the amount of the fourth compound may be in a range of about 13 % to about 24 %, based on 100 % of a total amount of the first compound to the fourth compound.

According to an embodiment, the second compound may comprise a compound represented by Formula 20-1, a compound represented by Formula 20-2, a compound represented by Formula 20-3, a compound represented by Formula 20-4, a compound represented by Formula 20-5, or any combination thereof:

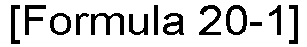

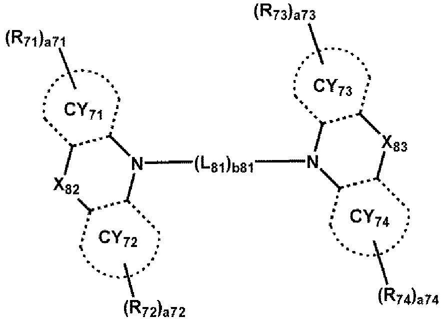

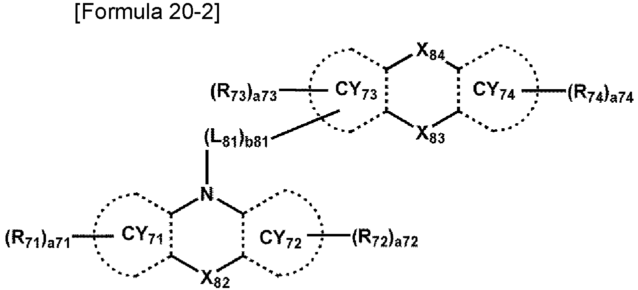

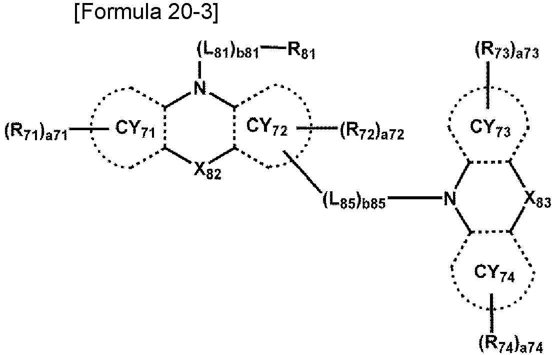

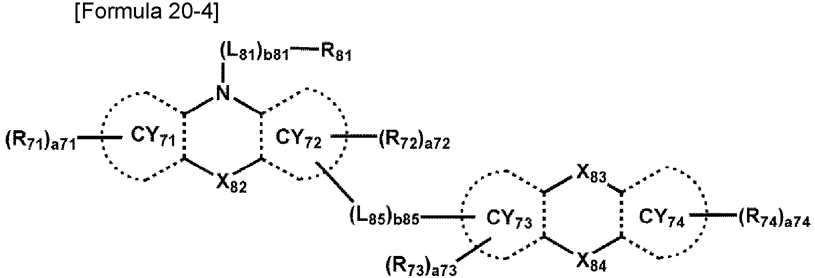

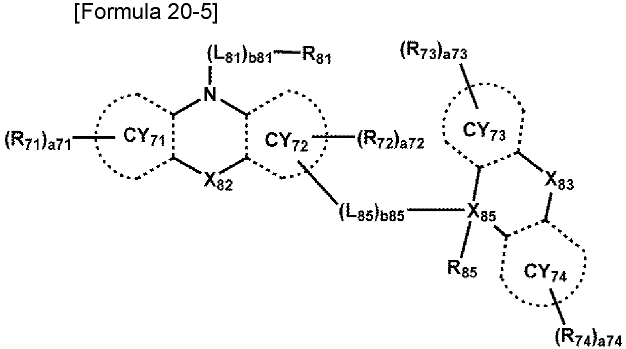

In Formulae 20-1 to 20-5,
ring CY₇₁ to ring CY₇₄ may each independently be a π electron-rich C₃-C₆₀ cyclic group or a pyridine group,
X₈₂ may be a single bond, B, O, S, N-[(L₈₂)_{b82}-R₈₂], C(R₈₂ₐ)(R_{82b}), or Si(R₈₂ₐ)(R_{82b}),
X₈₃ may be a single bond, B, O, S, N-[(L₈₃)_{b83}-R₈₃], C(R₈₃ₐ)(R_{83b}), or Si(R₈₃ₐ)(R_{83b}),
X₈₄ may be B, O, S, N-[(L₈₄)_{b84}-R₈₄], C(R₈₄ₐ)(R_{84b}), or Si(R₈₄ₐ)(R_{84b}),
X₈₅ may be B, C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ, or a pyridine group unsubstituted or substituted with at least one R₁₀ₐ, wherein Q₄ and Q₅ may each independently be same as described herein with respect to Q₁,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} may each be the same as described herein,
a71 to a74 may each independently be an integer from 0 to 20, and
R₁₀ₐ may be the same as described herein.

In an embodiment, the third compound may comprise a pyridine group, a pyrimidine group, a pyrazine group, a pyridazine group, a triazine group, or any combination thereof.

According to an embodiment, the third compound may comprise a compound represented by Formula 30:

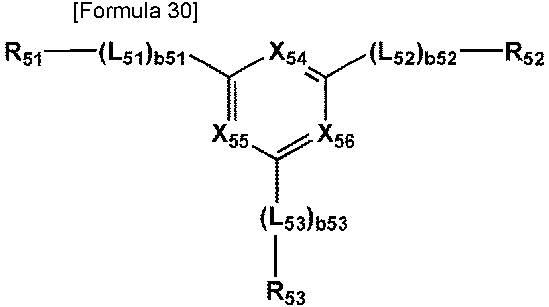

In Formula 30,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
X₅₄ may be N or C(R₅₄), X₅₅ may be N or C(R₅₅), X₅₆ may be N or C(R₅₆), and at least one of X₅₄ to X₅₆ may each be N,
R₅₁ to R₅₆ may each be the same as described herein, and
R₁₀ₐmay be the same as described herein.
The fourth compound may comprise a compound represented by Formula 401:

   [Formula 401] M(L₄₀₁)_{xc1}(L₄₀₂)_{xc2}

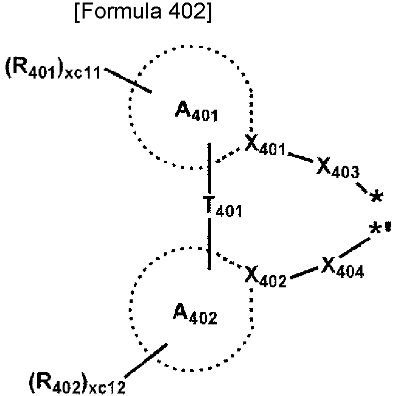

In Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein when xc1 is two or more, two or more of L₄₀₁(s) may be identical to or different from each other,
L₄₀₂ may be an organic ligand, and xc2 may be 0, 1, 2, 3, or 4, wherein when xc2 is 2 or more, two or more of L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond, O, S, N(Q₄₁₃), B(Q₄₁₃), P(Q₄₁₃), C(Q₄₁₃)(Q₄₁₄), or Si(Q₄₁₃)(Q₄₁₄),
R₄₀₁ and R₄₀₂ may each independently be hydrogen, deuterium, -F, -Cl, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), - N(Q₄₀₁)(Q₄₀₂), -B(Q₄₀₁)(Q₄₀₂), -C(=O)(Q₄₀₁), -S(=O)₂(Q₄₀₁), or -P(=O)(Q₄₀₁)(Q₄₀₂),
xc11 and xc12 may each independently be an integer from 0 to 10,
Q₄₁₁ to Q₄₁₄ and Q₄₀₁ to Q₄₀₃ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₇C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or any combination thereof,
* and *' in Formula 402 each indicate a binding site to M in Formula 401, and
R₁₀ₐ may be the same as described herein.

### [Descriptions of Formulae 20, 20-1 to 20-5, and 30]

In an embodiment, a group represented by 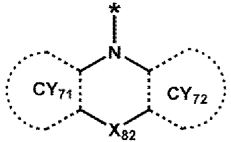 in Formulae 20-1 and 20-2 may be a group represented by one of Formulae CY71-1(1) to CY71-1(8), and/or
a group represented by 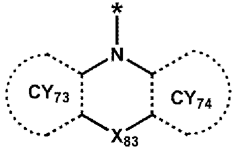 in Formulae 20-1 and 20-3 may be a group represented by one of Formulae CY71-2(1) to CY71-2(8), and/or
a group represented by 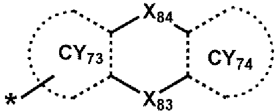 in Formulae 20-2 and 20-4 may be a group represented by one of Formulae CY71-3(1) to CY71-3(32), and/or
a group represented by 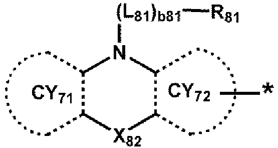 in Formulae 20-3 to 20-5 may be a group represented by one of Formulae CY71-4(1) to CY71-4(32), and/or
a group represented by 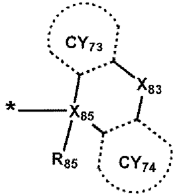 in Formula 20-5 may be a group represented by one of Formulae CY71-5(1) to CY71-5(8):

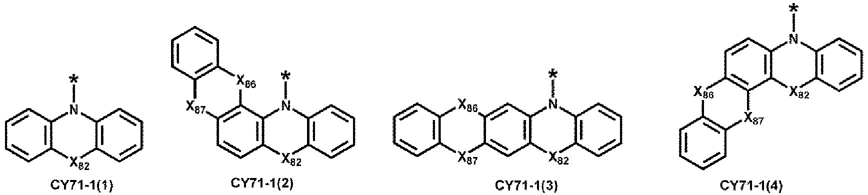

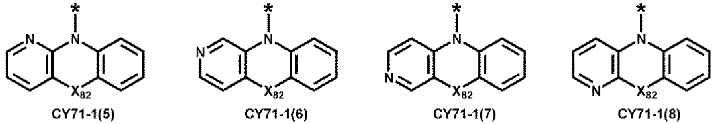

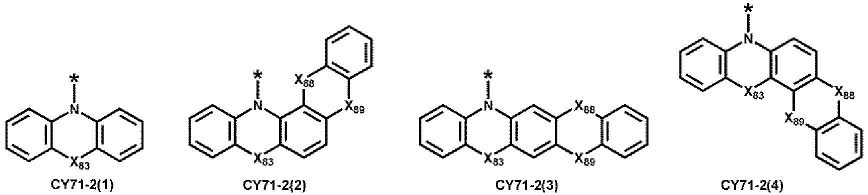

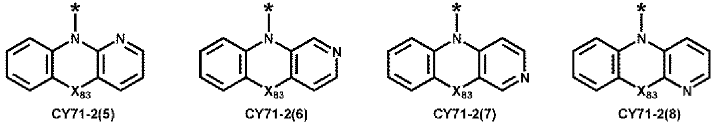

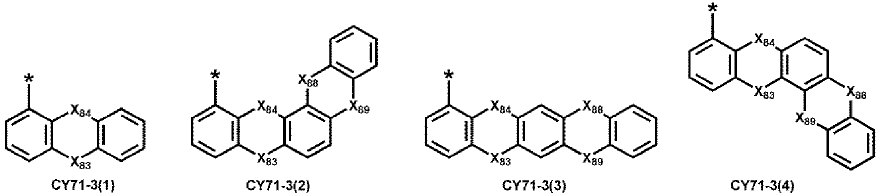

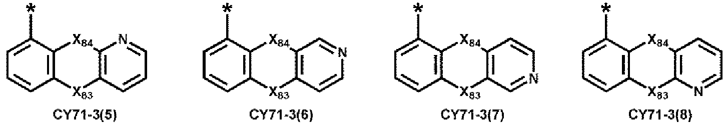

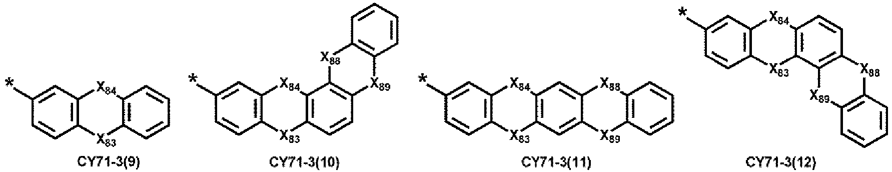

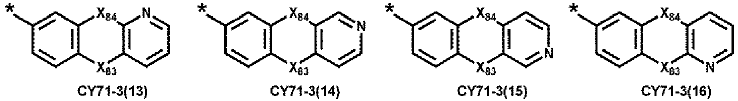

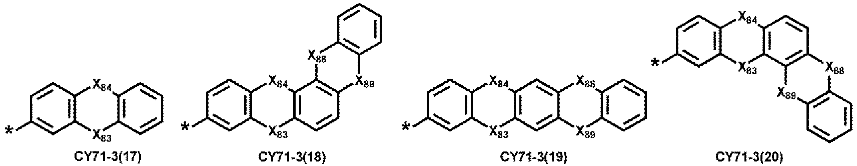

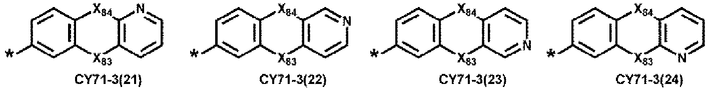

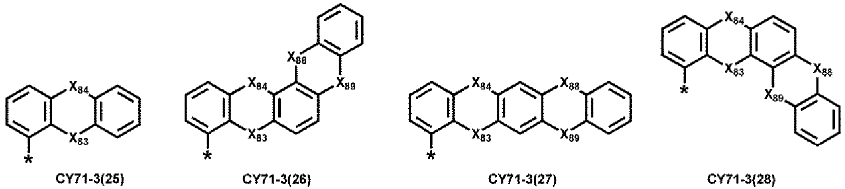

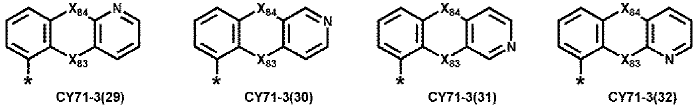

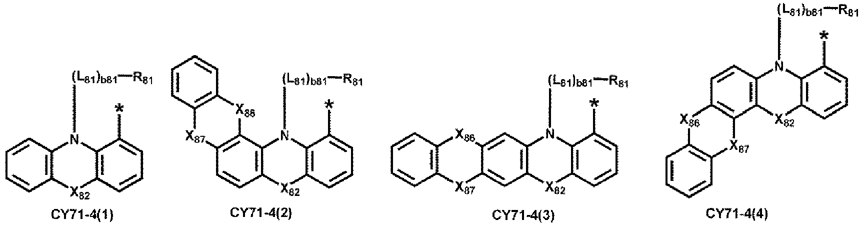

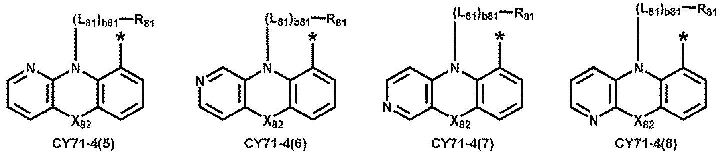

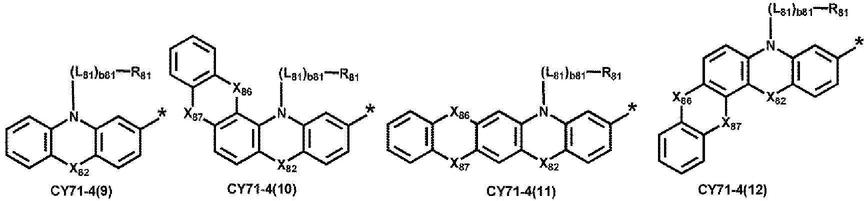

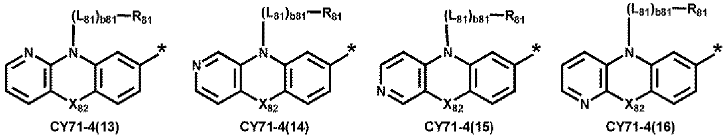

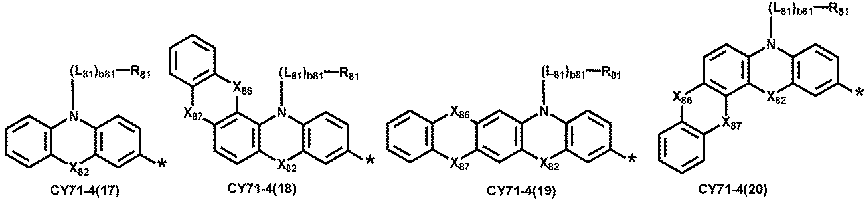

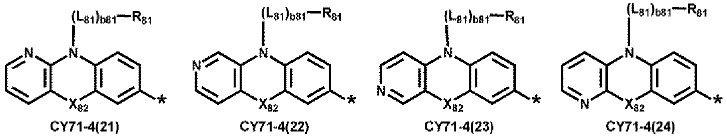

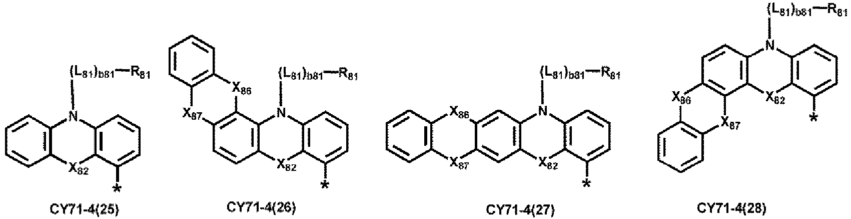

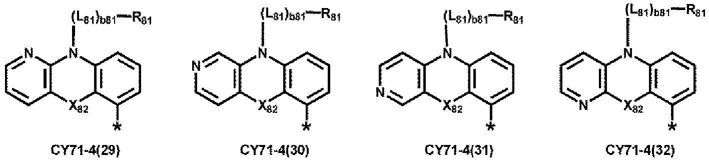

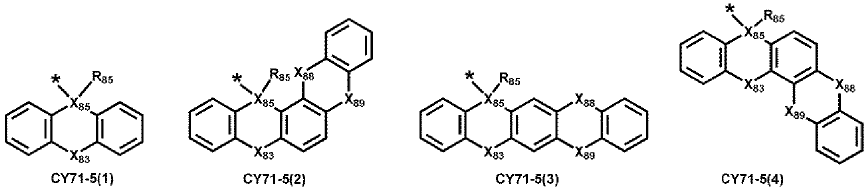

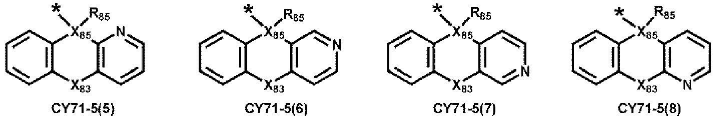

In Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₂ to X₈₅, L₈₁, b81, R₈₁, and R₈₅ may each be the same as described herein,
X₈₆ may be a single bond, O, S, N(R₈₆), B(R₈₆), C(R₈₆ₐ)(R_{86b}), or Si(R₈₆ₐ)(R_{86b}),
X₈₇ may be a single bond, O, S, N(R₈₇), B(R₈₇), C(R₈₇ₐ)(R_{87b}), or Si(R₈₇ₐ)(R_{87b}),
in Formulae CY71-1(1) to CY71-1(8) and CY71-4(1) to CY71-4(32), X₈₆ and X₈₇ may each not be a single bond at the same time,
X₈₈ may be a single bond, O, S, N(R₈₈), B(R₈₈), C(R₈₈ₐ)(R_{88b}), or Si(R₈₈ₐ)(R_{88b}),
X₈₉ may be a single bond, O, S, N(R₈₉), B(R₈₉), C(R₈₉ₐ)(R_{89b}), or Si(R₈₉ₐ)(R_{89b}),
in Formulae CY71-2(1) to CY71-2(8), CY71-3(1) to CY71-3(32), and CY71-5(1) to CY71-5(8), X₈₈ and X₈₉ may each not be a single bond at the same time, and
R₈₆ to R₈₉, R₈₆ₐ, R_{86b}, R₈₇ₐ, R_{87b}, R₈₈ₐ, R_{88b}, R₈₉ₐ, and R_{89b} may each independently be the same as described herein with respect to R₈₁.

In Formula 30, b51 to b53 respectively indicate numbers of L₅₁ to L₅₃, and may each independently be an integer from 1 to 5. When b51 is 2 or more, two or more of L₅₁(s) may be identical to or different from each other, when b52 is 2 or more, two or more of L₅₂(s) may be identical to or different from each other, and when b53 is 2 or more, two or more of L₅₃(s) may be identical to or different from each other. For example, b51 to b53 may each independently be 1 or 2.

In an embodiment, in Formula 30, L₅₁ to L₅₃ may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxacilline group, a dibenzothiacilline group, a dibenzodihydroazacilline group, a dibenzodihydrodicilline group, a dibenzodihydrocilline group, a dibenzodioxane group, a dibenzooxathiene group, a dibenzooxazine group, a dibenzopyran group, a dibenzodithiine group, a dibenzothiazine group, a dibenzothiopyran group, a dibenzocyclohexadiene group, a dibenzodihydropyridine group, or a dibenzodihydropyrazine group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), - P(=O)(Q₃₁)(Q₃₂), or any combination thereof, and
Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

According to an embodiment, in Formula 30, a bond between L₅₁ and R₅₁, a bond between L₅₂ and R₅₂, a bond between L₅₃ and R₅₃, a bond between two or more L₅₁(s), a bond between two or more L₅₂(s), a bond between two or more L₅₃(s), a bond between L₅₁ and carbon between X₅₄ and X₅₅ in Formula 30, a bond between L₅₂ and carbon between X₅₄ and X₅₆ in Formula 30, and a bond between L₅₃ and carbon between X₅₅ and X₅₆ in Formula 30 may each be a "carbon-carbon single bond".

In Formula 30, X₅₄ may be N or C(R₅₄), X₅₅ may be N or C(R₅₅), X₅₆ may be N or C(R₅₆), and at least one of X₅₄ to X₅₆ may each be N. R₅₄ to R₅₆ may each be the same as described herein. For example, two or three of X₅₄ to X₅₆ may each be N.

In the specification, R₅₁ to R₅₆, R₇₁ to R₇₄, R₈₁ to R₈₅, R₈₂ₐ, R_{82b}, R₈₃ₐ, R_{83b}, R₈₄ₐ, and R_{84b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂). Q₁ to Q₃ may each be the same as described herein.

For example, R₅₁ to R₅₆, R₇₁ to R₇₄, R₈₁ to R₈₅, R₈₂ₐ, R_{82b}, R₈₃ₐ, R_{83b}, R₈₄ₐ, and R_{84b} in Formulae 20-1 to 20-5 and 30; and R₁₀ₐ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), - S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), - P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂), and
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, or -CD₂CDH₂; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof:

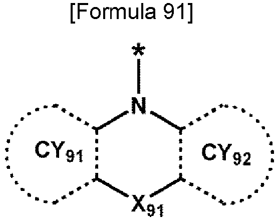

In Formula 91,
ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
X₉₁ may be a single bond, O, S, N(R₉₁), B(R₉₁), C(R₉₁ₐ)(R_{91b}), or Si(R₉₁ₐ)(R_{91b}),
R₉₁, R₉₁ₐ, and R_{91b} may respectively be the same as described herein with respect to R₃₂, R₈₂ₐ, and R_{82b} as described herein,
R₁₀ₐ may be the same as described herein, and
* indicates a binding site to a neighboring atom.

For example, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ, and
R₉₁, R₉₁ₐ, and R_{91b} may each independently be:
hydrogen or a C₁-C₁₀ alkyl group; or
a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.
According to another embodiment, R₅₁ to R₅₆, R₇₁ to R₇₄, R₈₁ to R₈₅, R₈₂ₐ, R_{82b}, R₈₃ₐ, R_{83b}, R₈₄ₐ, and R_{84b} in Formulae 20-1 to 20-5 and 30; and R₁₀ₐ may each independently be:
hydrogen, deuterium, -F, a cyano group, a nitro group, -CH₃, -CD₃, -CD₂H, -CDH₂, - CF₃, -CF₂H, -CFH₂, a group represented by any one of Formulae 9-1 to 9-39 and 9-44 to 9-67, a group represented by any one of Formulae 10-1 to 10-154 and 10-201 to 10-368, - C(Q₁)(Q₂)(Q₃), -Si(Q₁)(Q₂)(Q₃), or -P(=O)(Q₁)(Q₂), wherein Q₁ to Q₃ may each be the same as described herein:

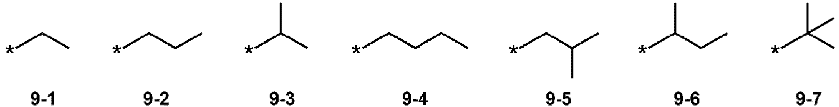

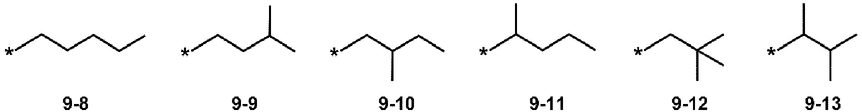

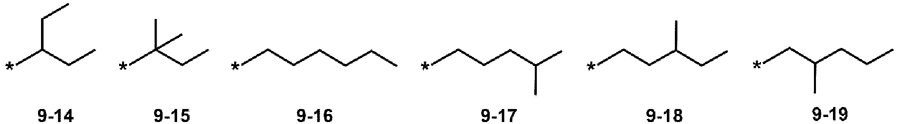

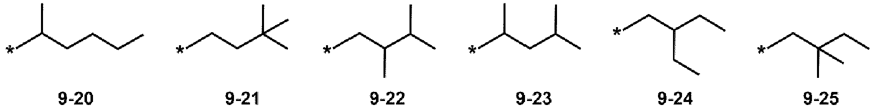

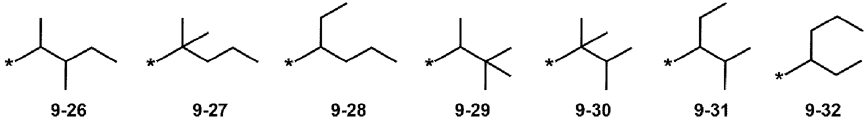

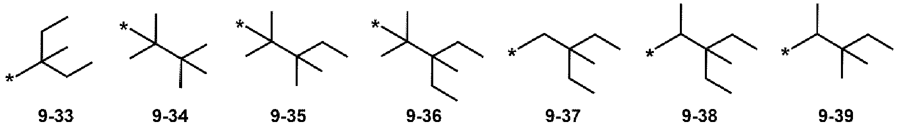

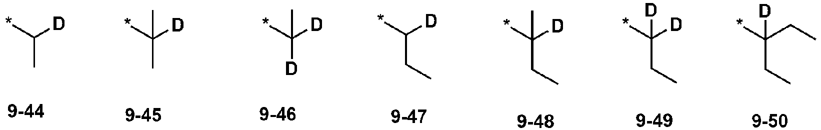

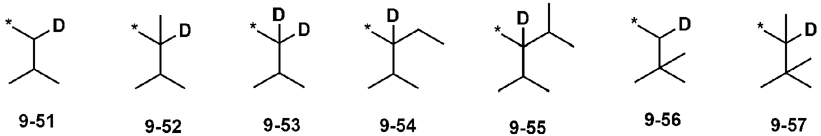

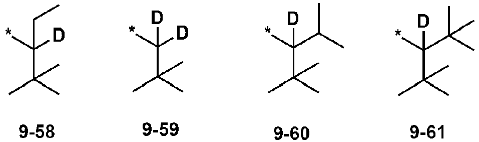

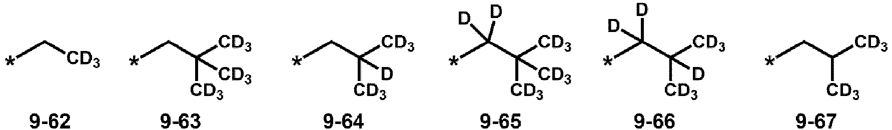

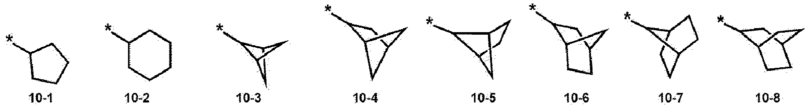

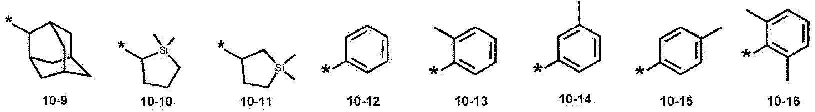

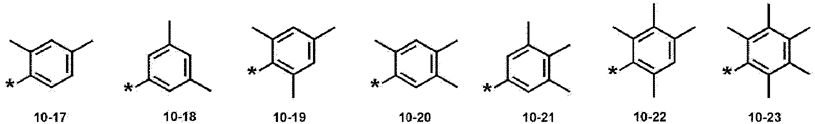

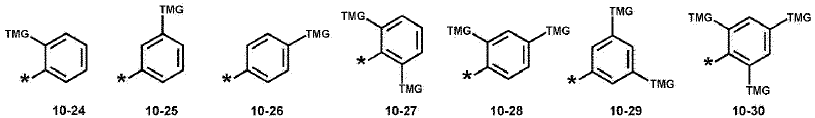

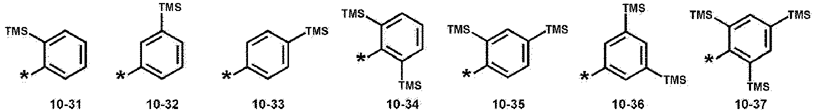

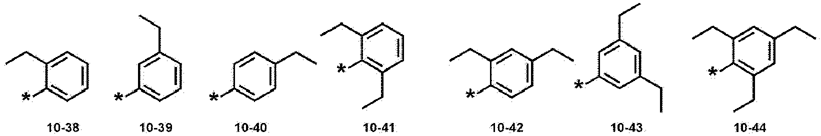

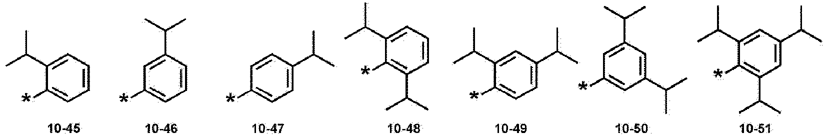

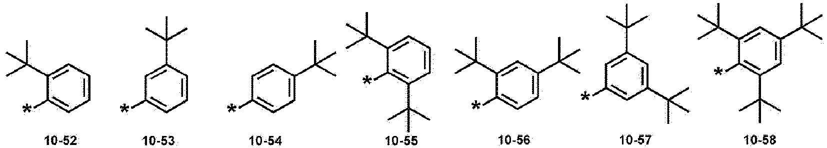

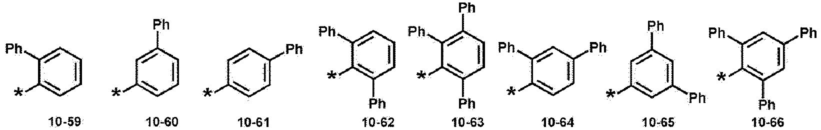

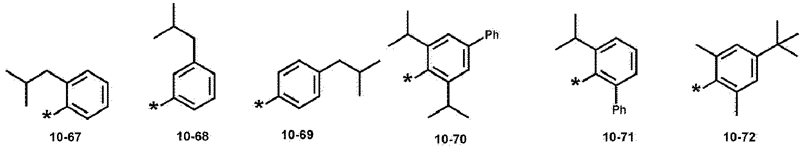

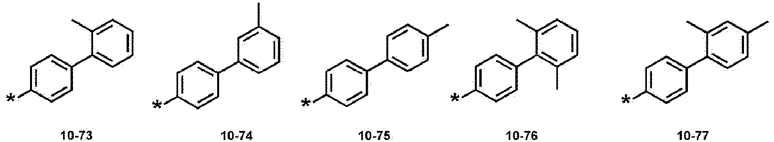

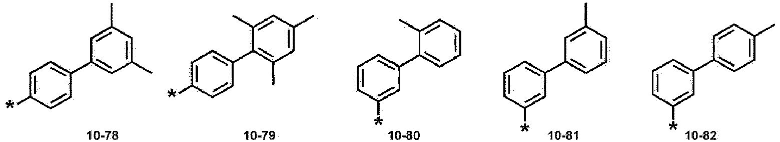

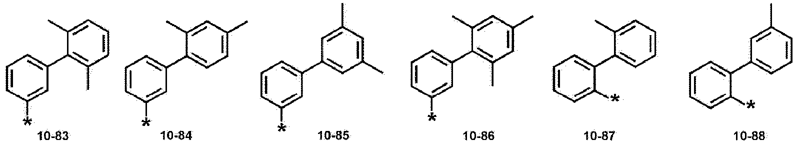

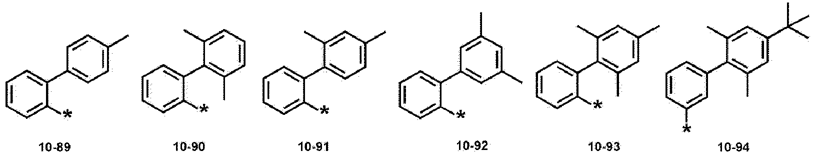

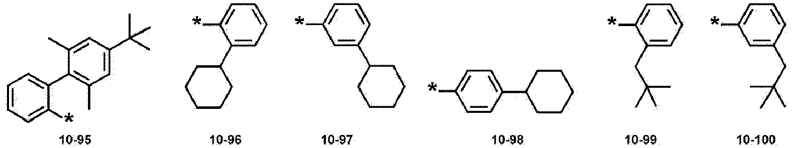

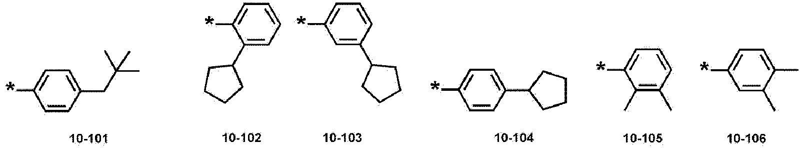

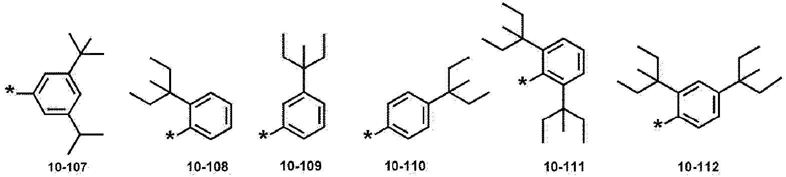

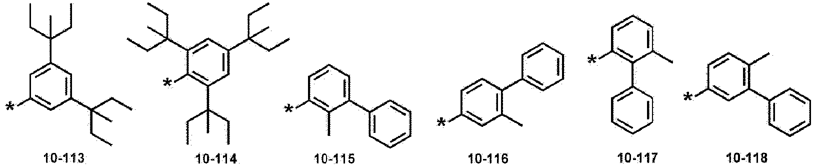

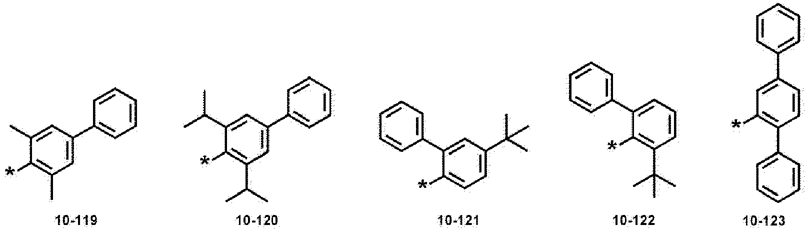

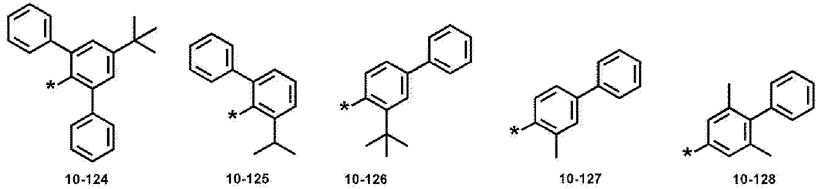

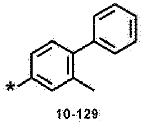

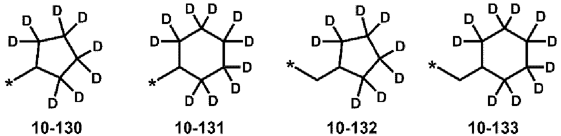

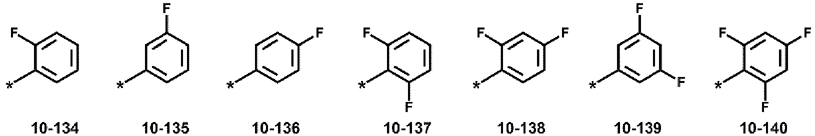

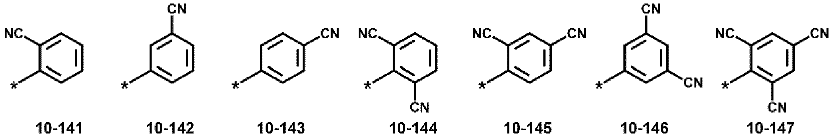

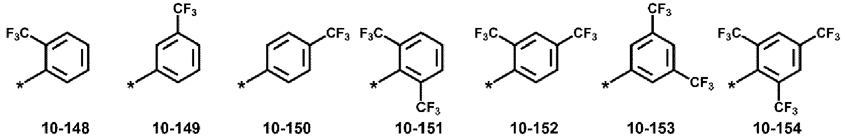

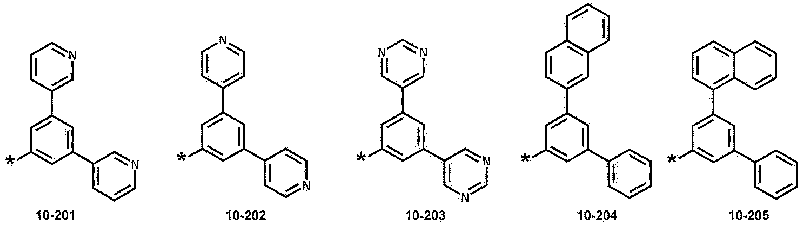

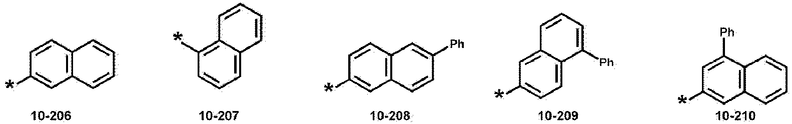

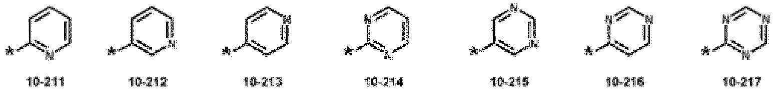

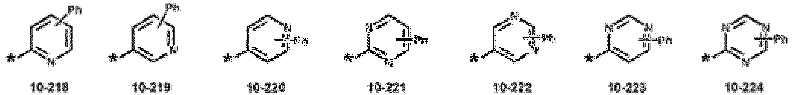

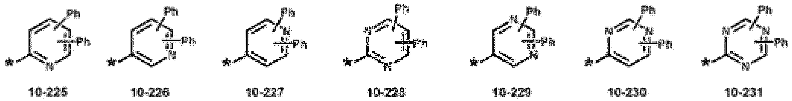

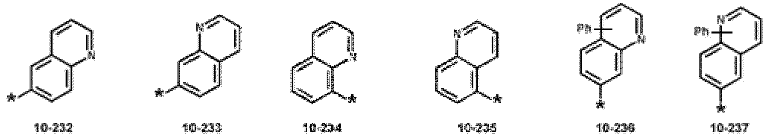

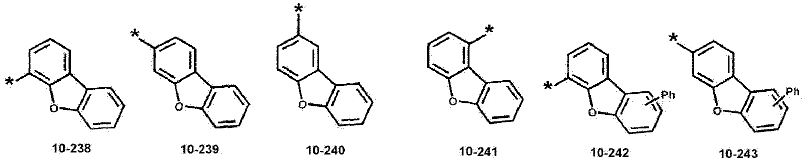

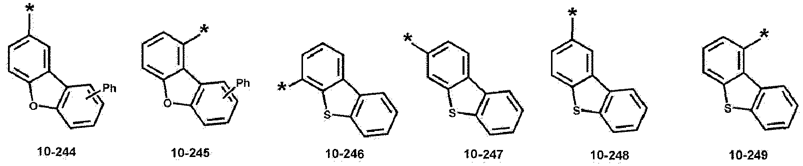

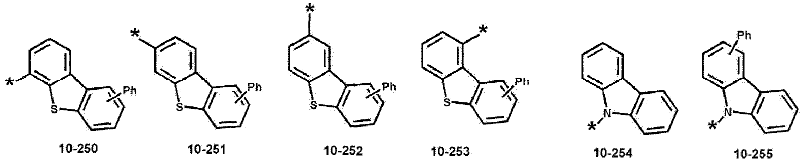

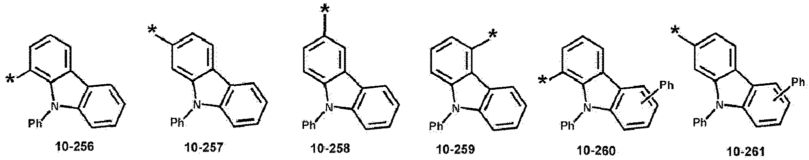

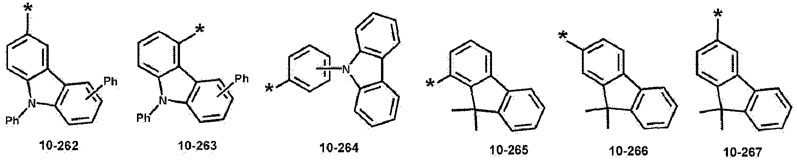

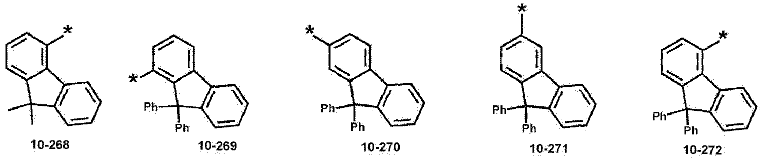

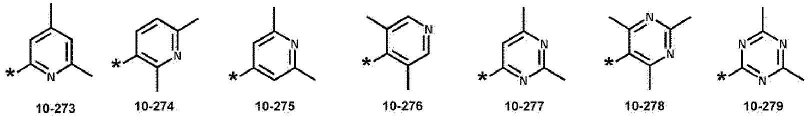

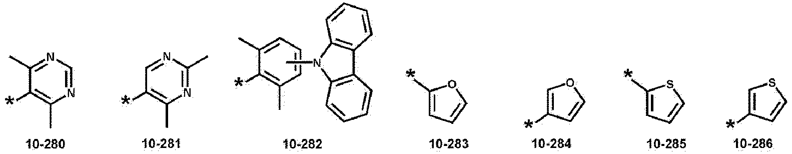

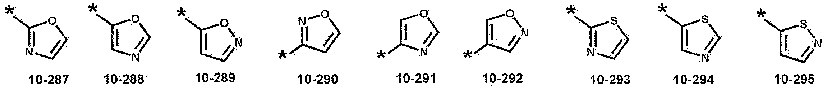

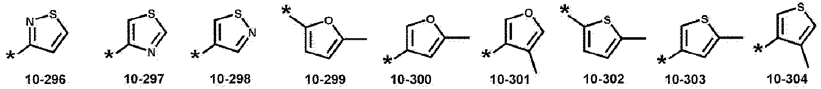

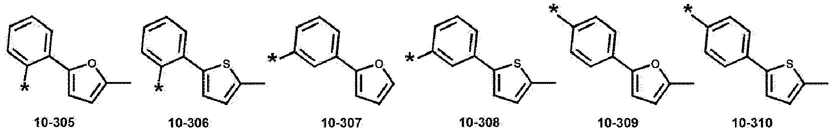

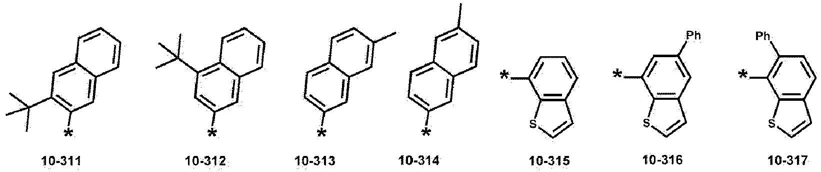

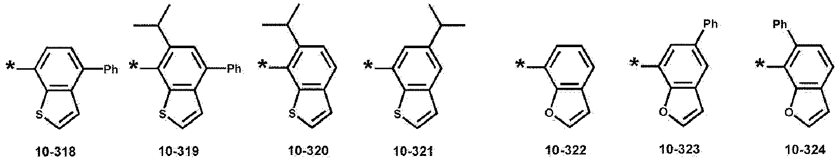

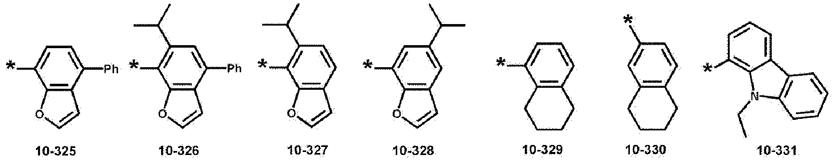

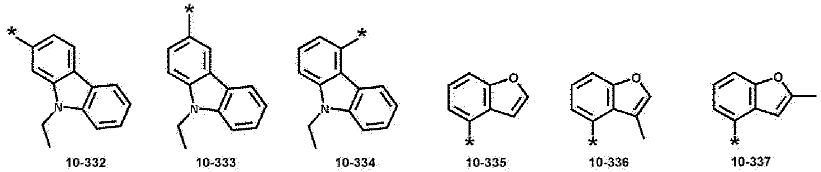

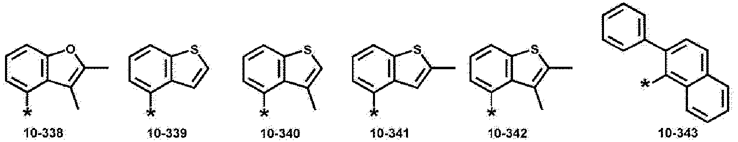

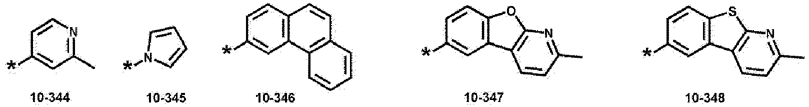

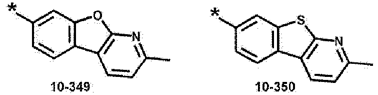

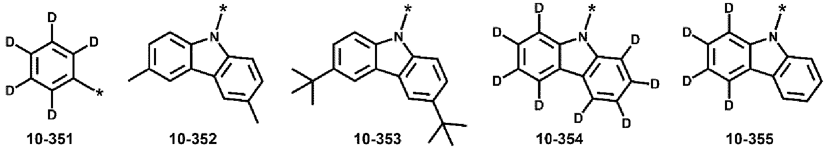

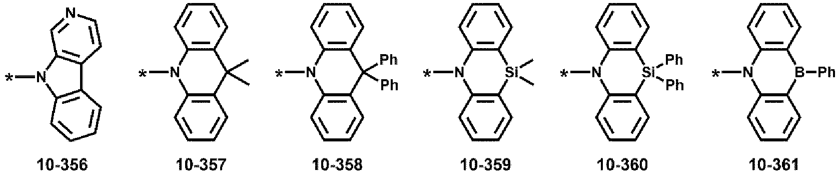

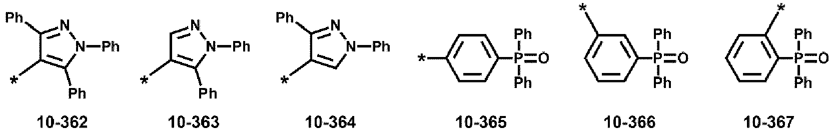

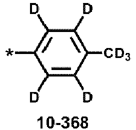

In Formulae 9-1 to 9-39, 9-44 to 9-67, 10-1 to 10-154, and 10-201 to 10-368, * indicates a binding site to a neighboring atom, Ph may be a phenyl group, TMS may be a trimethylsilyl group, and TMG may be a trimethylgermyl group.

In Formulae 20-1 to 20-5, a71 to a74 respectively indicate numbers of R₇₁(s) to R₇₄(s), and may each independently be an integer from 0 to 20. When a71 is 2 or more, two or more of R₇₁(s) may be identical to or different from each other, when a72 is 2 or more, two or more of R₇₂(s) may be identical to or different from each other, when a73 is 2 or more, two or more of R₇₃(s) may be identical to or different from each other, and when a74 is 2 or more, two or more of R₇₄(s) may be identical to or different from each other. In an embodiment, a71 to a74 may each independently be an integer from 0 to 8.

In an embodiment, in Formula 30, a group represented by *-(L₅₁)_{b51}-R₅₁ and a group represented by *-(L₅₂)_{b52}-R₅₂ may each not be a phenyl group.

According to an embodiment, in Formula 30, a group represented by *-(L₅₁)_{b51}-R₅₁ and a group represented by *-(L₅₂)_{b52}-R₅₂ may be identical to each other.

According to another embodiment, in Formula 30, a group represented by *-(L₅₁)_{b51}-R₅₁ and a group represented by *-(L₅₂)_{b52}-R₅₂ may be different from each other.

According to another embodiment, in Formula 30, b51 and b52 may each independently be 1, 2, or 3, and L₅₁ and L₅₂ may each independently be a benzene group, a pyridine group, a pyrimidine group, a pyridazine group, a pyrazine group, or a triazine group, each unsubstituted or substituted with at least one R₁₀ₐ.

In an embodiment, in Formula 30, R₅₁ and R₅₂ may each independently be a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), or -Si(Q₁)(Q₂)(Q₃), and

Q₁ to Q₃ may each independently be a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

According to an embodiment, in Formula 30,
a group represented by *-(L₅₁)_{b51}-R₅₁ may be a group represented by one of Formulae CY51-1 to CY51-26, and/or
a group represented by *-(L₅₂)_{b52}-R₅₂ may be a group represented by one of Formulae CY52-1 to CY52-26, and/or
a group represented by *-(L₅₃)_{b53}-R₅₃ may be a group represented by one of Formulae CY53-1 to CY53-27, -C(Q₁)(Q₂)(Q₃), or -Si(Q₁)(Q₂)(Q₃), wherein Q₁ to Q₃ may each be the same as described herein:

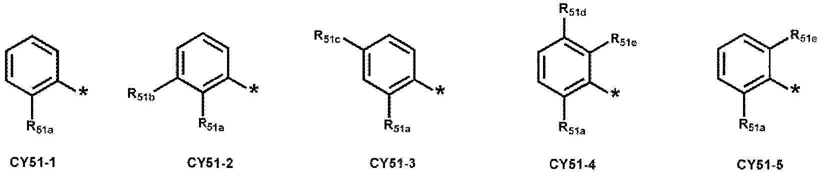

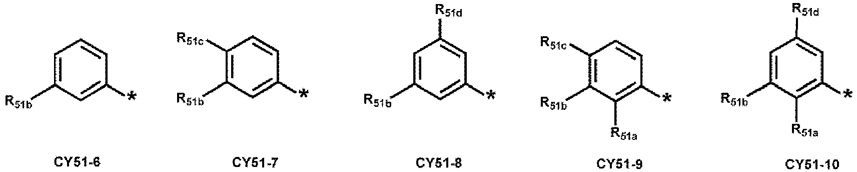

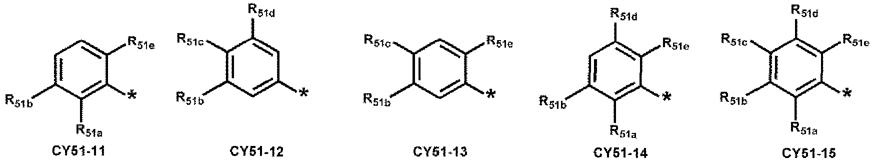

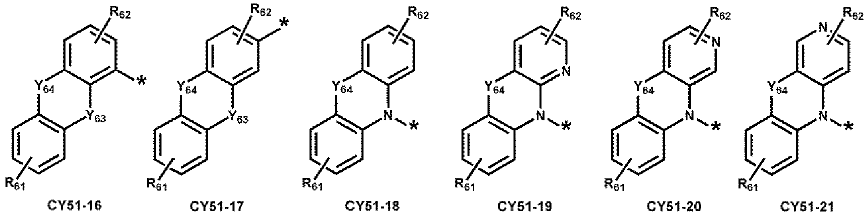

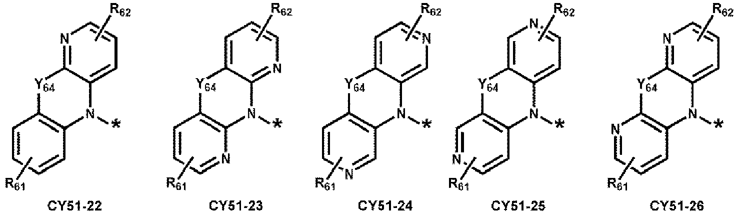

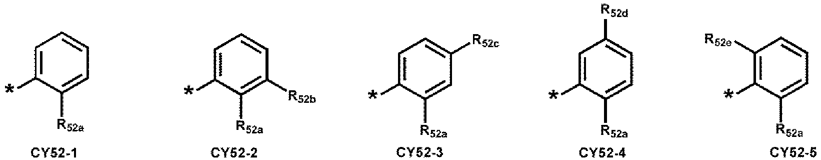

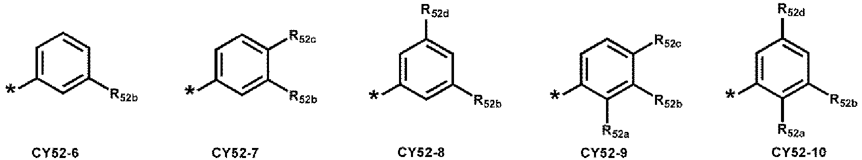

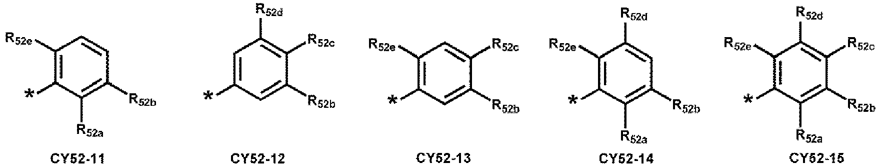

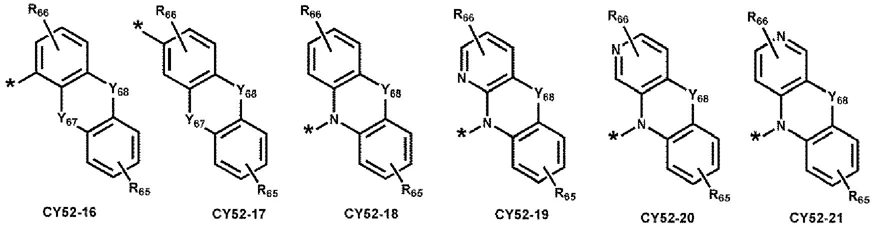

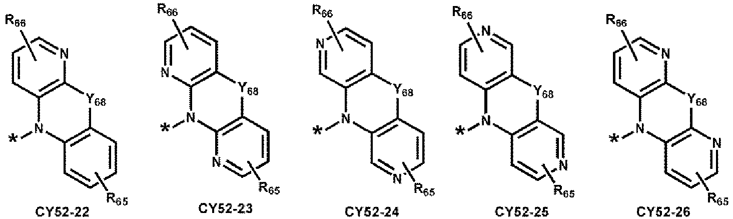

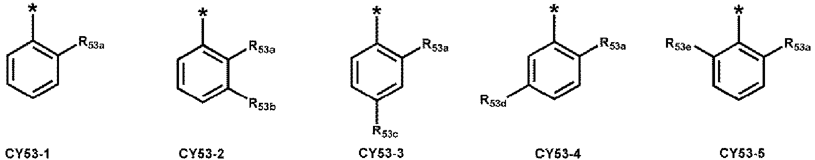

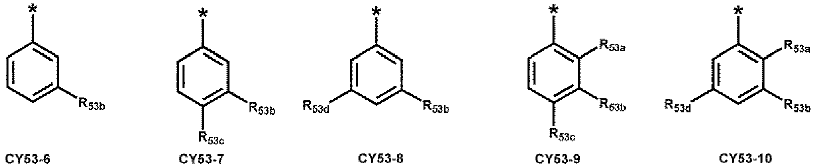

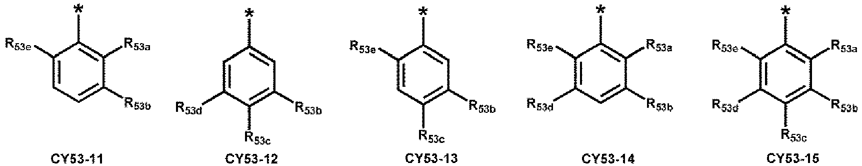

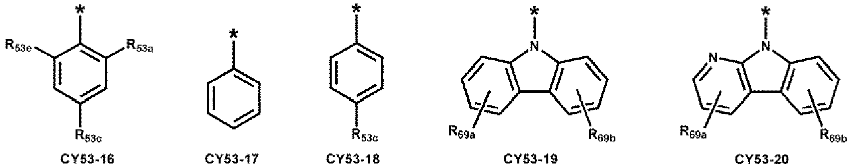

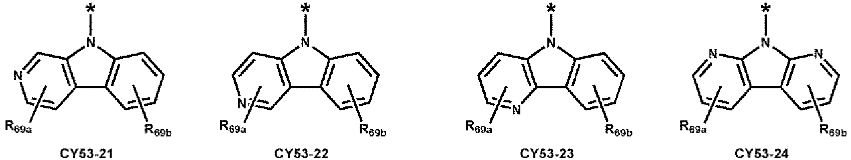

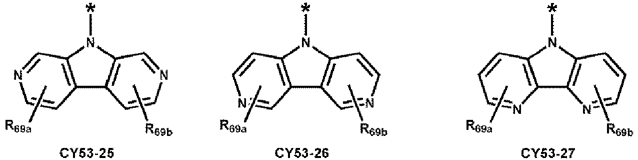

In Formulae CY51-1 to CY51-26, CY52-1 to CY52-26, and CY53-1 to CY53-27,
Y₆₃ may be a single bond, O, S, N(R₆₃), B(R₆₃), C(R₆₃ₐ)(R_{63b}), or Si(R₆₃ₐ)(R_{63b}),
Y₆₄ may be a single bond, O, S, N(R₆₄), B(R₆₄), C(R₆₄ₐ)(R_{64b}), or Si(R₆₄ₐ)(R_{64b}),
Y₆₇ may be a single bond, O, S, N(R₆₇), B(R₆₇), C(R₆₇ₐ)(R_{67b}), or Si(R₆₇ₐ)(R_{67b}),
Y₆₈ may be a single bond, O, S, N(R₆₈), B(R₆₃), C(R₆₈ₐ)(R_{68b}), or Si(R₆₈ₐ)(R_{68b}),
Y₆₃ and Y₆₄ in Formulae CY51-16 and CY51-17 may each not be a single bond at the same time,
Y₆₇ and Y₆₈ in Formulae CY52-16 and CY52-17 may each not be a single bond at the same time,
R₅₁ₐ to R₅₁ₑ, R₆₁ to R₆₄, R₆₃ₐ, R_{63b}, R₆₄ₐ, and R_{64b} may each independently be the same as described herein with respect to R₅₁, wherein R₅₁ₐ to R₅₁ₑ may each not be hydrogen,
R₅₂ₐ to R₅₂ₑ, R₆₅ to R₆₈, R₆₇ₐ, R_{67b}, R₆₈ₐ, and R_{68b} may each independently be the same as described herein with respect to R₅₂, wherein R₅₂ₐ to R₅₂ₑ may each not be hydrogen,
R₅₃ₐ to R₅₃ₑ, R₆₉ₐ, and R_{69b} may each independently be the same as described herein with respect to R₅₃, wherein R₅₃ₐ to R₅₃ₑ may each not be hydrogen, and
* indicates a binding site to a neighboring atom.

In embodiments, in Formulae CY51-1 to CY51-26 and Formulae CY52-1 to 52-26, R₅₁ₐ to R₅₁ₑ and R₅₂ₐ to R₅₂ₑ may each independently be:
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or any combination thereof; or
-C(Q₁)(Q₂)(Q₃) or -Si(Q₁)(Q₂)(Q₃), and
Q₁ to Q₃ may each independently be a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof,
in Formulae CY51-16 and CY51-17, Y₆₃ may be O or S, and Y₆₄ may be Si(R₆₄ₐ)(R_{64b}); or Y₆₃ may be Si(R₆₃ₐ)(R_{63b}), and Y₆₄ may be O or S, and
in Formulae CY52-16 and CY52-17, Y₆₇ may be O or S, and Y₆₃ may be Si(R₆₈ₐ)(R_{68b}); or Y₆₇ may be Si(R₆₇ₐ)(R_{67b}), and Y₆₈ may be O or S.

In an embodiment, in Formulae 20-1 to 20-5, L₈₁ to L₈₅ may each independently be:
a single bond;
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O(Q₃₁), -S(Q₃₁), - Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), -S(=O)₂(Q₃₁), - P(=O)(Q₃₁)(Q₃₂), or any combination thereof, and
Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In an embodiment, in Formula 402, X₄₀₁ may be nitrogen and X₄₀₂ may be carbon, or X₄₀₁ and X₄₀₂ may each be nitrogen.

In an embodiment, in Formula 401, when xc1 is 2 or more, two ring A₄₀₁(s) in two or more of L₄₀₁(s) may be optionally linked to each other via T₄₀₂, which is a linking group, or two ring A₄₀₂(s) may be optionally linked to each other via T₄₀₃, which is a linking group (see Compounds PD1 to PD4 and PD7). T₄₀₂ and T₄₀₃ may each independently be the same as described herein with respect to T₄₀₁.

In Formula 401, L₄₀₂ may be an organic ligand. For example, L₄₀₂ may comprise a halogen group, a diketone group (for example, an acetylacetonate group), a carboxylic acid group (for example, a picolinate group), -C(=O), an isonitrile group, -CN group, a phosphorus group (for example, a phosphine group, a phosphite group, etc.), or any combination thereof.

### [Detailed examples of second compound to fourth compound]

According to an embodiment, the second compound may comprise at least one of Compounds HTH1 to HTH55:

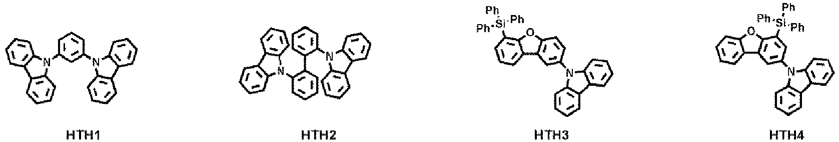

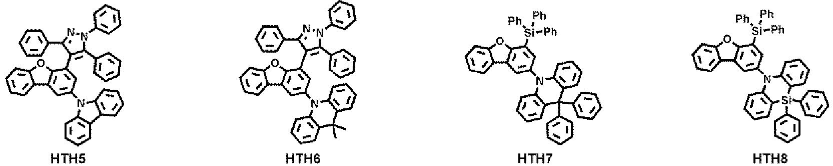

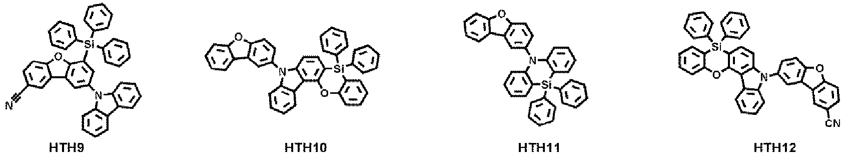

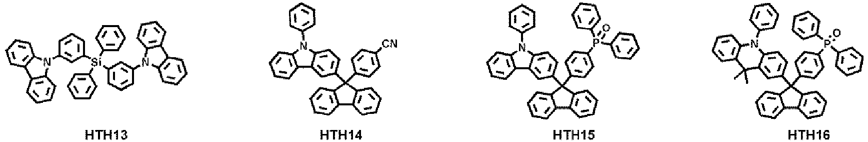

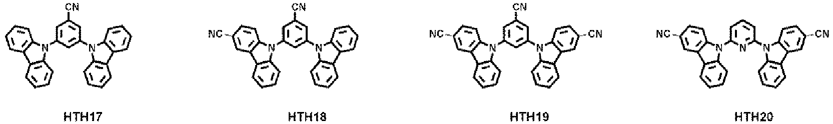

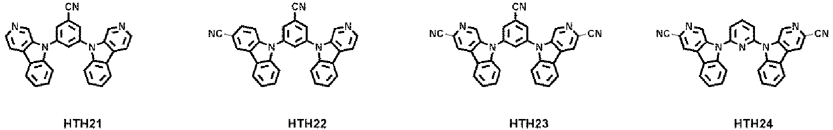

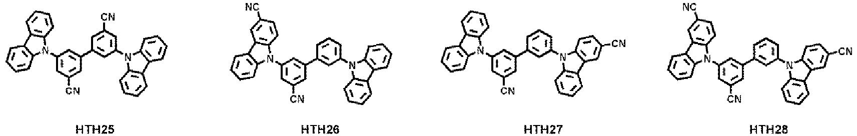

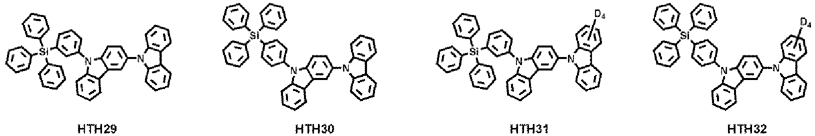

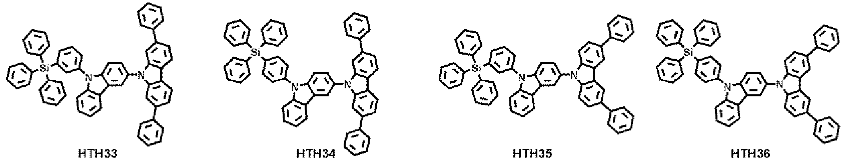

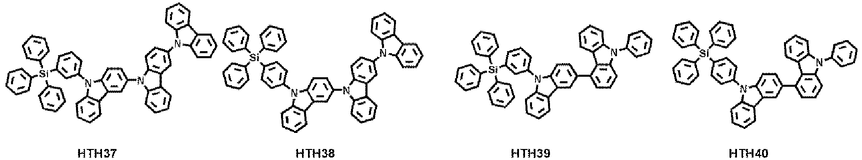

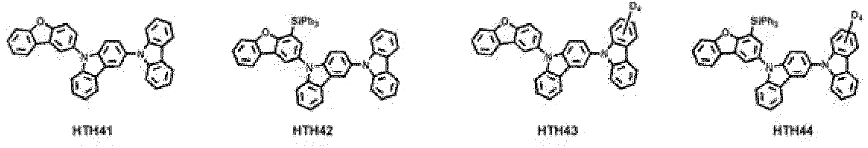

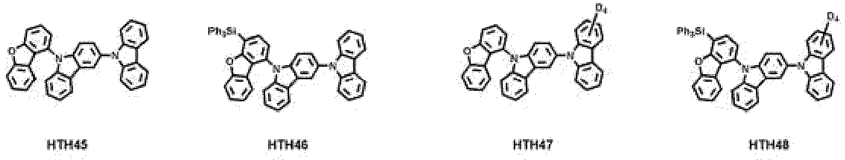

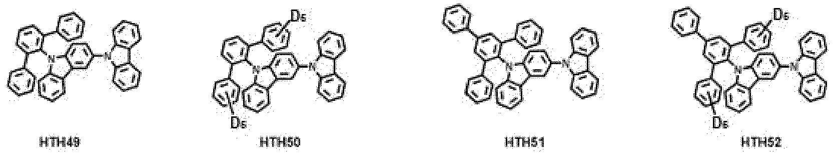

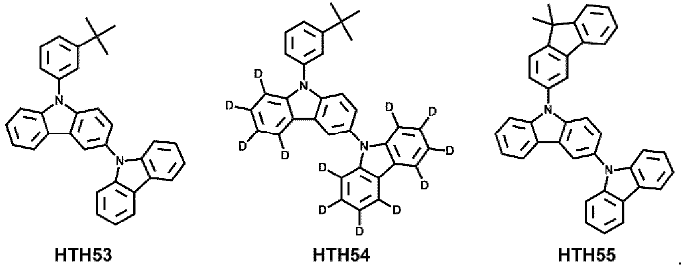

According to another embodiment, the third compound may comprise at least one of Compounds ETH1 to ETH86:

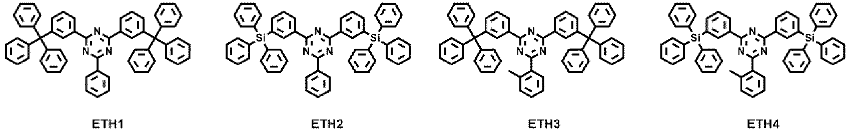

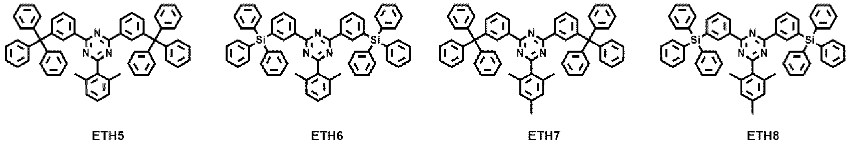

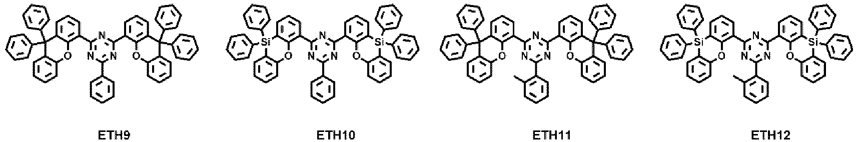

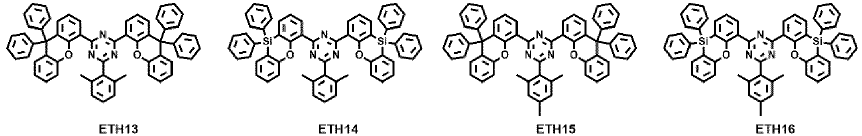

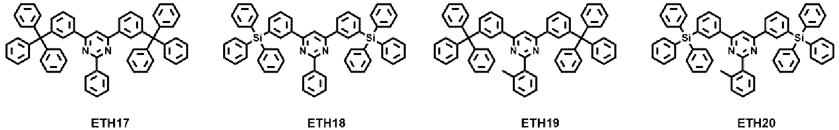

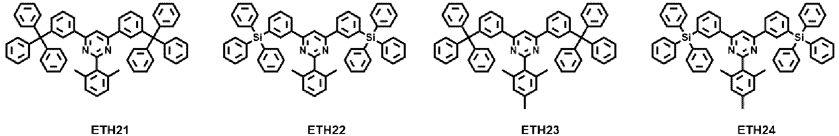

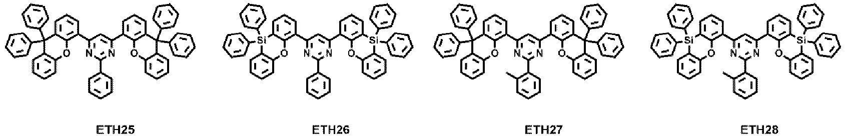

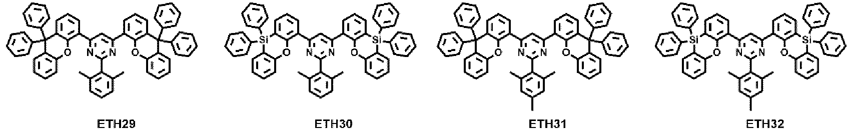

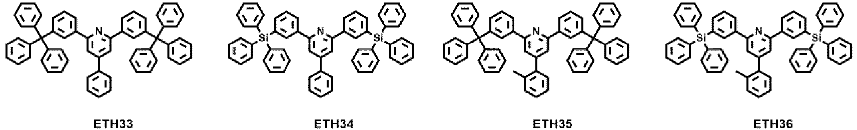

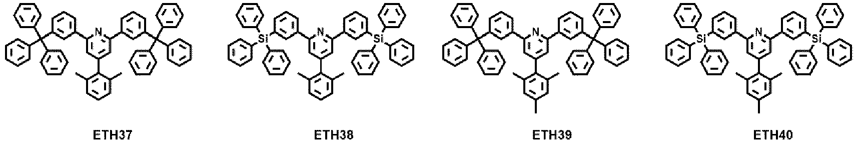

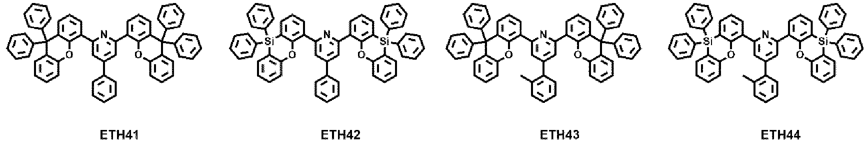

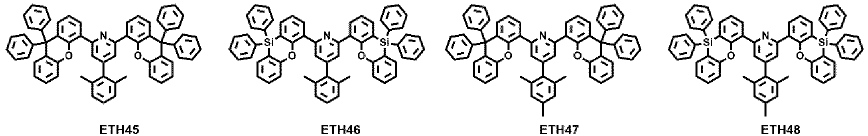

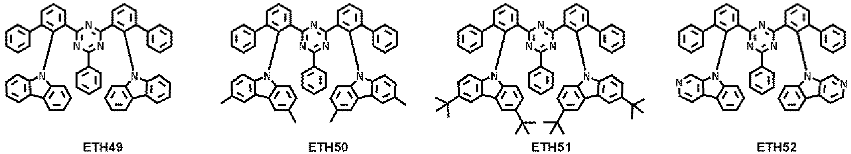

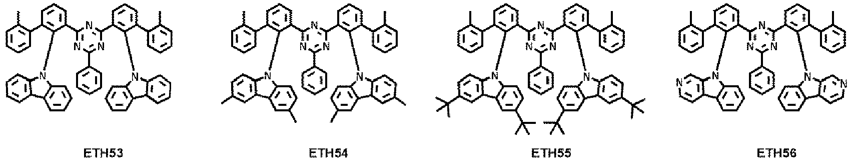

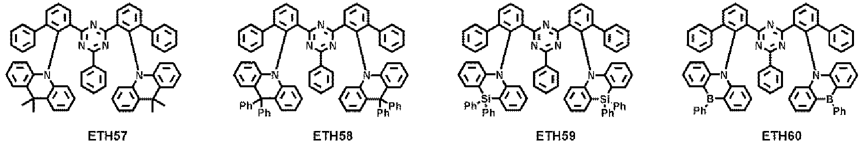

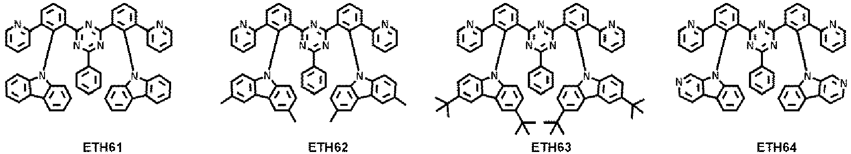

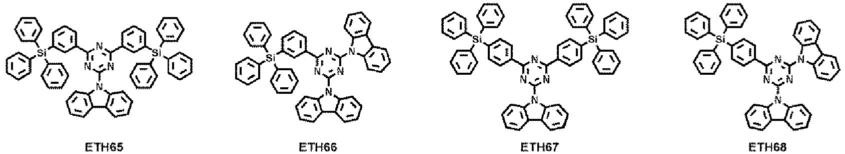

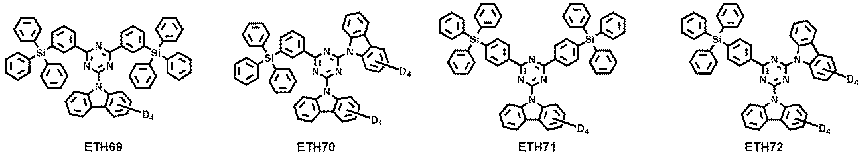

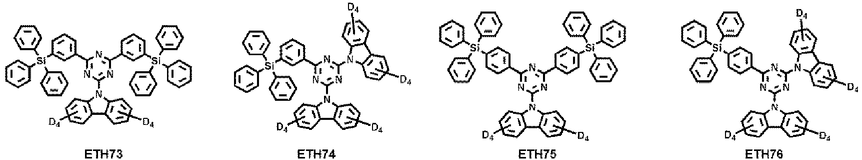

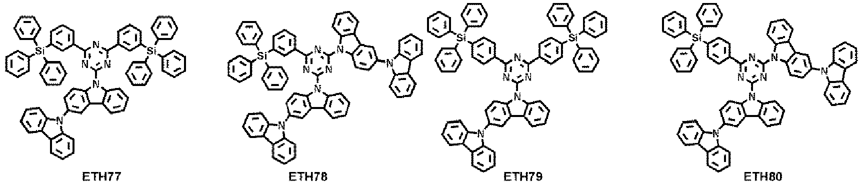

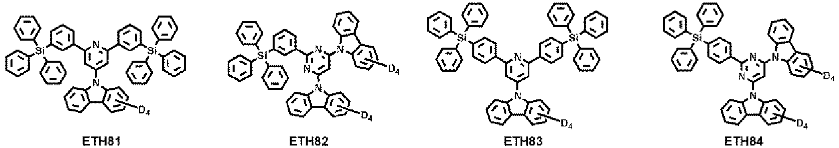

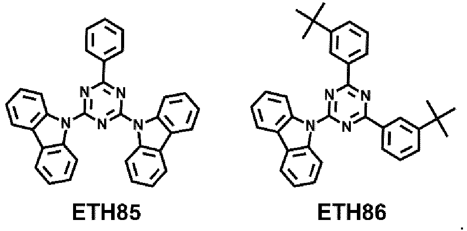

According to an embodiment, the fourth compound may comprise at least one of Compounds PD1 to PD41:

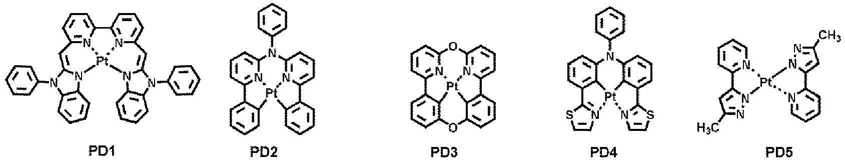

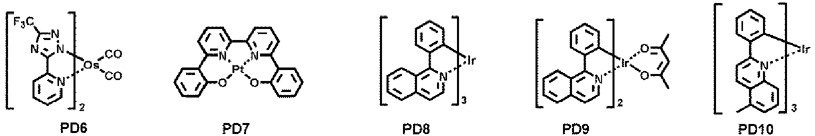

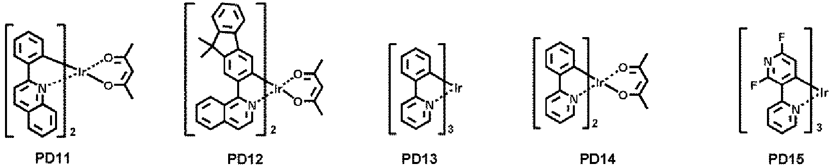

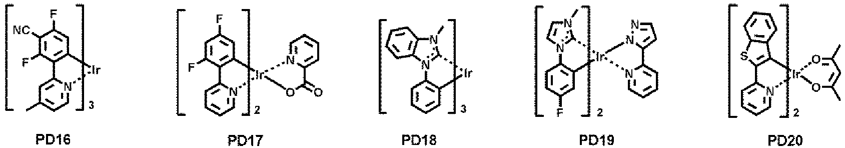

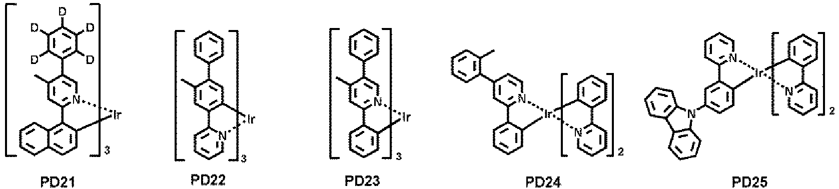

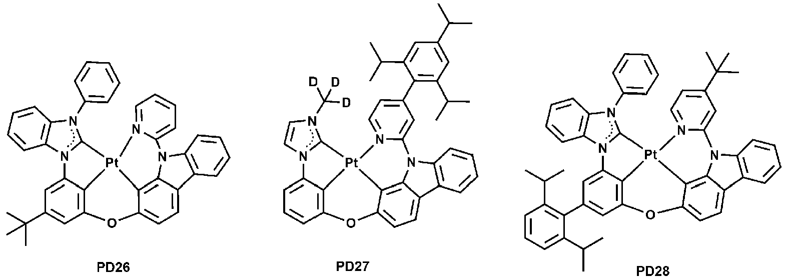

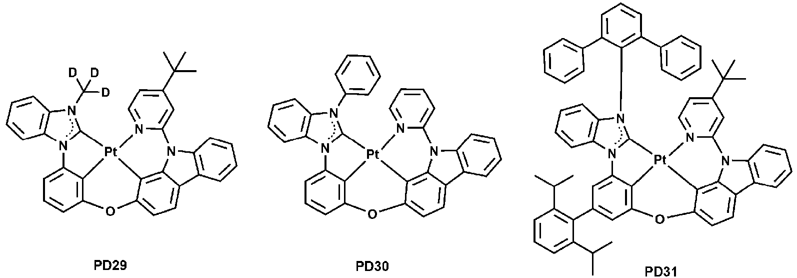

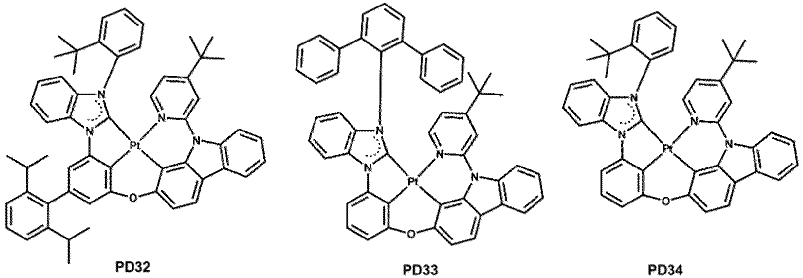

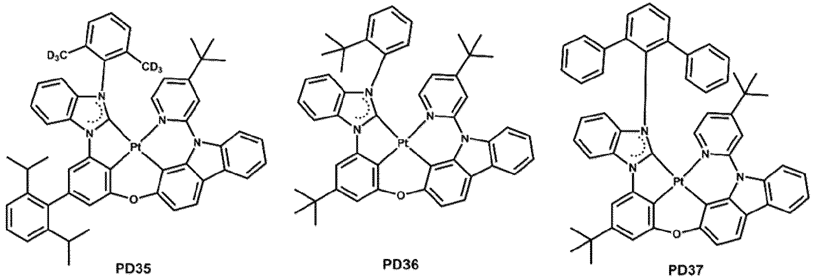

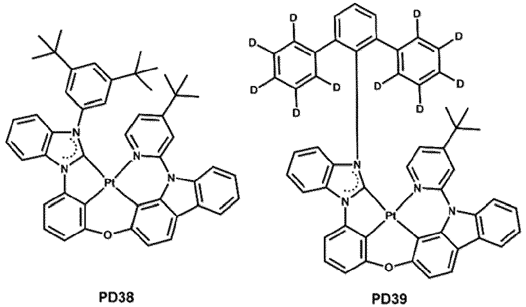

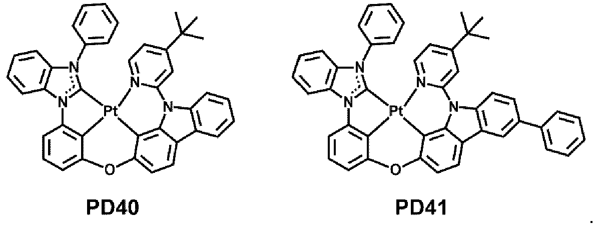

In Compounds HTH1 to HTH55 and ETH1 to ETH86, Ph may be a phenyl group, D₅ represents substitution with five deuterium atoms, and D₄ represents substitution with four deuterium atoms.

According to an embodiment, the light-emitting device may satisfy at least one of Conditions 1 to 4:

### [Condition 1]

Lowest unoccupied molecular orbital (LUMO) energy level (eV) of the second compound > LUMO energy level (eV) of the fourth compound

### [Condition 2]

LUMO energy level (eV) of the fourth compound > LUMO energy level (eV) of the third compound

### [Condition 3]

Highest occupied molecular orbital (HOMO) energy level (eV) of the fourth compound > HOMO energy level (eV) of the second compound

### [Condition 4]

HOMO energy level (eV) of the second compound > HOMO energy level (eV) of the third compound.

A HOMO energy level and a LUMO energy level of each of the first compound, the second compound, and the third compound may each be a negative value, and may be measured according to a method of the related art.

According to another embodiment, an absolute value of a difference between the LUMO energy level of the fourth compound and the LUMO energy level of the third compound may be in a range of about 0.1 eV to about 1.0 eV, an absolute value of a difference between the LUMO energy level of the fourth compound and the LUMO energy level of the second compound may be in a range of about 0.1 eV to about 1.0 eV or less, an absolute value of a difference between the HOMO energy level of the fourth compound and the HOMO energy level of the third compound may be less than or equal to about 1.25 eV (for example, in a range of about 0.2 eV to about 1.25 eV), and an absolute value of a difference between the HOMO energy level of the fourth compound and the HOMO energy level of the second compound may be less than about 1.25 eV (for example, in a range of about 0.2 eV to about 1.25 eV).

When the relationships between LUMO energy level and HOMO energy levels satisfy the conditions as described above, a balance between holes and electrons injected into the emission layer may be achieved.

The light-emitting device may have a structure of a first embodiment or a second embodiment:

### [Description of first embodiment]

According to a first embodiment, the first compound may be comprised in the emission layer in the interlayer of the light-emitting device, wherein the emission layer may further comprise a host, the first compound may be different from the host, and the emission layer may emit phosphorescence or fluorescence from the first compound. For example, according to the first embodiment, the first compound may be a dopant or an emitter. For example, the first compound may be a phosphorescent dopant or a phosphorescence emitter.

Phosphorescence or fluorescence emitted from the first compound may be blue light.

The emission layer may further comprise an auxiliary dopant. The auxiliary dopant may serve as a sensitizer that improves luminescence efficiency from the first compound by effectively transferring energy to the first compound which is a dopant or an emitter.

The auxiliary dopant may be different from the first compound and the host.

For example, the auxiliary dopant may be a phosphorescent dopant.

### [Description of second embodiment]

According to a second embodiment, the first compound may be comprised in the emission layer in the interlayer of the light-emitting device, wherein the emission layer may further comprise a host and a dopant, the first compound may be different from the host and the dopant, and the emission layer may emit phosphorescence or fluorescence (for example, delayed fluorescence) from the dopant.

For example, the first compound in the second embodiment may serve as an auxiliary dopant that transfers energy to a dopant (or to an emitter), but may not serve as a dopant.

As another example, the first compound in the second embodiment may serve as an emitter and also as an auxiliary dopant that transfers energy to a dopant (or to an emitter).

For example, phosphorescence or fluorescence emitted from the dopant (or the emitter) in the second embodiment may be blue phosphorescence or blue fluorescence (for example, blue delayed fluorescence).

The dopant (or an emitter) of the second embodiment may be a phosphorescent dopant material (for example, the organometallic compound represented by Formula 401 in the specification) or any fluorescent dopant material (for example, in the specification, the condensed cyclic compound represented by Formula 1, the compound represented by Formula 501, or any combination thereof).

In the first embodiment and the second embodiment, the blue light may be blue light having a maximum emission wavelength in a range of about 390 nm to about 500 nm. For example, the blue light may have a maximum emission wavelength in a range of about 410 nm to about 490 nm. For example, the blue light may have a maximum emission wavelength in a range of about 430 nm to about 480 nm. For example, the blue light may have a maximum emission wavelength in a range of about 440 nm to about 475 nm. For example, the blue light may have a maximum emission wavelength in a range of about 455 nm to about 470 nm.

The auxiliary dopant in the first embodiment may comprise, for example, a fourth compound represented by Formula 401.

The host in the first embodiment and in the second embodiment may be any host material (for example, in the specification, the compound represented by Formula 301, the compound represented by 301-1, the compound represented by Formula 301-2, or any combination thereof).

In another embodiment, the host in the first embodiment and in the second embodiment may be the second compound, the third compound, or any combination thereof.

Another aspect provides an electronic apparatus which may comprise the light-emitting device. The electronic apparatus may further comprise a thin-film transistor. For example, in an embodiment, the electronic apparatus may further comprise a thin-film transistor comprising a source electrode and a drain electrode, wherein the first electrode of the light-emitting device may be electrically connected to the source electrode or the drain electrode. In an embodiment, the electronic apparatus may further comprise a color filter, a color conversion layer, a touch screen layer, a polarizing layer, or any combination thereof. The electronic apparatus may be the same as described herein.

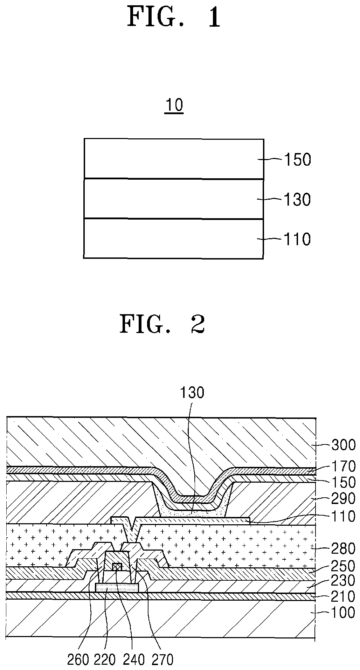

### [Description of FIG. 1]

FIG. 1 is a schematic cross-sectional view of a light-emitting device 10 according to an embodiment. The light-emitting device 10 comprises a first electrode 110, an interlayer 130, and a second electrode 150.

Hereinafter, the structure of the light-emitting device 10 according to an embodiment and a method of manufacturing the light-emitting device 10 will be described with reference to FIG. 1.

### [First electrode 110]

In FIG. 1, a substrate may be further comprised under the first electrode 110 or on the second electrode 150. In an embodiment, the substrate may be a glass substrate or a plastic substrate. In an embodiment, the substrate may be a flexible substrate, and may comprise plastics with excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a high-work function material that facilitates injection of holes may be used as a material for forming the first electrode 110.

The first electrode 110 may be a reflective electrode, a semi-transmissive electrode, or a transmissive electrode. To form the first electrode 110 which is a transmissive electrode, indium tin oxide (ITO), indium zinc oxide (IZO), tin oxide (SnO₂), zinc oxide (ZnO), or any combination thereof may be used as a material for forming the first electrode 110. The first electrode 110 may be a semi-transmissive electrode or a reflective electrode, and a material used to form the first electrode 110 may comprise magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a structure consisting of a single layer or a structure comprising multiple layers. For example, the first electrode 110 may have a three-layered structure of ITO/Ag/ITO.

### [Interlayer 130]

The interlayer 130 may be located on the first electrode 110. The interlayer 130 may comprise an emission layer.

The interlayer 130 may further comprise a hole transport region between the first electrode 110 and the emission layer, and an electron transport region between the emission layer and the second electrode 150.

The interlayer 130 may further comprise, in addition to various organic materials, a metal-containing compound such as an organometallic compound, an inorganic material such as quantum dots, or the like.

In an embodiment, the interlayer 130 may comprise two or more emitting units stacked between the first electrode 110 and the second electrode 150, and at least one charge generation layer between adjacent units among the two or more emitting units. When the interlayer 130 comprises the two or more emitting units and the at least one charge generation layer as described above, the light-emitting device 10 may be a tandem light-emitting device.

### [Hole transport region in interlayer 130]

The hole transport region may have a structure consisting of a layer consisting of a single material, a structure consisting of a layer comprising different materials, or a structure comprising multiple layers comprising different materials.

The hole transport region may comprise a hole injection layer, a hole transport layer, an emission auxiliary layer, an electron blocking layer, or any combination thereof.

In embodiments, the hole transport region may have a multi-layered structure comprising a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, the layers of each structure may be stacked from the first electrode 110 in its respective stated order, but the structure of the hole transport region is not limited thereto.

The hole transport region may comprise a compound represented by Formula 201, a compound represented by Formula 202, or any combination thereof:

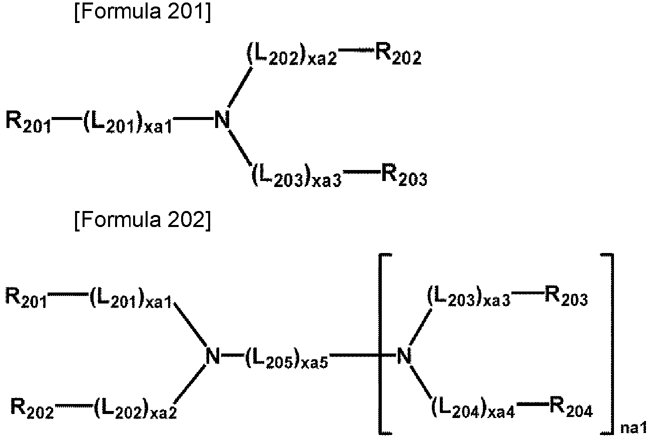

In Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ, or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group (for example, a carbazole group or the like) unsubstituted or substituted with at least one R₁₀ₐ (for example, see Compound HT16 or the like),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

In an embodiment, the compound represented by Formula 201 and the compound represented by Formula 202 may each independently comprise at least one of groups represented by Formulae CY201 to CY217:

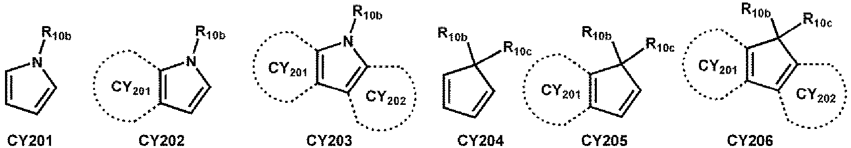

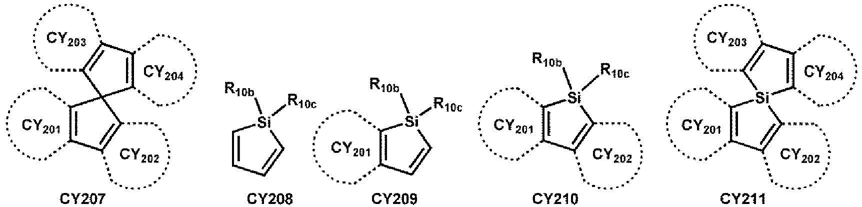

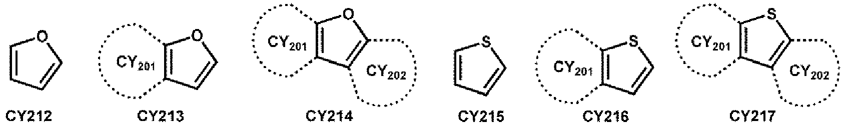

In Formulae CY201 to CY217, R_{10b} and R_{10c} may each independently be the same as described with respect to R₁₀ₐ herein, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ as described herein.

According to an embodiment, in Formulae CY201 to CY217, ring CY₂₀₁ to ring CY₂₀₄ may each independently be a benzene group, a naphthalene group, a phenanthrene group, or an anthracene group.

According to another embodiment, the compound represented by Formula 201 and the compound represented by Formula 202 may comprise at least one of groups represented by Formulae CY201 to CY203.

According to another embodiment, the compound represented by Formula 201 may comprise at least one of groups represented by Formulae CY201 to CY203 and at least one of groups represented by Formulae CY204 to CY217.

According to another embodiment, in Formula 201, xa1 may be 1, R₂₀₁ may be a group represented by one of Formulae CY201 to CY203, xa2 may be 0, and R₂₀₂ may be a group represented by one of Formulae CY204 to CY207.

According to another embodiment, the compound represented by Formula 201 and the compound represented by Formula 202 may each not comprise a group represented by one of Formulae CY201 to CY203.

According to another embodiment, the compound represented by Formula 201 and the compound represented by Formula 202 may each not comprise a group represented by one of Formulae CY201 to CY203, and may each independently comprise at least one of groups represented by Formulae CY204 to CY217.

In another embodiment, the compound represented by Formula 201 and the compound represented by Formula 202 may each not comprise a group represented by one of Formulae CY201 to CY217.

In an embodiment, the hole transport region may comprise one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any combination thereof:

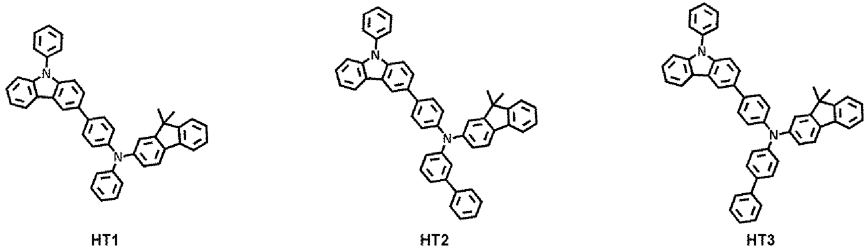

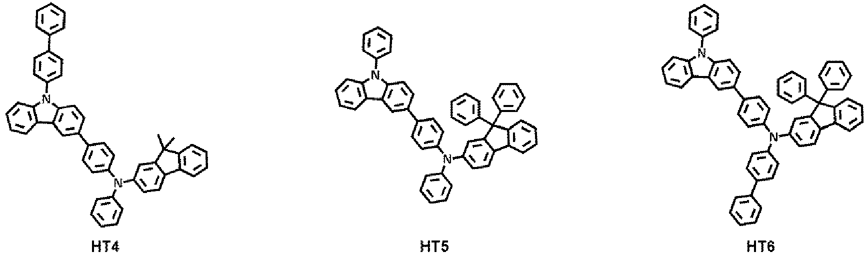

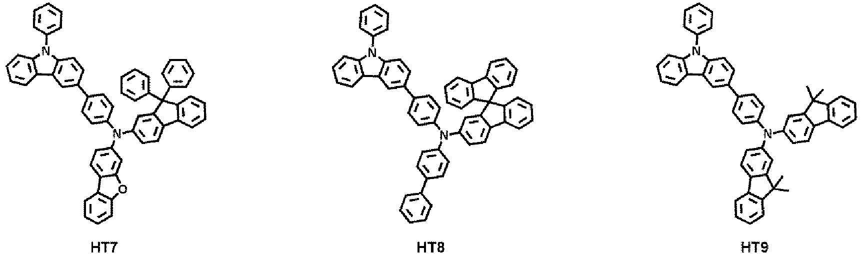

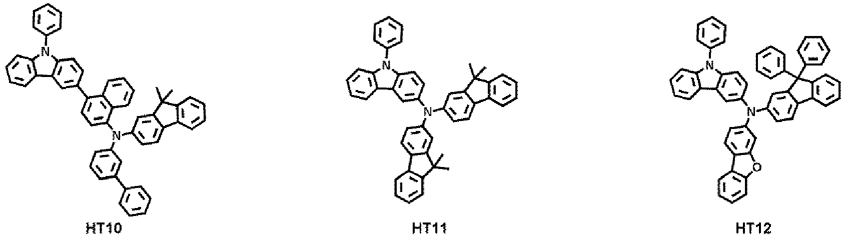

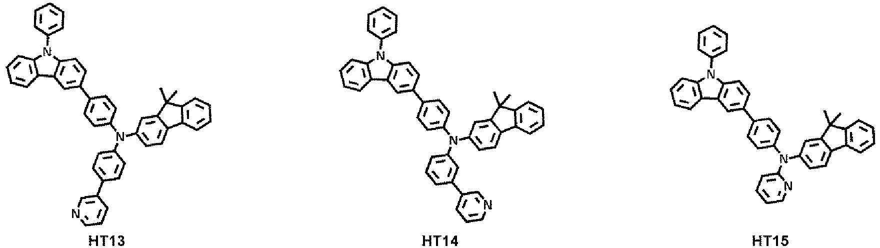

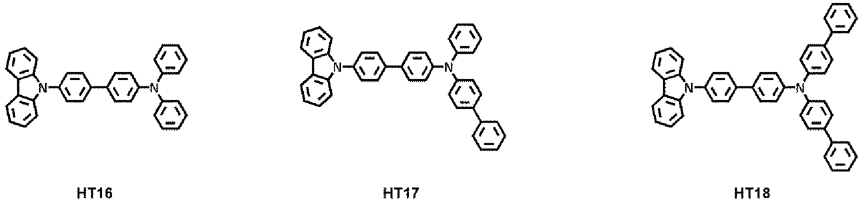

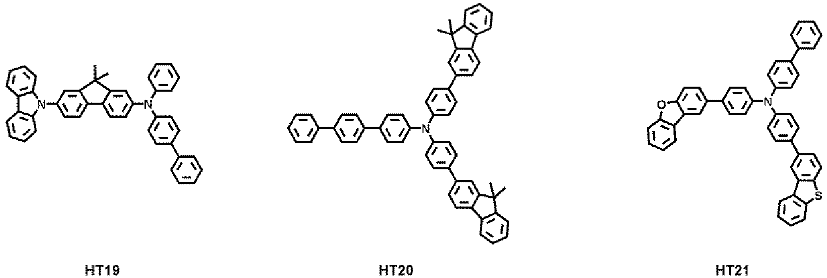

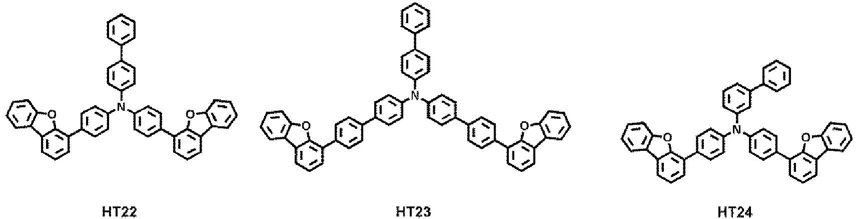

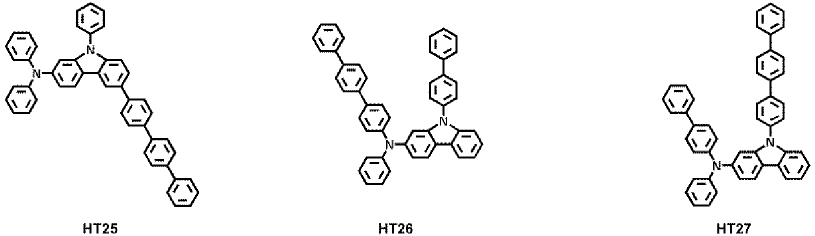

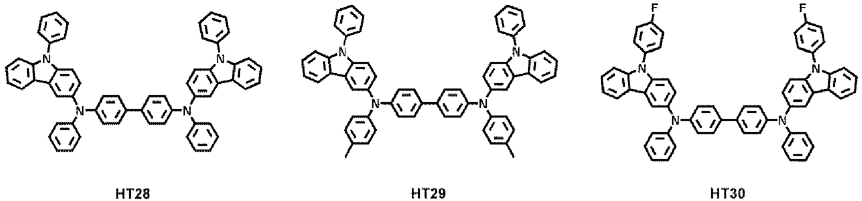

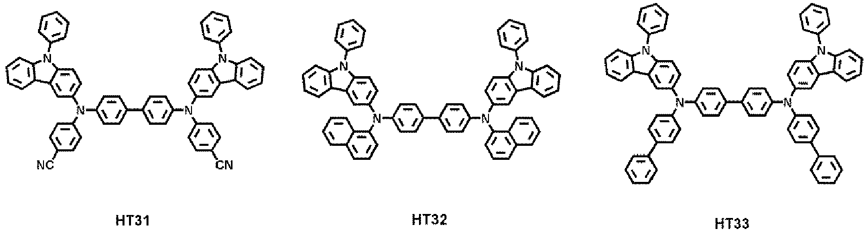

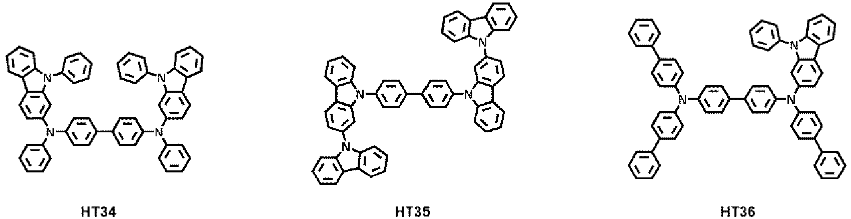

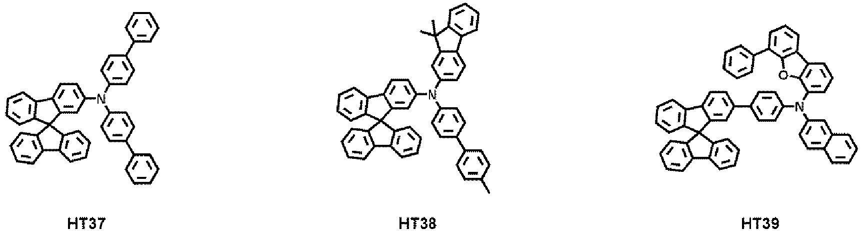

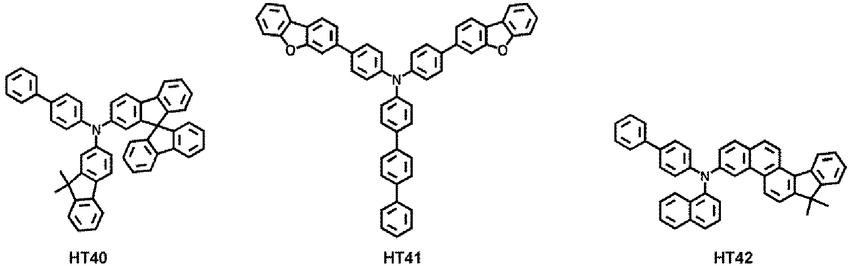

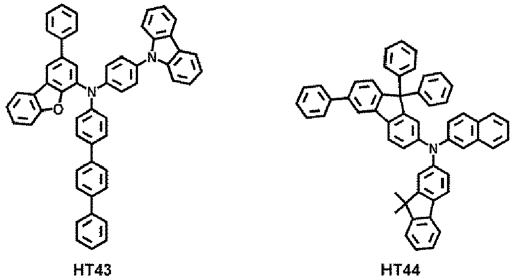

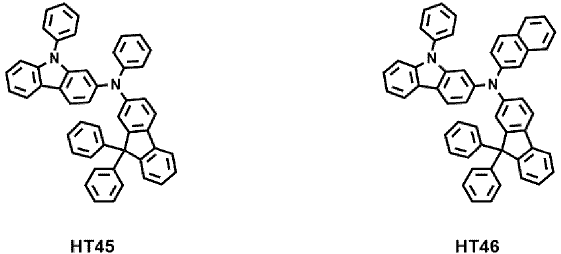

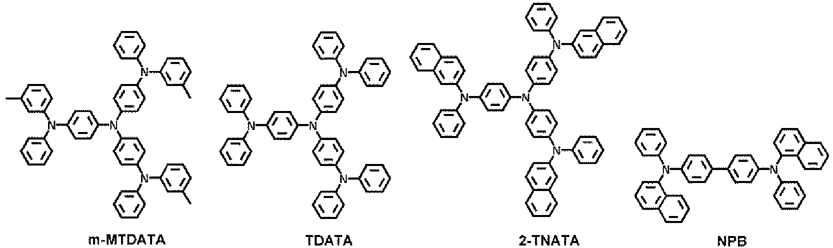

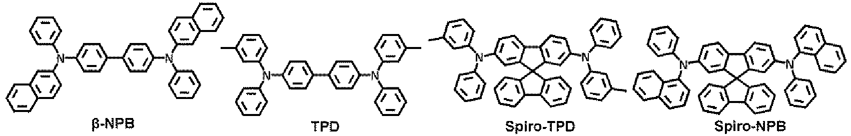

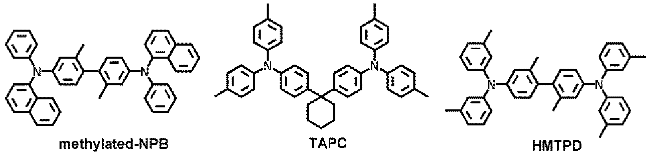

A thickness of the hole transport region may be in a range of about 50 Å to about 10,000 Å, For example, the thickness of the hole transport region may be in a range of about 100 Å to about 4,000 Å. When the hole transport region comprises a hole injection layer, a hole transport layer, or any combination thereof, a thickness of the hole injection layer may be in a range of about 100 Å to about 9,000 Å, and a thickness of the hole transport layer may be in a range of about 50 Å to about 2,000 Å. For example, the thickness of the hole injection layer may be in a range of about 100 Å to about 1,000 Å. For example, the thickness of the hole transport layer may be in a range of about 100 Å to about 1,500 Å. When the thicknesses of the hole transport region, the hole injection layer, and the hole transport layer are within any of these ranges, satisfactory hole transporting characteristics may be obtained without a substantial increase in driving voltage.

The emission auxiliary layer may increase luminescence efficiency by compensating for an optical resonance distance according to a wavelength of light emitted by an emission layer, and the electron blocking layer may block the leakage of electrons from an emission layer to a hole transport region. Materials that may be comprised in the hole transport region may be comprised in the emission auxiliary layer and the electron blocking layer.

### [p-dopant]

The hole transport region may further comprise, in addition to these materials, a charge-generating material for the improvement of conductive properties. The charge-generating material may be uniformly or non-uniformly dispersed in the hole transport region (for example, in the form of a single layer consisting of a charge-generating material).

The charge-generating material may be, for example, a p-dopant.

For example, the lowest unoccupied molecular orbital (LUMO) energy level of the p-dopant may be less than or equal to about -3.5 eV.

According to an embodiment, the p-dopant may comprise a quinone derivative, a cyano group-containing compound, a compound comprising element EL1 and element EL2, or any combination thereof.

Examples of a quinone derivative may comprise TCNQ, F4-TCNQ, etc.

Examples of a cyano group-containing compound may comprise HAT-CN, a compound represented by Formula 221, etc.:

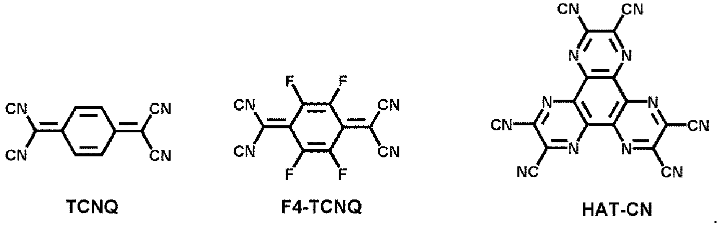

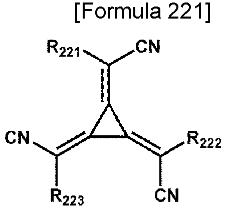

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, or any combination thereof; or any combination thereof.

In the compound comprising element EL1 and element EL2, element EL1 may be a metal, a metalloid, or any combination thereof, and element EL2 may be a non-metal, a metalloid, or any combination thereof.

Examples of a metal may comprise: an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.), etc.

Examples of a metalloid may comprise silicon (Si), antimony (Sb), tellurium (Te), etc.

Examples of a non-metal may comprise oxygen (O), halogen (for example, F, Cl, Br, I, etc.), etc.

For example, a compound comprising element EL1 and element EL2 may comprise a metal oxide, a metal halide (for example, a metal fluoride, a metal chloride, a metal bromide, a metal iodide, etc.), a metalloid halide (for example, a metalloid fluoride, a metalloid chloride, a metalloid bromide, a metalloid iodide, etc.), a metal telluride, or any combination thereof.

Examples of a metal oxide may comprise a tungsten oxide (for example, WO, W₂O₃, WO₂, WO₃, W₂O₅, etc.), a vanadium oxide (for example, VO, V₂O₃, VO₂, V₂O₅, etc.), a molybdenum oxide (MoO, Mo₂O₃, MoO₂, MoO₃, Mo₂O₅, etc.), a rhenium oxide (for example, ReO₃, etc.), etc.

Examples of a metal halide may comprise an alkali metal halide, an alkaline earth metal halide, a transition metal halide, a post-transition metal halide, a lanthanide metal halide, etc.

Examples of an alkali metal halide may comprise LiF, NaF, KF, RbF, CsF, LiCI, NaCl, KCI, RbCI, CsCI, LiBr, NaBr, KBr, RbBr, CsBr, Lil, Nal, KI, Rbl, Csl, etc.

Examples of an alkaline earth metal halide may comprise BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, etc.

Examples of a transition metal halide may comprise a titanium halide (for example, TiF₄, TiCl₄, TiBr₄, TiI₄, etc.), a zirconium halide (for example, ZrF₄, ZrCl₄, ZrBr₄, ZrI₄, etc.), a hafnium halide (for example, HfF₄, HfCl₄, HfBr₄, HfI₄, etc.), a vanadium halide (for example, VF₃, VCl₃, VBr₃, VI₃, etc.), a niobium halide (for example, NbF₃, NbCl₃, NbBr₃, NbI₃, etc.), a tantalum halide (for example, TaF₃, TaCl₃, TaBr₃, TaI₃, etc.), a chromium halide (for example, CrF₃, CrCl₃, CrBr₃, CrI₃, etc.), a molybdenum halide (for example, MoF₃, MoCl₃, MoBr₃, MoI₃, etc.), a tungsten halide (for example, WF₃, WCl₃, WBr₃, WI₃, etc.), a manganese halide (for example, MnF₂, MnCl₂, MnBr₂, MnI₂, etc.), a technetium halide (for example, TcF₂, TcCl₂, TcBr₂, TcI₂, etc.), a rhenium halide (for example, ReF₂, ReCl₂, ReBr₂, ReI₂, etc.), an iron halide (for example, FeF₂, FeCl₂, FeBr₂, FeI₂, etc.), a ruthenium halide (for example, RuF₂, RuCl₂, RuBr₂, RuI₂, etc.), an osmium halide (for example, OsF₂, OsCl₂, OsBr₂, OsI₂, etc.), a cobalt halide (for example, CoF₂, CoCl₂, CoBr₂, CoI₂, etc.), a rhodium halide (for example, RhF₂, RhCl₂, RhBr₂, RhI₂, etc.), an iridium halide (for example, IrF₂, IrCl₂, IrBr₂, IrI₂, etc.), a nickel halide (for example, NiF₂, NiCl₂, NiBr₂, NiI₂, etc.), a palladium halide (for example, PdF₂, PdCl₂, PdBr₂, PdI₂, etc.), a platinum halide (for example, PtF₂, PtCl₂, PtBr₂, PtI₂, etc.), a copper halide (for example, CuF, CuCI, CuBr, Cul, etc.), a silver halide (for example, AgF, AgCl, AgBr, Agl, etc.), a gold halide (for example, AuF, AuCI, AuBr, Aul, etc.), etc.

Examples of a post-transition metal halide may comprise a zinc halide (for example, ZnF₂, ZnCl₂, ZnBr₂, ZnI₂, etc.), an indium halide (for example, InI₃, etc.), a tin halide (for example, SnI₂, etc.), etc.

Examples of a lanthanide metal halide may comprise YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, SmI₃, etc.

Examples of a metalloid halide may comprise an antimony halide (for example, SbCl₅, etc.), etc.

Examples of a metal telluride may comprise an alkali metal telluride (for example, Li₂Te, Na₂Te, K₂Te, Rb₂Te, Cs₂Te, etc.), an alkaline earth metal telluride (for example, BeTe, MgTe, CaTe, SrTe, BaTe, etc.), a transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), a post-transition metal telluride (for example, ZnTe, etc.), and a lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### [Emission layer in interlayer 130]

When the light-emitting device 10 is a full-color light-emitting device, the emission layer may be patterned into a red emission layer, a green emission layer, and/or a blue emission layer, according to a subpixel. In an embodiment, the emission layer may have a stacked structure of two or more layers of a red emission layer, a green emission layer, and a blue emission layer, in which the two or more layers may contact each other or may be separated from each other to emit white light, or may a structure in which two or more materials of a red light-emitting material, a green light-emitting material, and a blue light-emitting material may be mixed with each other in a single layer to emit white light. For example, the emission layer may emit blue light.

According to an embodiment, the emission layer may comprise the condensed cyclic compound represented by Formula 1 as described herein.

In embodiments, the emission layer may comprise a host and a dopant.

According to an embodiment, the dopant may comprise the condensed cyclic compound represented by Formula 1 as described herein. In an embodiment, the dopant may further comprise, in addition to the condensed cyclic compound represented by Formula 1, a phosphorescent dopant, a fluorescent dopant, or any combination thereof. In addition to the condensed cyclic compound represented by Formula 1, a phosphorescent dopant, a fluorescent dopant, or the like may be further comprised in the emission layer. The phosphorescent dopant and the fluorescent dopant will be described later.

An amount of the dopant in the emission layer may be in a range of about 0.01 parts by weight to about 15 parts by weight, based on 100 parts by weight of the host.

In an embodiment, the emission layer may comprise a quantum dot.

The term "quantum dot" as used herein may be a crystal of a semiconductor compound, and may comprise any material capable of emitting light of various emission wavelengths according to a size of the crystal.

In an embodiment, the emission layer may comprise a delayed fluorescence material. The delayed fluorescence material may serve as a host or as a dopant in the emission layer.

A thickness of the emission layer may be in a range of about 100 Å to about 1,000 Å. For example, the thickness of the emission layer may be in a range of about 200 Å to about 600 Å. When the thickness of the emission layer is within any of these ranges, excellent luminescence characteristics may be obtained without a substantial increase in driving voltage.

### [Host]

The host in the emission layer may comprise the second compound or the third compound described in the specification, or any combination thereof.

In an embodiment, the host may comprise a compound represented by Formula 301:

[Formula 301] [Ar₃₀₁]_{xb11}**-**[(L₃₀₁)_{xb1}-R₃₀₁]_{xb21}

In Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or - P(=O)(Q₃₀₁)(Q₃₀₂),
xb21 may be an integer from 1 to 5, and
Q₃₀₁ to Q₃₀₃ may each independently be the same as described herein with respect to Q1.

In an embodiment in Formula 301, when xb11 is 2 or more, two or more of Ar₃₀₁(s) may be linked to each other via a single bond.

In an embodiment, the host may comprise a compound represented by Formula 301-1, a compound represented by Formula 301-2, or any combination thereof:

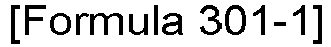

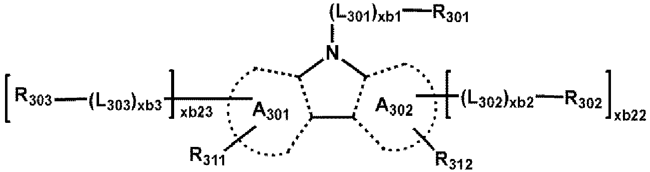

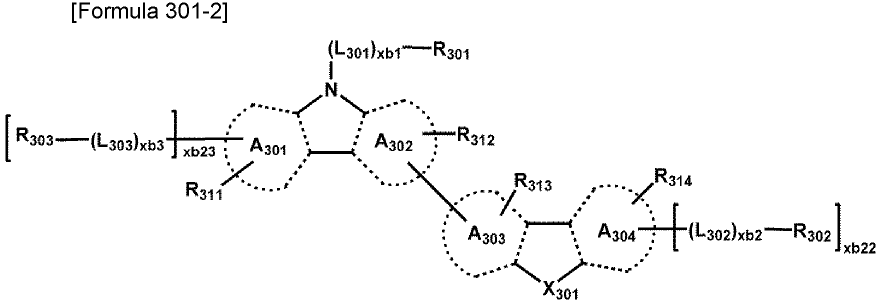

In Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be the same as described herein,
L₃₀₂ to L₃₀₄ may each independently be the same as described herein with respect to with L₃₀₁,
xb2 to xb4 may each independently be the same as described herein with respect to xb1, and
R₃₀₂ to R₃₀₅ and R₃₁₁ to R₃₁₄ may each independently be the same as described herein with respect to R₃₀₁.

In an embodiment, the host may comprise an alkali earth metal complex, a post-transition metal complex, or any combination thereof. For example, the host may comprise a Be complex (for example, Compound H55), an Mg complex, a Zn complex, or any combination thereof.

In another embodiment, the host may comprise one of Compounds H1 to H124, 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or any combination thereof:

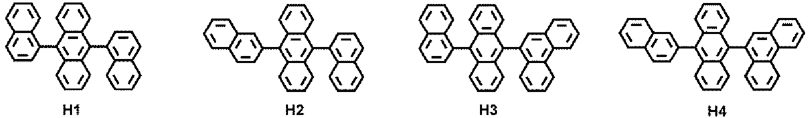

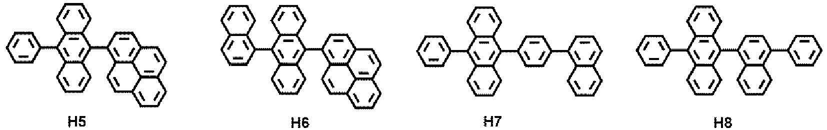

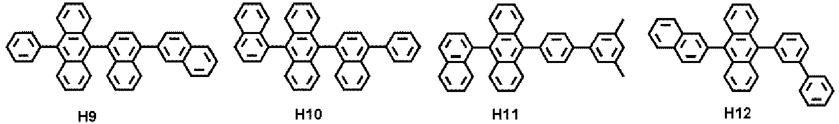

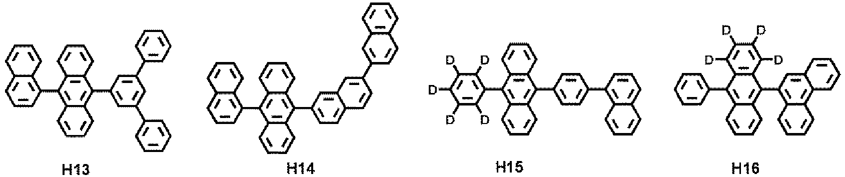

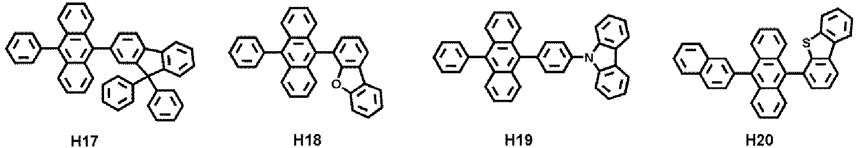

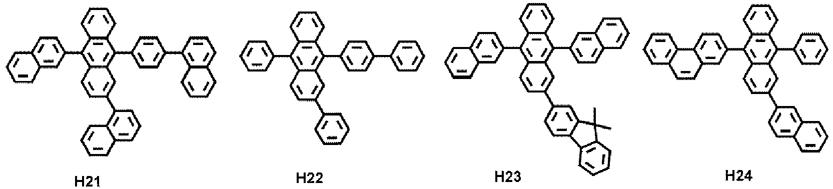

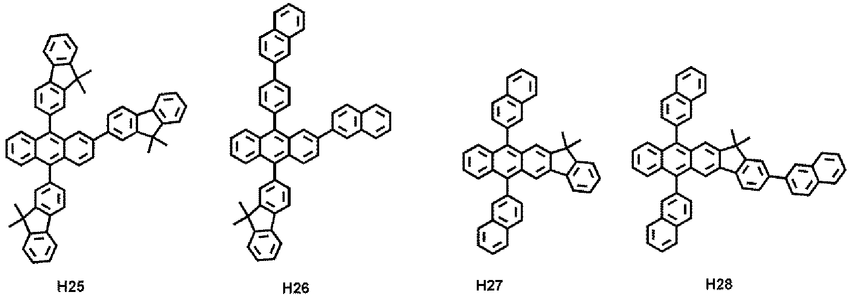

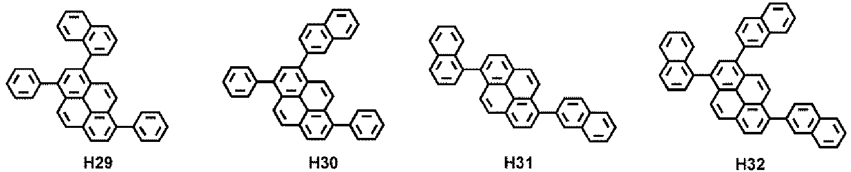

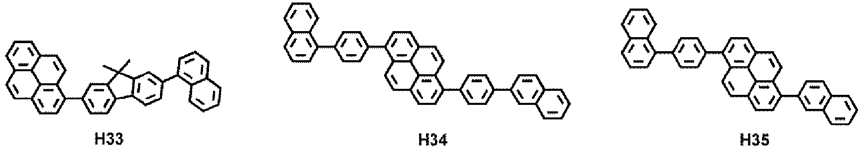

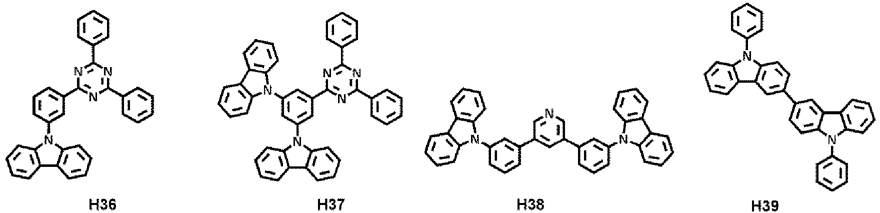

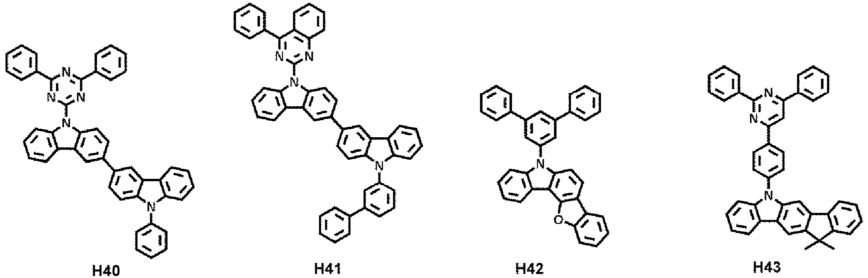

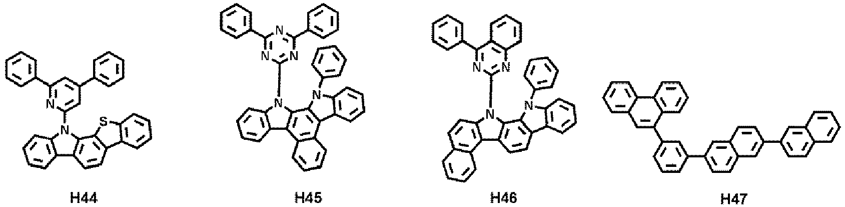

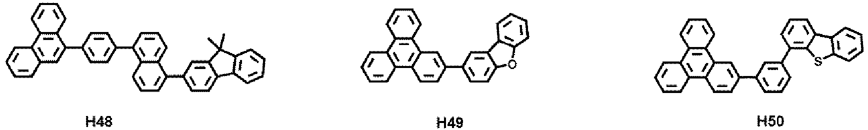

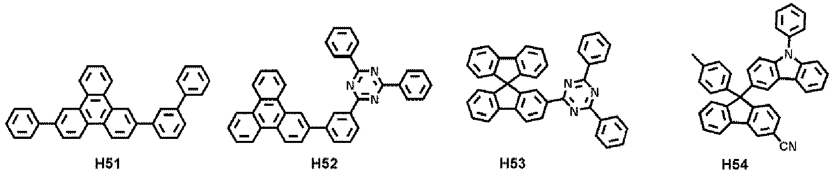

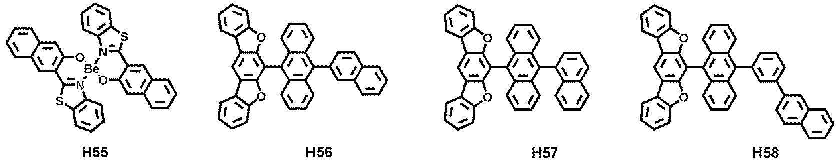

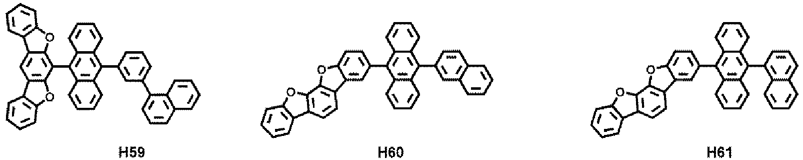

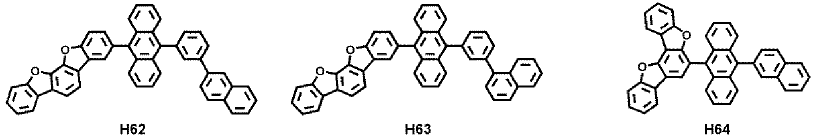

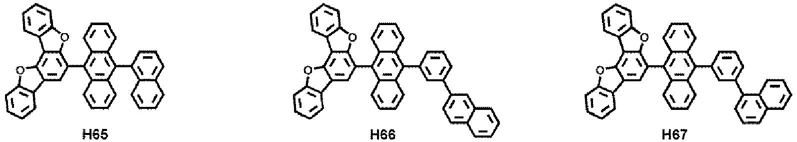

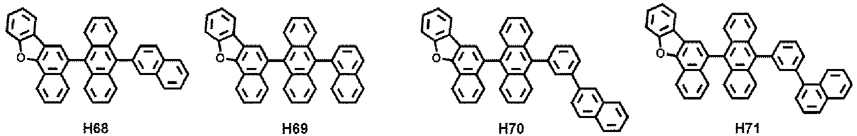

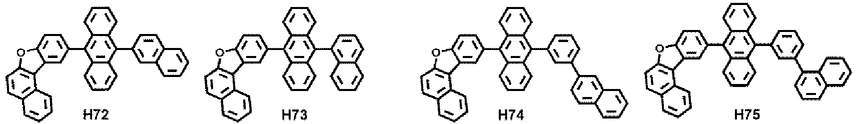

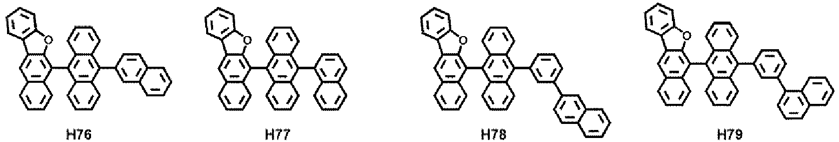

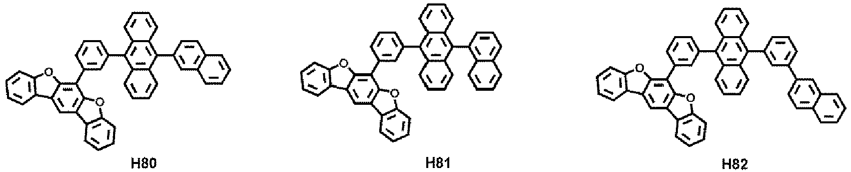

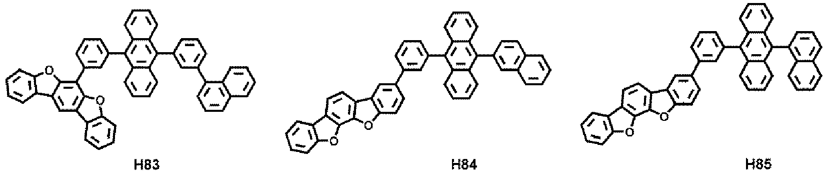

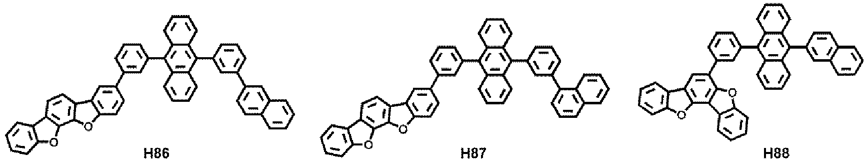

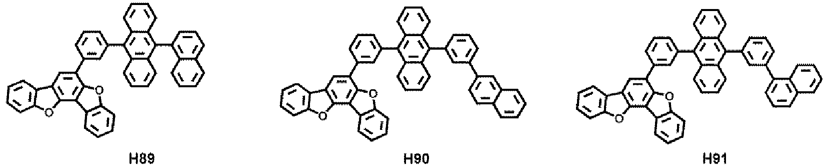

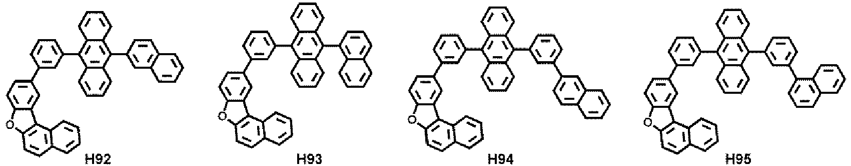

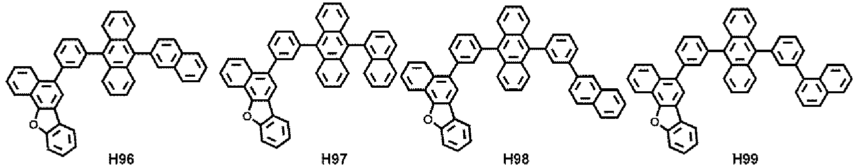

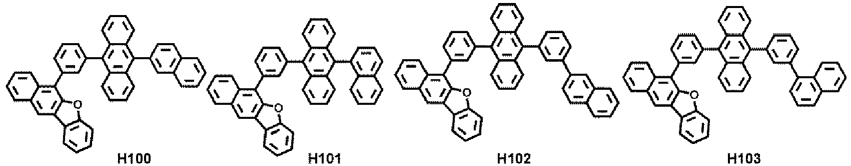

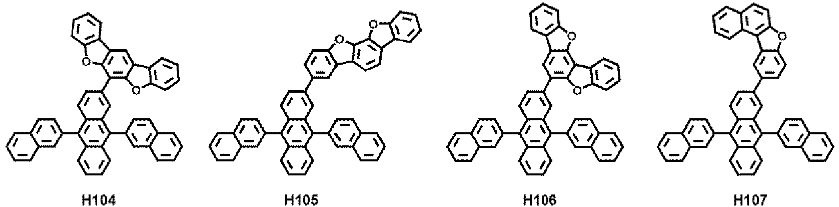

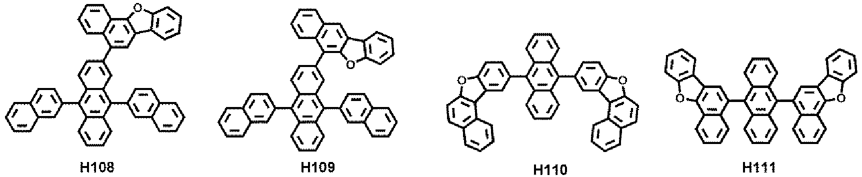

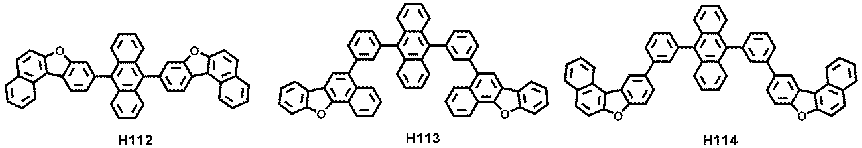

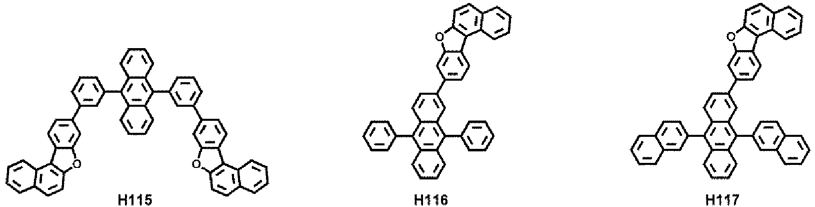

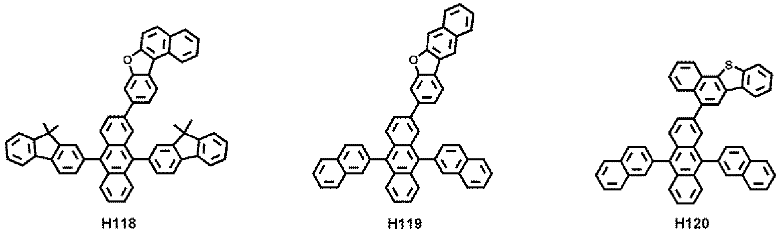

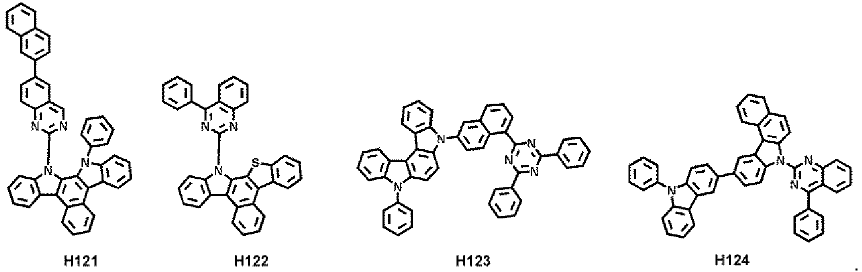

### [Phosphorescent dopant]

In an embodiment, the phosphorescent dopant may comprise at least one transition metal as a central metal.

The phosphorescent dopant may comprise a monodentate ligand, a bidentate ligand, a tridentate ligand, a tetradentate ligand, a pentadentate ligand, a hexadentate ligand, or any combination thereof.

The phosphorescent dopant may be electrically neutral.

In an embodiment, the phosphorescent dopant may comprise an organometallic compound represented by Formula 401:

[Formula 401] M(L₄₀₁)_{xc1}(L₄₀₂)_{xc2}

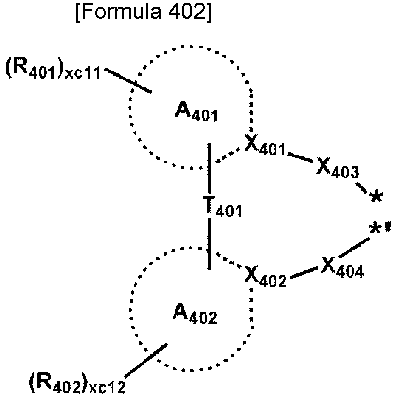

Formulae 401 and 402 may be the same as described herein.

The phosphorescent dopant may comprise, for example, one of Compounds PD1 to PD41, or any combination thereof.

### [Fluorescent dopant]

The fluorescent dopant may comprise an amine group-containing compound, a styryl group-containing compound, or any combination thereof.

In an embodiment, the fluorescent dopant may comprise a compound represented by Formula 501:

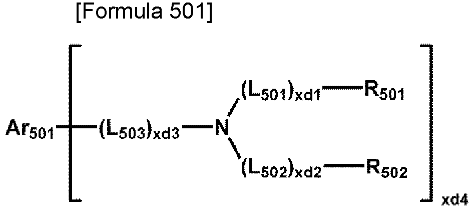

In Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

In an embodiment, in Formula 501, Ar₅₀₁ may be a condensed cyclic group (for example, an anthracene group, a chrysene group, a pyrene group, etc.) in which three or more monocyclic groups are condensed together.

In an embodiment, in Formula 501, xd4 may be 2.

In an embodiment, the fluorescent dopant may comprise one of Compounds FD1 to FD36, DPVBi, DPAVBi, or any combination thereof:

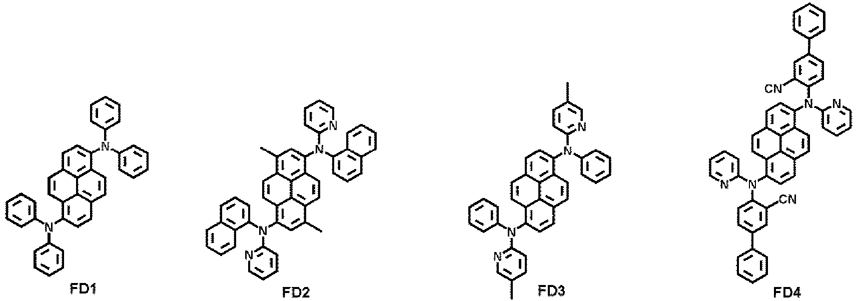

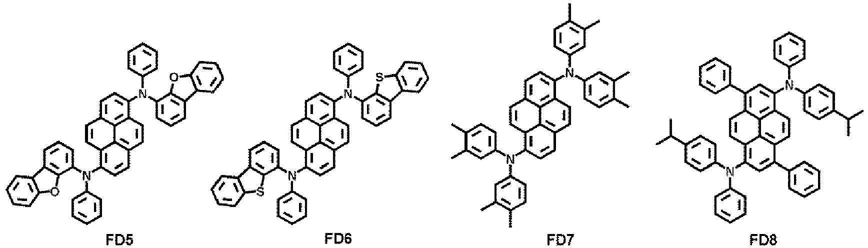

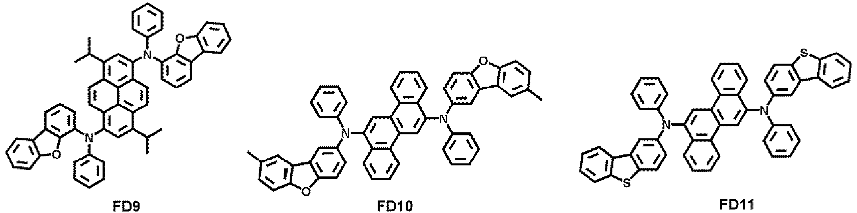

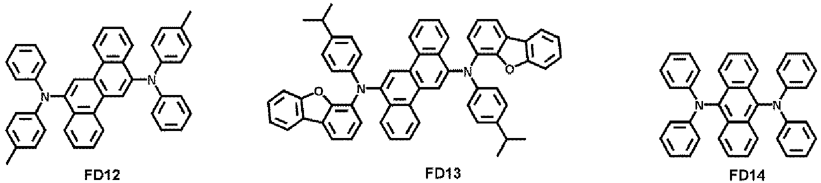

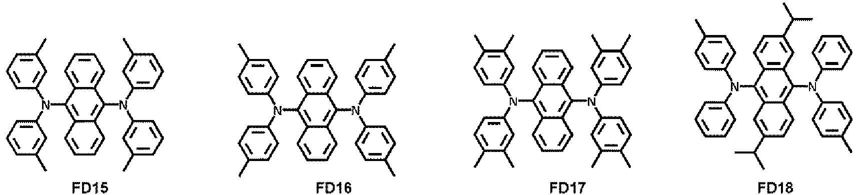

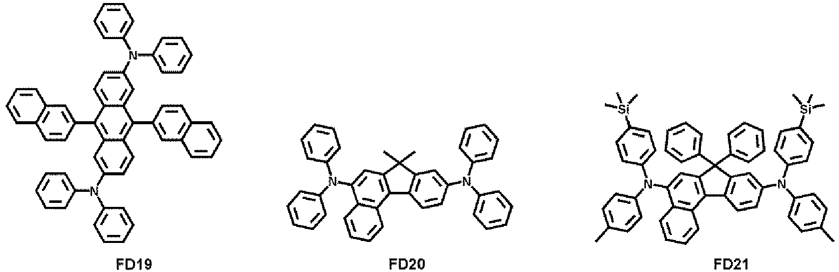

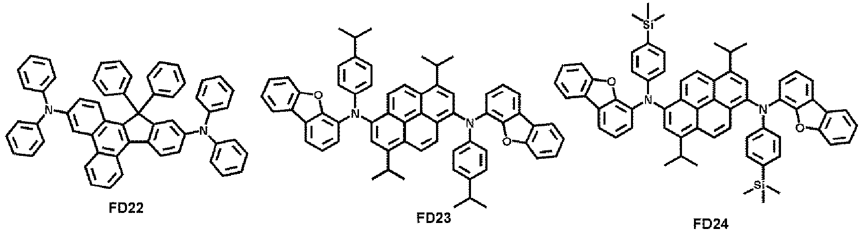

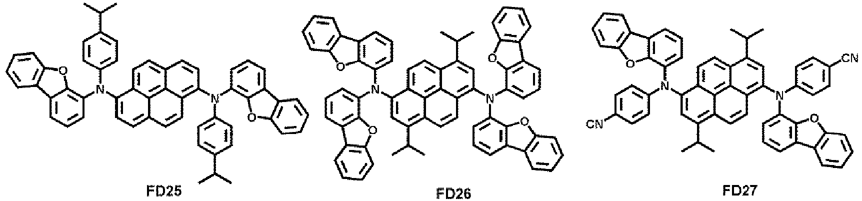

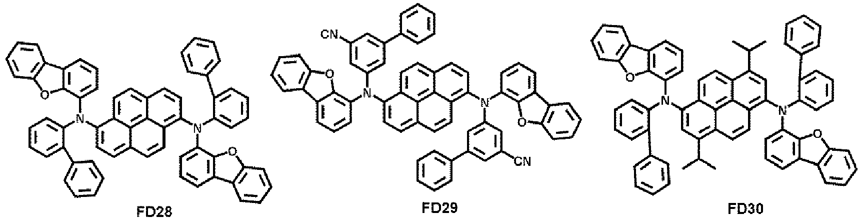

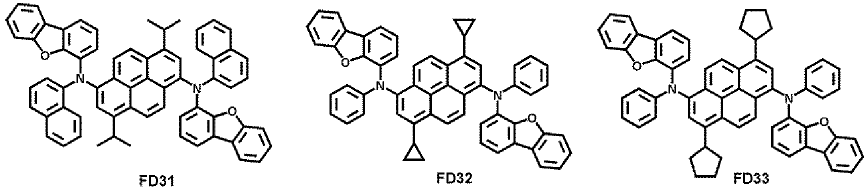

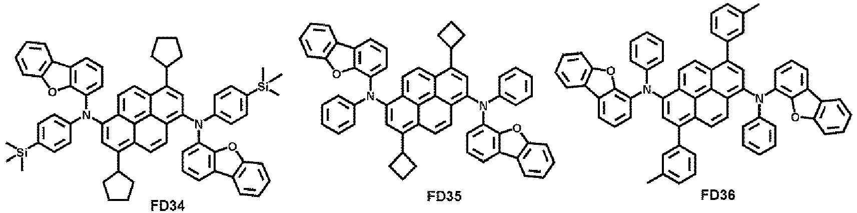

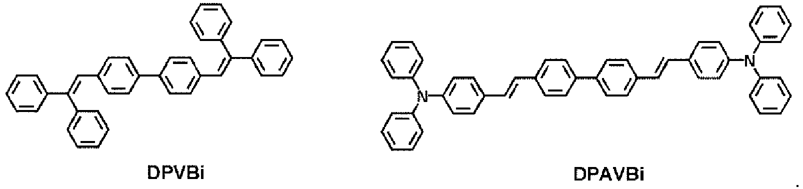

### [Electron transport region in interlayer 130]

The electron transport region may have a structure consisting of a layer consisting of a single material, a structure consisting of a layer comprising different materials, or a structure comprising multiple layers comprising different materials.

The electron transport region may comprise a buffer layer, a hole blocking layer, an electron control layer, an electron transport layer, an electron injection layer, or any combination thereof.

In an embodiment, the electron transport region may have an electron transport layer/electron injection layer structure, a hole blocking layer/electron transport layer/electron injection layer structure, an electron control layer/electron transport layer/electron injection layer structure, a buffer layer/electron transport layer/electron injection layer structure, or the like, wherein the layers of each structure may be stacked from an emission layer in its respective stated order, but the structure of the electron transport region is not limited thereto.

In an embodiment, the electron transport region (for example, a buffer layer, a hole blocking layer, an electron control layer, or an electron transport layer in the electron transport region) may comprise a metal-free compound comprising at least one π electron-deficient nitrogen-containing C₁-C₆₀ cyclic group.

In an embodiment, the electron transport region may comprise a compound represented by Formula 601:

[Formula 601] [Ar₆₀₁]ₓₑ₁₁-[(L₆₀₁)ₓₑ₁-R₆₀₁]ₓₑ₂₁

In Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, - Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each independently be the same as described herein with respect to Q1,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group unsubstituted or substituted with at least one R₁₀ₐ.

In an embodiment, in Formula 601, when xe11 is 2 or more, two or more of Ar₆₀₁(s) may be linked to each other via a single bond.

In an embodiment, in Formula 601, Ar₆₀₁ may be a substituted or unsubstituted anthracene group.

In an embodiment, the electron transport region may comprise a compound represented by Formula 601-1:

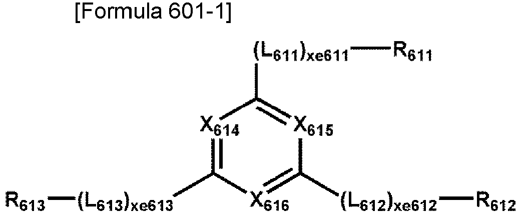

In Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may each be N,
L₆₁₁ to L₆₁₃ may each independently be the same as described herein with respect to L₆₀₁,
xe611 to xe613 may each independently be the same as described herein with respect to xe1,
R₆₁₁ to R₆₁₃ may each independently be the same as described herein with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

In an embodiment, in Formulae 601 and 601-1, xe1 and xe611 to xe613 may each independently be 0, 1, or 2.

In an embodiment, the electron transport region may comprise one of Compounds ET1 to ET45, 2,9-dimethyl-4,7-diphenyl-1,10-phenanthroline (BCP), 4,7-diphenyl-1,10-phenanthroline (Bphen), Alq₃, BAlq, TAZ, NTAZ, or any combination thereof:

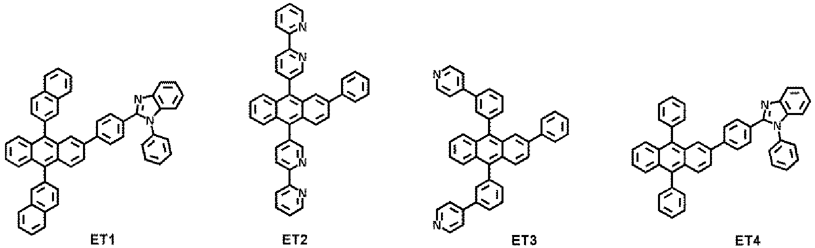

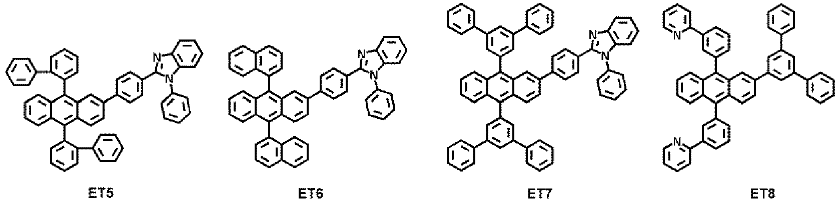

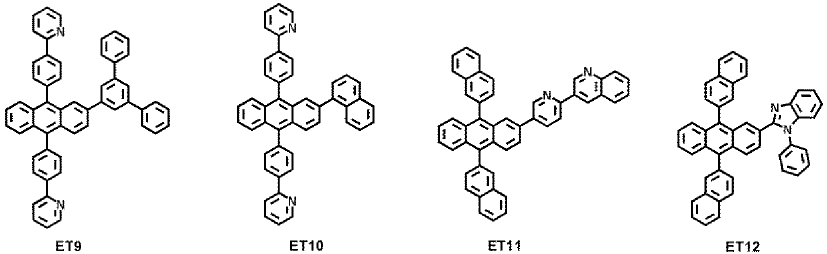

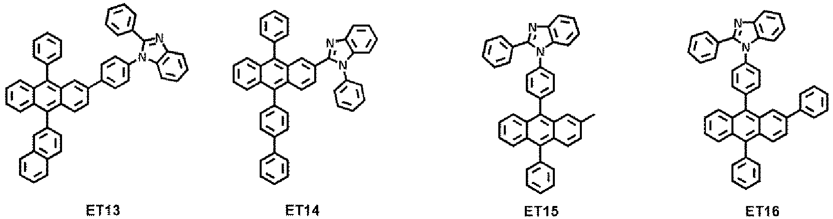

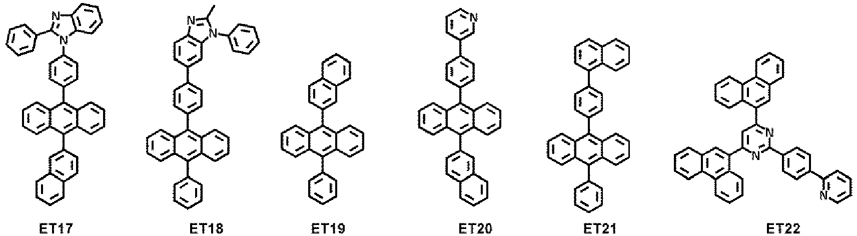

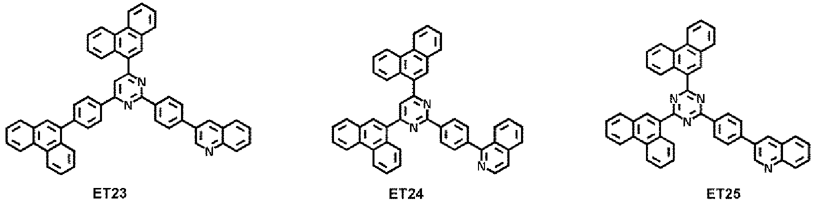

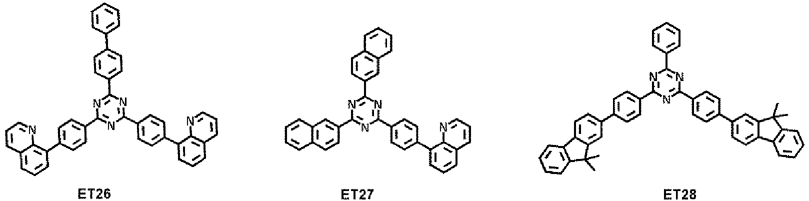

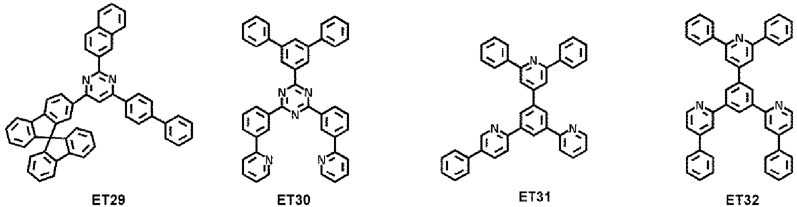

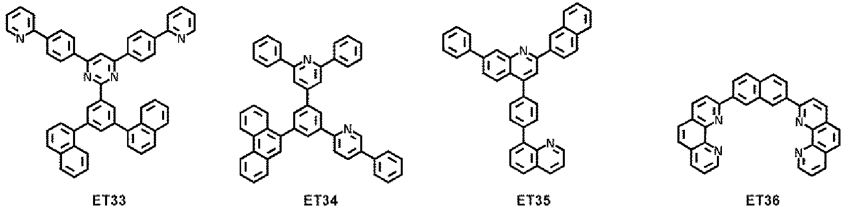

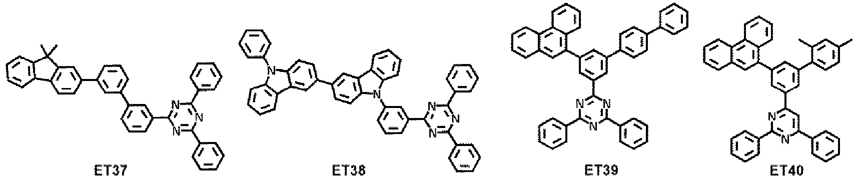

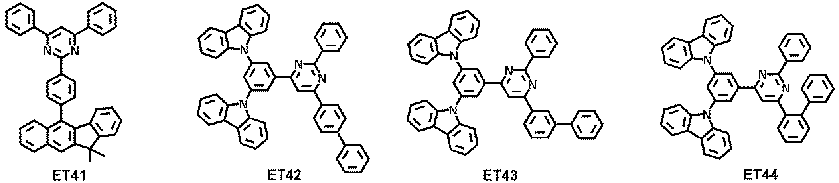

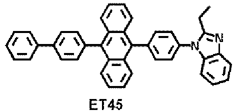

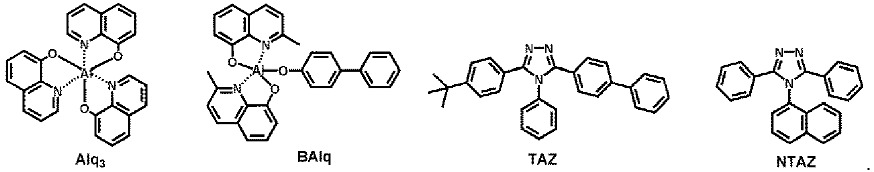

A thickness of the electron transport region may be in a range of about 160 Å to about 5,000 Å. For example, the thickness of the electron transport region may be in a range of about 100 Å to about 4,000 Å. When the electron transport region comprises a buffer layer, a hole blocking layer, an electron control layer, an electron transport layer, or any combination thereof, a thickness of the buffer layer, the hole blocking layer, or the electron control layer may each independently be in a range of about 20 Å to about 1000 Å. For example, the thickness of the buffer layer, the hole blocking layer, or the electron control layer may each independently be in a range of about 30 Å to about 300 Å. A thickness of the electron transport layer may be in a range of about 100 Å to about 1000 Å. For example, the thickness of the electron transport layer may be in a range of about 150 Å to about 500 Å. When the thickness of the buffer layer, the hole blocking layer, the electron control layer, the electron transport layer, and/or the electron transport layer are within any of these ranges, satisfactory electron transporting characteristics may be obtained without a substantial increase in driving voltage.

The electron transport region (for example, the electron transport layer in the electron transport region) may further comprise, in addition to the materials described above, a metal-containing material.

The metal-containing material may comprise an alkali metal complex, an alkaline earth metal complex, or any combination thereof. A metal ion of an alkali metal complex may be a Li ion, a Na ion, a K ion, a Rb ion, or a Cs ion, and a metal ion of an alkaline earth metal complex may be a Be ion, a Mg ion, a Ca ion, a Sr ion, or a Ba ion.

A ligand coordinated with a metal ion of an alkali metal complex or an alkaline earth metal complex may comprise a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, the metal-containing material may comprise a Li complex. The Li complex may comprise, for example, Compound ET-D1 (LiQ) or Compound ET-D2:

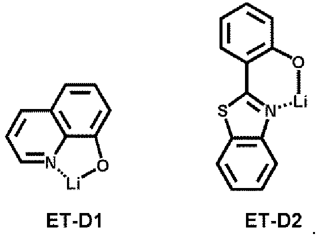

The electron transport region may comprise an electron injection layer that facilitates the injection of electrons from the second electrode 150. The electron injection layer may contact (e.g., directly contact) the second electrode 150.

The electron injection layer may have a structure consisting of a layer consisting of a single material, a structure consisting of a layer comprising different materials, or a structure comprising multiple layers comprising different materials.

The electron injection layer may comprise an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may comprise Li, Na, K, Rb, Cs, or any combination thereof. The alkaline earth metal may comprise Mg, Ca, Sr, Ba, or any combination thereof. The rare earth metal may comprise Sc, Y, Ce, Tb, Yb, Gd, or any combination thereof.

The alkali metal-containing compound, the alkaline earth metal-containing compound, and the rare earth metal-containing compound may comprise oxides, halides (for example, fluorides, chlorides, bromides, iodides, etc.), or tellurides of the alkali metal, the alkaline earth metal, and the rare earth metal, or any combination thereof.

The alkali metal-containing compound may comprise an alkali metal oxide, such as Li₂O, Cs₂O, K₂O, etc., an alkali metal halide, such as LiF, NaF, CsF, KF, Lil, Nal, Csl, KI, etc., or any combination thereof. The alkaline earth metal-containing compound may comprise an alkaline earth metal compound, such as BaO, SrO, CaO, BaₓSr₁₋ₓO (wherein x is a real number satisfying the condition of 0<x<1), BaₓCa₁₋ₓO (wherein x is a real number satisfying the condition of 0<x<1), etc. The rare earth metal-containing compound may comprise YbF₃, ScF₃, Sc₂O₃, Y₂O₃, Ce₂O₃, GdF₃, TbF₃, YbI₃, ScI₃, TbI₃, or any combination thereof. The rare earth metal-containing compound may comprise a lanthanide metal telluride. Examples of a lanthanide metal telluride may comprise LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and the like.

The alkali metal complex, the alkaline earth metal complex, and the rare earth metal complex may comprise an alkali metal ion, an alkaline earth metal ion, or a rare earth metal ion and a ligand bonded to the metal ion (for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or any combination thereof).

The electron injection layer may consist only of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above, or the electron injection layer may further comprise an organic material (for example, a compound represented by Formula 601).

According to an embodiment, the electron injection layer may consist of: an alkali metal-containing compound (for example, an alkali metal halide); or the electron injection layer may consist of an alkali metal-containing compound (for example, an alkali metal halide), and an alkali metal, an alkaline earth metal, a rare earth metal, or any combination thereof. For example, the electron injection layer may be a KI:Yb co-deposited layer, an Rbl:Yb co-deposited layer, etc.

When the electron injection layer further comprises an organic material, an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof may be uniformly or non-uniformly dispersed in a matrix comprising the organic material.

A thickness of the electron injection layer may be in a range of about 1 Å to about 100 Å. For example, the thickness of the electron injection layer may be in a range of about 3 Å to about 90 Å. When the thickness of the electron injection layer is within any of these ranges, satisfactory electron injection characteristics may be obtained without a substantial increase in driving voltage.

### [Second electrode 150]

The second electrode 150 may be located on the interlayer 130 as described above. The second electrode 150 may be a cathode, which is an electron injection electrode. When the second electrode 150 is a cathode, a material for forming the second electrode 150 may comprise a material having a low-work function, such as a metal, an alloy, an electrically conductive compound, or any combination thereof.

The second electrode 150 may comprise lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure having a single layer or a multi-layered structure.

### [Capping layer]

The light-emitting device 10, may comprise a first capping layer outside the first electrode 110, and/or a second capping layer outside the second electrode 150. For example, the light-emitting device 10 may have a structure in which the first capping layer, the first electrode 110, the interlayer 130, and the second electrode 150 are stacked in this stated order, a structure in which the first electrode 110, the interlayer 130, the second electrode 150, and the second capping layer are stacked in this stated order, or a structure in which the first capping layer, the first electrode 110, the interlayer 130, the second electrode 150, and the second capping layer are stacked in this stated order.

Light generated in an emission layer of the interlayer 130 of the light-emitting device 10 may be extracted through the first electrode 110, which may be a semi-transmissive electrode or a transmissive electrode, and through the first capping layer to the outside. Light generated in an emission layer of the interlayer 130 of the light-emitting device 10 may be extracted through the second electrode 150, which may be a semi-transmissive electrode or a transmissive electrode, and through the second capping layer to the outside.

The first capping layer and the second capping layer may each increase external luminescence efficiency according to the principle of constructive interference. Accordingly, the light extraction efficiency of the light-emitting device 10 is increased, so that the luminescence efficiency of the light-emitting device 10 may be improved.

The first capping layer and the second capping layer may each comprise a material having a refractive index greater than or equal to about 1.6 (with respect to a wavelength of about 589 nm).

The first capping layer and the second capping layer may each independently be an organic capping layer comprising an organic material, an inorganic capping layer comprising an inorganic material, or an organic-inorganic composite capping layer comprising an organic material and an inorganic material.

At least one of the first capping layer and the second capping layer may each independently comprise a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent comprising O, N, S, Se, Si, F, Cl, Br, I, or any combination thereof.

According to an embodiment, at least one of the first capping layer and the second capping layer may each independently comprise an amine group-containing compound.

In an embodiment, at least one of the first capping layer and the second capping layer may each independently comprise a compound represented by Formula 201, a compound represented by Formula 202, or any combination thereof.

According to another embodiment, at least one of the first capping layer and the second capping layer may each independently comprise one of Compounds HT28 to HT33, one of Compounds CP1 to CP6, β-NPB, or any combination thereof:

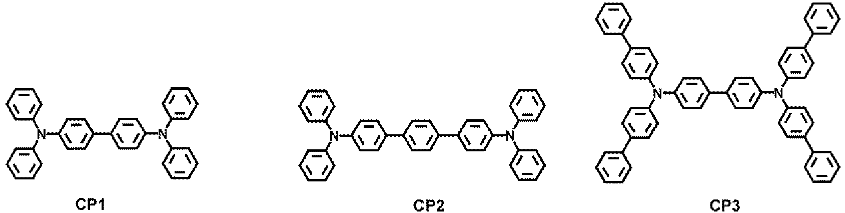

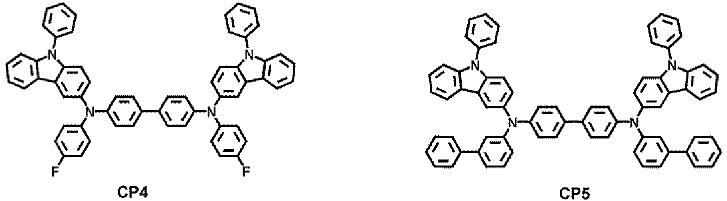

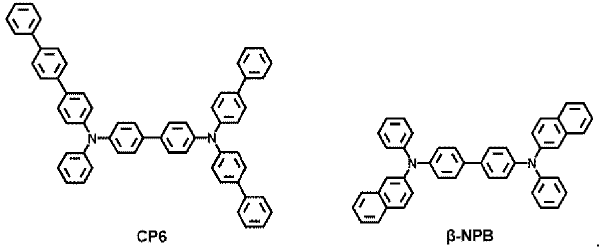

### [Film]

The condensed cyclic compound represented by Formula 1 may be comprised in various films. Accordingly, embodiments provide a film comprising the condensed cyclic compound represented by Formula 1. The film may be, for example, an optical member (or a light control means) (for example, a color filter, a color conversion member, a capping layer, a light extraction efficiency enhancement layer, a selective light absorbing layer, a polarizing layer, a quantum dot-containing layer, etc.), a light-blocking member (for example, a light reflective layer, a light absorbing layer, etc.), a protective member (for example, an insulating layer, a dielectric layer, etc.), etc.

### [Electronic apparatus]

The light-emitting device may be comprised in various electronic apparatuses. For example, the electronic apparatus comprising the light-emitting device may be a light-emitting apparatus, an authentication apparatus, or the like.

The electronic apparatus (for example, a light-emitting apparatus) may further comprise, in addition to the light-emitting device, a color filter, a color conversion layer, or a color filter and a color conversion layer. The color filter and/or the color conversion layer may be located in at least one direction in which light emitted from the light-emitting device travels. For example, the light emitted from the light-emitting device may be blue light or white light. The light-emitting device may be a light-emitting device as described herein. According to an embodiment, the color conversion layer may comprise a quantum dot. The quantum dot may be, for example, a quantum dot as described herein.

The electronic apparatus may comprise a first substrate. The first substrate may comprise subpixels, the color filter may comprise color filter areas respectively corresponding to the subpixels, and the color conversion layer may comprise color conversion areas respectively corresponding to the subpixels.

A pixel defining layer may be located between the subpixels to define each subpixel.

The color filter may further comprise color filter areas and light blocking patterns located between the color filter areas, and the color conversion layer may further comprise color conversion areas and light blocking patterns located between the color conversion areas.

The color filter areas (or the color conversion areas) may comprise a first area emitting first color light, a second area emitting second color light, and/or a third area emitting third color light, wherein the first color light, the second color light, and/or the third color light may have different maximum emission wavelengths from one another. For example, the first color light may be red light, the second color light may be green light, and the third color light may be blue light. In an embodiment, the color filter areas (or the color conversion areas) may comprise quantum dots. In an embodiment, the first area may comprise a red quantum dot, the second area may comprise a green quantum dot, and the third area may not comprise a quantum dot. The quantum dot may be a quantum dot as described herein. The first area, the second area, and/or the third area may each comprise a scatterer.

In an embodiment, the light-emitting device may emit first light, the first area may absorb the first light to emit first-first color light, the second area may absorb the first light to emit second-first color light, and the third area may absorb the first light to emit third-first color light. The first-first color light, the second-first color light, and the third-first color light may have different maximum emission wavelengths from one another. In an embodiment, the first light may be blue light, the first-first color light may be red light, the second-first color light may be green light, and the third-first color light may be blue light.

The electronic apparatus may further comprise a thin-film transistor, in addition to the light-emitting device as described above. The thin-film transistor may comprise a source electrode, a drain electrode, and an active layer, wherein any one of the source electrode and the drain electrode may be electrically connected to any one of the first electrode and the second electrode of the light-emitting device.

The thin-film transistor may further comprise a gate electrode, a gate insulating film, or the like.

The active layer may comprise crystalline silicon, amorphous silicon, an organic semiconductor, an oxide semiconductor, or the like.

The electronic apparatus may further comprise a sealing portion for sealing the light-emitting device. The sealing portion may be located between the color filter and/or the color conversion layer and the light-emitting device. The sealing portion may allow light from the light-emitting device to be extracted to the outside, and may prevent ambient air and/or moisture from penetrating into the light-emitting device. The sealing portion may be a sealing substrate that comprises a transparent glass substrate or a plastic substrate. The sealing portion may be a thin-film encapsulation layer that comprises one or more of an organic layer and/or an inorganic layer. When the sealing portion is a thin-film encapsulation layer, the electronic apparatus may be flexible.

Various functional layers may be further comprised on the sealing portion, in addition to the color filter and/or the color conversion layer, according to the use of the electronic apparatus. Examples of the functional layers are a touch screen layer, a polarizing layer, etc. The touch screen layer may be a pressure-sensitive touch screen layer, a capacitive touch screen layer, or an infrared touch screen layer. The authentication apparatus may be, for example, a biometric authentication apparatus that authenticates an individual by using biometric information of a living body (for example, fingertips, pupils, etc.).

The authentication apparatus may further comprise, in addition to the light-emitting device as described above, a biometric information collector.

The electronic apparatus may be applied to various displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, various measuring instruments, meters (for example, meters for a vehicle, an aircraft, and a vessel), projectors, and the like.

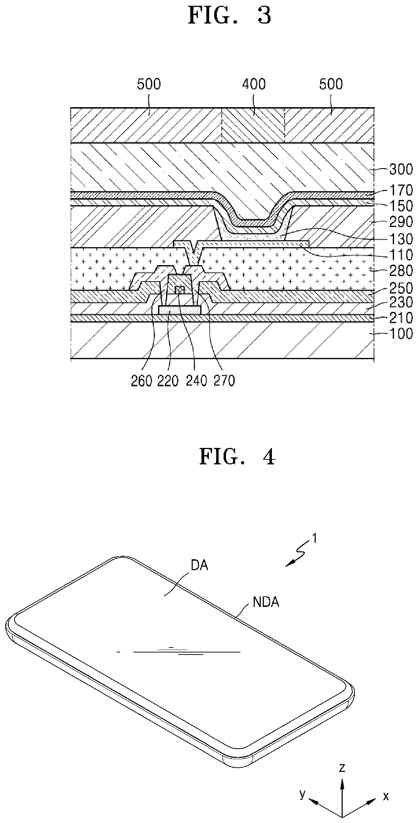

### [Descriptions of FIGS. 2 and 3]

FIG. 2 is a schematic cross-sectional view of an electronic apparatus according to an embodiment.

The electronic apparatus of FIG. 2 may comprise a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be located on the substrate 100. The buffer layer 210 may prevent penetration of impurities through the substrate 100 and may provide a flat surface on the substrate 100.

A TFT may be located on the buffer layer 210. The TFT may comprise an active layer 220, a gate electrode 240, a source electrode 260, and a drain electrode 270.

The active layer 220 may comprise an inorganic semiconductor such as silicon or polysilicon, an organic semiconductor, or an oxide semiconductor, and may comprise a source region, a drain region, and a channel region.

A gate insulating film 230 for insulating the active layer 220 from the gate electrode 240 may be located on the active layer 220, and the gate electrode 240 may be located on the gate insulating film 230.

An interlayer insulating film 250 may be located on the gate electrode 240. The interlayer insulating film 250 may be located between the gate electrode 240 and the source electrode 260 to insulate the gate electrode 240 from the source electrode 260 and between the gate electrode 240 and the drain electrode 270 to insulate the gate electrode 240 from the drain electrode 270.

The source electrode 260 and the drain electrode 270 may be located on the interlayer insulating film 250. The interlayer insulating film 250 and the gate insulating film 230 may be formed to expose the source region and the drain region of the active layer 220, and the source electrode 260 and the drain electrode 270 may respectively contact the exposed portions of the source region and the drain region of the active layer 220.

The TFT may be electrically connected to a light-emitting device to drive the light-emitting device, and may be covered and protected by a passivation layer 280. The passivation layer 280 may comprise an inorganic insulating film, an organic insulating film, or any combination thereof. A light-emitting device may be provided on the passivation layer 280. The light-emitting device may comprise a first electrode 110, an interlayer 130, and a second electrode 150.

The first electrode 110 may be located on the passivation layer 280. The passivation layer 280 may not completely cover the drain electrode 270 and may expose a portion of the drain electrode 270. The first electrode 110 may be electrically connected to the exposed portion of the drain electrode 270.

A pixel defining layer 290 comprising an insulating material may be located on the first electrode 110. The pixel defining layer 290 may expose a region of the first electrode 110, and an interlayer 130 may be formed on the exposed region of the first electrode 110. The pixel defining layer 290 may be a polyimide or polyacrylic organic film. Although not shown in FIG. 2, at least some layers of the interlayer 130 may extend beyond the upper portion of the pixel defining layer 290 to be provided in the form of a common layer.

The second electrode 150 may be located on the interlayer 130, and a capping layer 170 may be further comprised on the second electrode 150. The capping layer 170 may be formed to cover the second electrode 150.

The encapsulation portion 300 may be located on the capping layer 170. The encapsulation portion 300 may be located on a light-emitting device to protect the light-emitting device from moisture and/or oxygen. The encapsulation portion 300 may comprise: an inorganic film comprising silicon nitride (SiNₓ), silicon oxide (SiOₓ), indium tin oxide, indium zinc oxide, or any combination thereof; an organic film comprising polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, etc.), an epoxy-based resin (for example, aliphatic glycidyl ether (AGE), etc.), or any combination thereof; or any combination of the inorganic film and the organic film.

FIG. 3 is a schematic cross-sectional view of an electronic apparatus according to another embodiment.

The electronic apparatus of FIG. 3 may differ from the electronic apparatus of FIG. 2, at least in that a light blocking pattern 500 and a functional region 400 are further comprised on the encapsulation portion 300. The functional region 400 may be a color filter area, a color conversion area, or a combination of the color filter area and the color conversion area. According to an embodiment, the light-emitting device comprised in the electronic apparatus of FIG. 3 may be a tandem light-emitting device.

### [Description of FIG. 4]

FIG. 4 is a schematic perspective view of an electronic equipment 1 comprising a light-emitting device according to an embodiment.

The electronic equipment 1 may be an apparatus that displays a moving image or still image, and may not only be a portable electronic equipment, such as a mobile phone, a smart phone, a tablet personal computer (PC), a mobile communication terminal, an electronic notebook, an electronic book, a portable multimedia player (PMP), a navigation device, or a ultra mobile PC (UMPC) but may also be various products, such as a television, a laptop, a monitor, a billboard, an Internet of things (lOT) or the like, or a part thereof. In an embodiment, the electronic equipment 1 may be a wearable device, such as a smart watch, a watch phone, a glasses-type display, or a head mounted display (HMD), or a part of the wearable device. However, embodiments are not limited thereto.

Examples of the electronic equipment 1 may comprise a dashboard of a vehicle, a center fascia of a vehicle, a center information display arranged on a dashboard of a vehicle, a room mirror display that replaces a side mirror of a vehicle, an entertainment display for a rear seat of a vehicle or arranged on the back of a front seat, a head up display (HUD) installed in the front of a vehicle or projected on a front window glass, or a computer-generated hologram augmented-reality head up display (CGH AR HUD). FIG. 4 illustrates a case in which the electronic equipment 1 is a smartphone for convenience of explanation.

The electronic equipment 1 may comprise a display area DA and a non-display area NDA outside the display area DA. A display device may implement an image through a two-dimensional array of pixels that are arranged in the display area DA.

The non-display area NDA may be an area that does not display an image, and may surround the display area DA. A driver or the like for providing electrical signals or power to display devices arranged on the display area DA may be arranged in the non-display area NDA. A pad, which is an area to which an electronic element, a printing circuit board, or the like may be electrically connected, may be arranged in the non-display area NDA.

In the electronic equipment 1, a length in the x-axis direction and a length in the y-axis direction may be different from each other. For example, as shown in FIG. 4, a length in the x-axis direction may be shorter than a length in the y-axis direction. As another example, a length in the x-axis direction may be the same as a length in the y-axis direction. As another example, a length in the x-axis direction may be longer than a length in the y-axis direction.

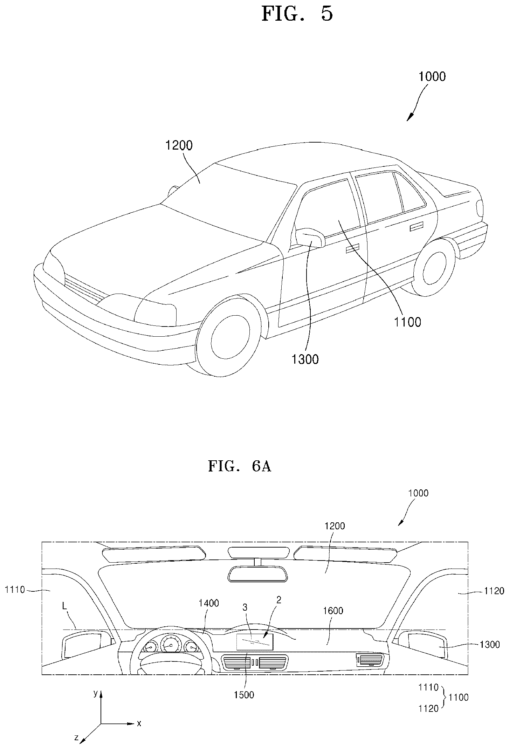

### [Descriptions of FIGS. 5 and 6A to 6C]

FIG. 5 is a schematic perspective view of an exterior of a vehicle 1000 as an electronic equipment comprising a light-emitting device according to an embodiment. FIGS. 6A to 6C are each a schematic diagram of an interior of a vehicle 1000 according to embodiments.

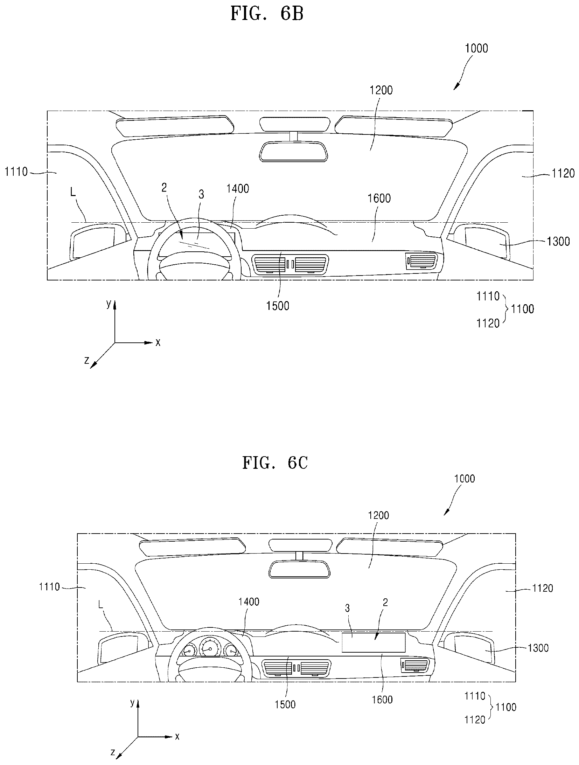

Referring to FIGS. 5, 6A, 6B, and 6C, the vehicle 1000 may comprise various apparatuses for moving a subject to be transported, such as a person, an object, an animal, or the like, from a departure point to a destination. The vehicle 1000 may comprise a vehicle traveling on a road or track, a vessel moving over a sea or river, an airplane flying in the sky using the action of air, and the like.

The vehicle 1000 may travel on a road or a track. The vehicle 1000 may move in a selectable direction according to the rotation of at least one wheel. Examples of the vehicle 1000 may comprise a three-wheeled or four-wheeled vehicle, a construction machine, a two-wheeled vehicle, a prime mover device, a bicycle, and a train running on a track.

The vehicle 1000 may comprise a body having an interior and an exterior, and a chassis that is a portion excluding the body in which mechanical apparatuses for driving are installed as other parts. The exterior of the vehicle body may comprise a front panel, a bonnet, a roof panel, a rear panel, a trunk, a pillar provided at a boundary between doors, and the like. The chassis of the vehicle 1000 may comprise a power generating device, a power transmitting device, a driving device, a steering device, a braking device, a suspension device, a transmission device, a fuel device, front and rear wheels, left and right wheels, and the like.

The vehicle 1000 may comprise a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a pillar arranged between the side window glass 1100 and the front window glass 1200.

The side window glass 1100 may be installed on a side of the vehicle 1000. In an embodiment, the side window glass 1100 may be installed on a door of the vehicle 1000. Multiple side window glasses 1100 may be provided and may face each other. In an embodiment, the side window glass 1100 may comprise a first side window glass 1110 and a second side window glass 1120. In an embodiment, the first side window glass 1110 may be arranged adjacent to the cluster 1400 and the second side window glass 1120 may be arranged adjacent to the passenger seat dashboard 1600.

In an embodiment, the side window glasses 1100 may be spaced apart from each other in the x-direction or the -x-direction. For example, the first side window glass 1110 and the second side window glass 1120 may be spaced apart from each other in the x direction or the -x direction. For example, a virtual straight line L connecting the side window glasses 1100 may extend in the x-direction or the -x-direction. For example, a virtual straight line L connecting the first side window glass 1110 and the second side window glass 1120 to each other may extend in the x direction or the -x direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In an embodiment, multiple side mirrors 1300 may be provided. Any one of the side mirrors 1300 may be arranged outside the first side window glass 1110 and another of the side mirrors 1300 may be arranged outside the second side window glass 1120.

The cluster 1400 may be arranged in front of the steering wheel. The cluster 1400 may comprise a tachometer, a speedometer, a coolant thermometer, a fuel gauge turn indicator, a high beam indicator, a warning light, a seat belt warning light, an odometer, an hodometer, an automatic shift selector indicator light, a door open warning light, an engine oil warning light, and/or a low fuel warning light.

The center fascia 1500 may comprise a control panel on which buttons for adjusting an audio device, an air conditioning device, and a seat heater are arranged. The center fascia 1500 may be arranged on one side of the cluster 1400.

A passenger seat dashboard 1600 may be spaced apart from the cluster 1400 with the center fascia 1500 arranged therebetween. In an embodiment, the cluster 1400 may be arranged to correspond to a driver seat (not shown), and the passenger seat dashboard 1600 may be disposed to correspond to a passenger seat (not shown). In an embodiment, the cluster 1400 may be adjacent to the first side window glass 1110, and the passenger seat dashboard 1600 may be adjacent to the second side window glass 1120.

In an embodiment, the display device 2 may comprise a display panel 3, and the display panel 3 may display an image. The display device 2 may be arranged inside the vehicle 1000. In an embodiment, the display device 2 may be arranged between the side window glasses 1100 facing each other. The display device 2 may be arranged on at least one of the cluster 1400, the center fascia 1500, and the passenger seat dashboard 1600.

The display device 2 may comprise an organic light-emitting display device, an inorganic electroluminescent (EL) display device, a quantum dot display device, etc. Hereinafter, as the display device 2 according to an embodiment, an organic light-emitting display device comprising the light-emitting device according to the disclosure will be described as an example. However, various types of display devices as described above may be used in embodiments.

Referring to FIG. 6A, the display device 2 may be arranged on the center fascia 1500. In an embodiment, the display device 2 may display navigation information. In an embodiment, the display device 2 may display information regarding audio settings, video settings, or vehicle settings.

Referring to FIG. 6B, the display device 2 may be arranged on the cluster 1400. When the display device 2 is arranged on the cluster 1400, the cluster 1400 may display driving information and the like through the display device 2. For example, the cluster 1400 may digitally implement driving information. The digital cluster 1400 may display vehicle information and driving information as images. For example, a needle and a gauge of a tachometer and various warning light icons may be displayed by a digital signal.

Referring to FIG. 6C, the display device 2 may be arranged on the passenger seat dashboard 1600. The display device 2 may be embedded in the passenger seat dashboard 1600 or arranged on the passenger seat dashboard 1600. In an embodiment, the display device 2 arranged on the passenger seat dashboard 1600 may display an image related to information displayed on the cluster 1400 and/or information displayed on the center fascia 1500. In another embodiment, the display device 2 arranged on the passenger seat dashboard 1600 may display information that is different from information displayed on the cluster 1400 and/or information displayed on the center fascia 1500.

### [Manufacturing method]

Respective layers comprised in the hole transport region, the emission layer, and respective layers comprised in the electron transport region may be formed in a selected region by using various methods, such as vacuum deposition, spin coating, casting, Langmuir-Blodgett (LB) deposition, ink-jet printing, laser-printing, laser-induced thermal imaging (LITI), etc.

When the respective layers comprised in the hole transport region, the emission layer, and the respective layers comprised in the electron transport region are formed by vacuum deposition, the deposition may be performed at a deposition temperature in a range of about 100 °C to about 500 °C, a vacuum degree in a range of about 10⁻⁸ torr to about 10⁻³ torr, and a deposition rate in a range of about 0.01 Å/sec to about 100 Å/sec, depending on a material to be comprised in a layer to be formed and the structure of a layer to be formed.

### [Definitions of Terms]

The term "C₃-C₆₀ carbocyclic group" as used herein may be a cyclic group consisting of only carbon atoms as ring-forming atoms and having 3 to 60 carbon atoms, and the term "C₁-C₆₀ heterocyclic group" as used herein may be a cyclic group that has 1 to 60 carbon atoms and further comprises, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. In an embodiment, a C₁-C₆₀ heterocyclic group may have 3 to 61 ring-forming atoms.

The term "cyclic group" as used herein may be a C₃-C₆₀ carbocyclic group or a C₁-C₆₀ heterocyclic group.

The term "π electron-rich C₃-C₆₀ cyclic group" as used herein may be a cyclic group that has 3 to 60 carbon atoms and may not comprise *-N=*' as a ring-forming moiety, and the term "π electron-deficient nitrogen-containing C₁-C₆₀ cyclic group" as used herein may be a heterocyclic group that has 1 to 60 carbon atoms and may comprise *-N=*' as a ring-forming moiety.

In an embodiment,
a C₃-C₆₀ carbocyclic group may be a T1 group or a group in which two or more T1 groups are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
a C₁-C₆₀ heterocyclic group may be a T2 group, a group in which two or more T2 groups are condensed with each other, or a group in which one or more T2 groups and one or more T1 groups are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
a π electron-rich C₃-C₆₀ cyclic group may be a T1 group, a group in which two or more T1 groups are condensed with each other, a T3 group, a group in which two or more T3 groups are condensed with each other, or a group in which one or more T3 groups and one or more T1 groups are condensed with each other (for example, a C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
a π electron-deficient nitrogen-containing C₁-C₆₀ cyclic group may be a T4 group, a group in which two or more T4 groups are condensed with each other, a group in which one or more T4 groups and one or more T1 groups are condensed with each other, a group in which one or more T4 groups and one or more T3 groups are condensed with each other, or a group in which one or more T4 groups, one or more T1 groups, and one or more T3 groups are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
wherein the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
the T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
the T3 group may be a furan group, a thiophene group, a 1H-pyrrole group, a silole group, or a borole group, and
the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "cyclic group", "C₃-C₆₀ carbocyclic group", "C₁-C₆₀ heterocyclic group", "π electron-rich C₃-C₆₀ cyclic group", or "π electron-deficient nitrogen-containing C₁-C₆₀ cyclic group" as used herein may each be a group condensed to any cyclic group, a monovalent group, or a polyvalent group (for example, a divalent group, a trivalent group, a tetravalent group, etc.) according to the structure of a formula for which the corresponding term is used. For example, the "benzene group" may be a benzo group, a phenyl group, a phenylene group, etc., which may be readily understood by one of ordinary skill in the art according to the structure of a formula comprising the "benzene group."

Examples of a monovalent C₃-C₆₀ carbocyclic group or a monovalent C₁-C₆₀ heterocyclic group may comprise a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of a divalent C₃-C₆₀ carbocyclic group or a divalent C₁-C₆₀ heterocyclic group may comprise a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a divalent non-aromatic condensed heteropolycyclic group.

The term "C₁-C₆₀ alkyl group" as used herein may be a linear or branched aliphatic hydrocarbon monovalent group that has 1 to 60 carbon atoms, and examples thereof may comprise a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, etc. The term "C₁-C₆₀ alkylene group" as used herein may be a divalent group having a same structure as the C₁-C₆₀ alkyl group.

The term "C₂-C₆₀ alkenyl group" as used herein may be a monovalent hydrocarbon group having one or more carbon-carbon double bonds in the middle or at a terminus of the C₂-C₆₀ alkyl group, and examples thereof may comprise an ethenyl group, a propenyl group, a butenyl group, etc. The term "C₂-C₆₀ alkenylene group" as used herein may be a divalent group having a same structure as the C₂-C₆₀ alkenyl group.

The term "C₂-C₆₀ alkynyl group" as used herein may be a monovalent hydrocarbon group having one or more carbon-carbon triple bonds in the middle or at a terminus of the C₂-C₆₀ alkyl group, and examples thereof may comprise an ethynyl group, a propynyl group, etc. The term "C₂-C₆₀ alkynylene group" as used herein may be a divalent group having a same structure as the C₂-C₆₀ alkynyl group.

The term "C₁-C₆₀ alkoxy group" as used herein may be a monovalent group represented by -O(A₁₀₁) (wherein A₁₀₁ may be a C₁-C₆₀ alkyl group), and examples thereof may comprise a methoxy group, an ethoxy group, an isopropyloxy group, etc.

The term "C₃-C₁₀ cycloalkyl group" as used herein may be a monovalent saturated hydrocarbon cyclic group having 3 to 10 carbon atoms, and examples thereof may comprise a cyclopropyl group, a cyclobutyl group, a cyclopentyl group, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, a bicyclo[2.2.2]octyl group, etc. The term "C₃-C₁₀ cycloalkylene group" as used herein may be a divalent group having a same structure as the C₃-C₁₀ cycloalkyl group.

The term "C₁-C₁₀ heterocycloalkyl group" as used herein may be a monovalent cyclic group of 1 to 10 carbon atoms, further comprising, in addition to carbon atoms, at least one heteroatom, as ring-forming atoms, and examples thereof may comprise a 1,2,3,4-oxatriazolidinyl group, a tetrahydrofuranyl group, a tetrahydrothiophenyl group, etc. The term "C₁-C₁₀ heterocycloalkylene group" as used herein may be a divalent group having a same structure as the C₁-C₁₀ heterocycloalkyl group.

The term "C₃-C₁₀ cycloalkenyl group" as used herein may be a monovalent cyclic group that has 3 to 10 carbon atoms and at least one carbon-carbon double bond in the ring thereof and no aromaticity, and examples thereof may comprise a cyclopentenyl group, a cyclohexenyl group, a cycloheptenyl group, etc. The term "C₃-C₁₀ cycloalkenylene group" as used herein may be a divalent group having a same structure as the C₃-C₁₀ cycloalkenyl group.

The term "C₁-C₁₀ heterocycloalkenyl group" as used herein may be a monovalent cyclic group of 1 to 10 carbon atoms, further comprising, in addition to carbon atoms, at least one heteroatom, as ring-forming atoms, and having at least one carbon-carbon double bond in the cyclic structure thereof. Examples of a C₁-C₁₀ heterocycloalkenyl group may comprise a 4,5-dihydro-1,2,3,4-oxatriazolyl group, a 2,3-dihydrofuranyl group, a 2,3-dihydrothiophenyl group, etc. The term "C₁-C₁₀ heterocycloalkenylene group" as used herein may be a divalent group having a same structure as the C₁-C₁₀ heterocycloalkenyl group.

The term "C₆-C₆₀ aryl group" as used herein may be a monovalent group having a carbocyclic aromatic system of 6 to 60 carbon atoms, and the term "C₆-C₆₀ arylene group" as used herein may be a divalent group having a carbocyclic aromatic system of 6 to 60 carbon atoms. Examples of a C₆-C₆₀ aryl group may comprise a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, etc. When the C₆-C₆₀ aryl group and the C₆-C₆₀ arylene group each comprise two or more rings, the respective rings may be condensed with each other.

The term "C₁-C₆₀ heteroaryl group" as used herein may be a monovalent group having a heterocyclic aromatic system of 1 to 60 carbon atoms, further comprising, in addition to carbon atoms, at least one heteroatom, as ring-forming atoms. The term "C₁-C₆₀ heteroarylene group" as used herein may be a divalent group having a heterocyclic aromatic system of 1 to 60 carbon atoms, further comprising, in addition to carbon atoms, at least one heteroatom, as ring-forming atoms. Examples of a C₁-C₆₀ heteroaryl group may comprise a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, a naphthyridinyl group, etc. When the C₁-C₆₀ heteroaryl group and the C₁-C₆₀ heteroarylene group each comprise two or more rings, the respective rings may be condensed with each other.

The term "monovalent non-aromatic condensed polycyclic group" as used herein may be a monovalent group (for example, having 8 to 60 carbon atoms) having two or more rings condensed to each other, only carbon atoms as ring-forming atoms, and no aromaticity in its entire molecular structure. Examples of a monovalent non-aromatic condensed polycyclic group may comprise an indenyl group, a fluorenyl group, a spiro-bifluorenyl group, a benzofluorenyl group, an indenophenanthrenyl group, an indeno anthracenyl group, etc. The term "divalent non-aromatic condensed polycyclic group" as used herein may be a divalent group having a same structure as the monovalent non-aromatic condensed polycyclic group.

The term "monovalent non-aromatic condensed heteropolycyclic group" as used herein may be a monovalent group (for example, having 1 to 60 carbon atoms) having two or more rings condensed to each other, further comprising, in addition to carbon atoms, at least one heteroatom, as ring-forming atoms, and having no aromaticity in its entire molecular structure. Examples of a monovalent non-aromatic condensed heteropolycyclic group may comprise a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, a benzothienodibenzothiophenyl group, etc. The term "divalent non-aromatic condensed heteropolycyclic group" as used herein may be a divalent group having a same structure as the monovalent non-aromatic condensed heteropolycyclic group.

The term "C₆-C₆₀ aryloxy group" as used herein may be a group represented by -O(A₁₀₂) (wherein A₁₀₂ may be a C₆-C₆₀ aryl group), and the term "C₆-C₆₀ arylthio group" as used herein may be a group represented by -S(A₁₀₃) (wherein A₁₀₃ may be a C₆-C₆₀ aryl group).

The term "C₇-C₆₀ arylalkyl group" used herein may be a group represented by - (A₁₀₄)(A₁₀₅) (where A₁₀₄ may be a C₁-C₅₄ alkylene group, and A₁₀₅ may be a C₆-C₅₉ aryl group), and the term C₂-C₆₀ heteroarylalkyl group" used herein may be a group represented by - (A₁₀₆)(A₁₀₇) (where A₁₀₆ may be a C₁-C₅₉ alkylene group, and A₁₀₇ may be a C₁-C₅₉ heteroaryl group).

In the specification, the group "R₁₀ₐ" may be:
deuterium, -F, -Cl, -Br, -I, a hydroxyl group, a cyano group, a nitro group, amidino group, hydrazine group, or hydrazine group;
a C₁-C₆₀ alkyl group, a C₂-C₆₀ alkenyl group, a C₂-C₆₀ alkynyl group, C₁-C₆₀ alkoxy group, or a C₁-C₆₀ alkylthio group, each unsubstituted or substituted with deuterium, -F, -Cl, - Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, C₁-C₆₀ alkylthio group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -Ge(Q₃₁)(Q₃₂)(Q₃₃), -N(Q₃₁)(Q₃₂), -B(Q₃₁)(Q₃₂), -P(Q₃₁)(Q₃₂), -O(Q₃₁), -S(Q₃₁), -C(=O)(Q₃₁), -S(=O)₂(Q₃₁), or -P(=O)(Q₃₁)(Q₃₂).

In the specification, the groups Q₁ to Q₃, Q₁₁ to Q₁₃, Q₂₁ to Q₂₃, and Q₃₁ to Q₃₃ as used herein may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or any combination thereof.

The term "heteroatom" as used herein may be any atom other than a carbon atom or a hydrogen atom. Examples of a heteroatom may comprise B, O, S, N, P, Si, B, Ge, Se, or any combination thereof.

The term "transition metals" as used herein may comprise hafnium (Hf), tantalum (Ta), tungsten (W), rhenium (Re), osmium (Os), iridium (Ir), platinum (Pt), gold (Au), and the like.

In the specification, the term "Ph" refers to a phenyl group, the term "Me" refers to a methyl group, the term "Et" refers to an ethyl group, the terms "tert-Bu" or "Bu^{t}" each refer to a tert-butyl group, and the term "OMe" refers to a methoxy group.

The term "biphenyl group" as used herein may be "a phenyl group substituted with a phenyl group." For example, the "biphenyl group" may be a substituted phenyl group having a C₆-C₆₀ aryl group as a substituent.

The term "terphenyl group" as used herein may be "a phenyl group substituted with a biphenyl group". For example, the "terphenyl group" may be a substituted phenyl group having, as a substituent, a C₆-C₆₀ aryl group substituted with a C₆-C₆₀ aryl group.

The symbols *, *', and *" as used herein, unless otherwise defined, each refer to a binding site to a neighboring atom in the corresponding formula or moiety.

Hereinafter, compounds according to embodiments and light-emitting devices according to embodiments will be described in detail with reference to the following Synthesis Examples and Examples. The wording "B was used instead of A" used in describing Synthesis Examples refers to that an identical molar equivalent of B was used in place of A.

### [Synthesis Examples and Examples]

### Synthesis Example 1. Synthesis of Compound 1

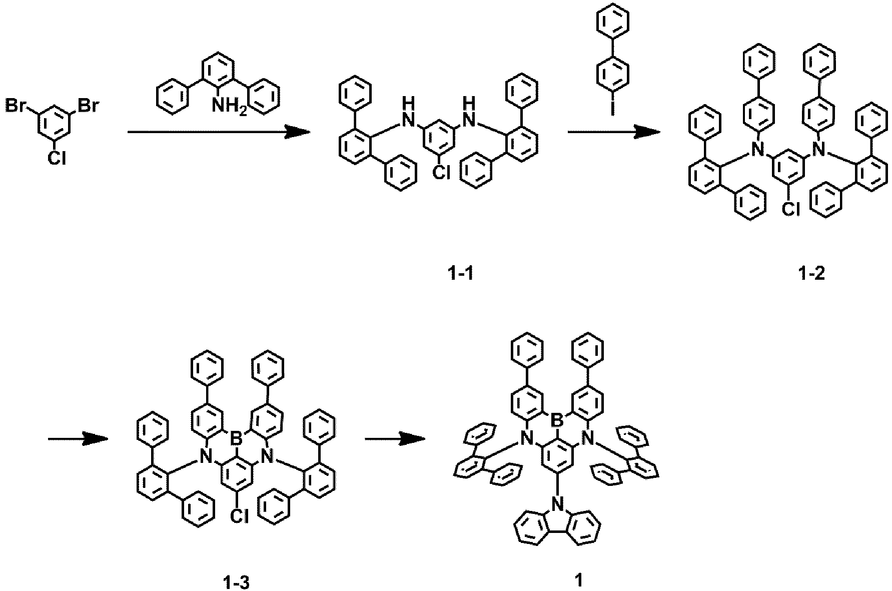

### Synthesis of Intermediate 1-1

1,3-dibromo-5-chlorobenzene (1 eq), [1,1':3',1"-terphenyl]-2'-amine (2 eq), tris(dibenzylideneacetone)dipalladium(0) (0.05 eq), tri-tert-butylphosphine (0.1 eq), and sodium tert-butoxide (3 eq) were dissolved in toluene and stirred at 110 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 1-1. (Yield: 82 %)

### Synthesis of Intermediate 1-2

Intermediate 1-1 (1 eq), 4-iodo-1,1'-biphenyl (2 eq), tris(dibenzylideneacetone)dipalladium(0) (0.25 eq), tri-tert-butylphosphine (0.5 eq), and sodium tert-butoxide (3 eq) were dissolved in o-xylene and stirred at 150 °C for 60 hours. After cooling and washing with ethyl acetate and water three times, the organic layer was separated therefrom, and dried over MgSO₄ under reduced pressure. The resulting product was purified by column chromatography with MC and n-hexane to obtain Intermediate 1-2. (Yield: 31 %)

### Synthesis of Intermediate 1-3

Intermediate 1-2 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly dropwise added into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Intermediate 1-3. (Yield: 3 %)

### Synthesis of Compound 1

Intermediate 1-3 (1 eq), carbazole (1.5 eq), tris(dibenzylideneacetone)dipalladium(0) (0.05 eq), tri-tert-butylphosphine (0.1 eq), and sodium tert-butoxide (3 eq) were dissolved in o-xylene and stirred at 150 °C for 36 hours. After cooling and washing with ethyl acetate and water three times, the organic layer was separated therefrom, and dried over MgSO₄ under reduced pressure. The resulting product was purified by column chromatography with MC and n-hexane to obtain Compound 1. (Yield: 62 %)

### Synthesis Example 2. Synthesis of Compound 2

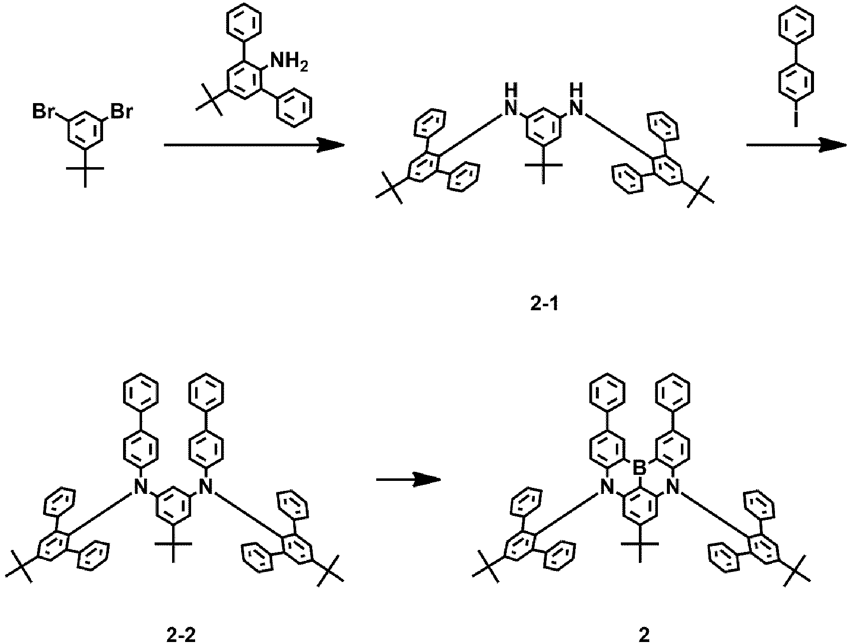

### Synthesis of Intermediate 2-1

1,3-dibromo-5-(tert-butyl)benzene (1 eq), 5'-(tert-butyl)-[1,1':3',1"-terphenyl]-2'-amine (2 eq), tris(dibenzylideneacetone)dipalladium(0) (0.05 eq), tri-tert-butylphosphine (0.1 eq), and sodium tert-butoxide (3 eq) were dissolved in toluene and stirred at 110 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 2-1. (Yield: 71 %)

### Synthesis of Intermediate 2-2

Intermediate 2-1 (1 eq), 4-iodo-1,1'-biphenyl (4 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 2-2. (Yield: 33 %)

### Synthesis of Compound 2

Intermediate 2-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 2. (Yield: 4 %)

### Synthesis Example 3. Synthesis of Compound 3

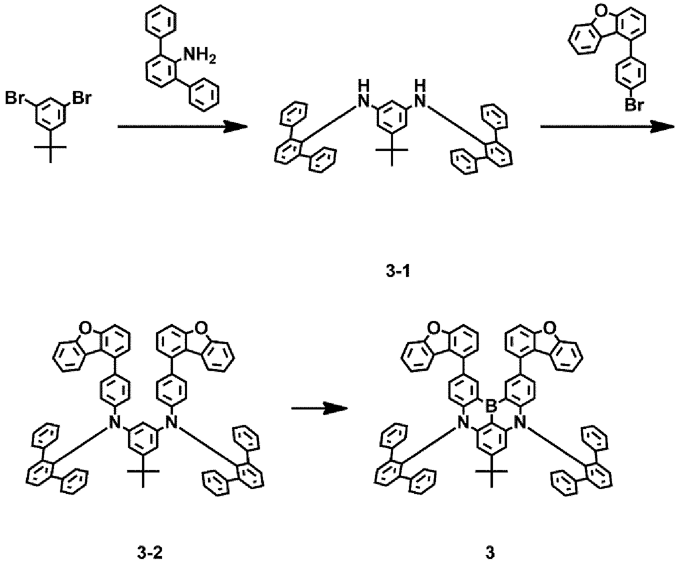

### Synthesis of Intermediate 3-1

1,3-dibromo-5-(tert-butyl)benzene (1 eq), [1,1':3',1"-terphenyl]-2'-amine (2 eq), tris(dibenzylideneacetone)dipalladium(0) (0.05 eq), tri-tert-butylphosphine (0.1 eq), and sodium tert-butoxide (3 eq) were dissolved in toluene and stirred at 110 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 3-1. (Yield: 68 %)

### Synthesis of Intermediate 3-2

Intermediate 3-1 (1 eq), 1-(4-bromophenyl)dibenzo[b,d]furan (4 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 3-2. (Yield: 27 %)

### Synthesis of Compound 3

Intermediate 3-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 3. (Yield: 3 %)

### Synthesis Example 4. Synthesis of Compound 4

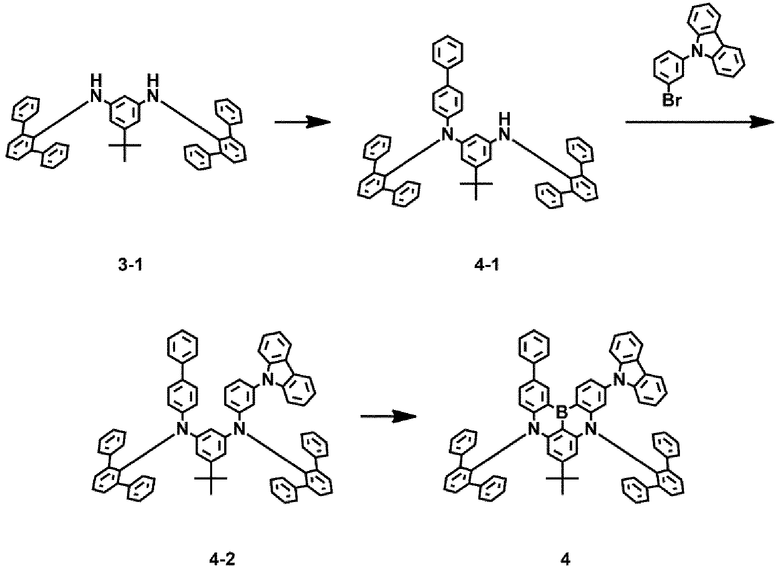

### Synthesis of Intermediate 4-1

Intermediate 3-1 (1 eq), 4-iodo-1,1'-biphenyl (1 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 4-1. (Yield: 30 %)

### Synthesis of Intermediate 4-2

Intermediate 4-1 (1 eq), 9-(3-bromophenyl)-9H-carbazole (2 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 4-2. (Yield: 44 %)

### Synthesis of Compound 4

Intermediate 4-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 4. (Yield: 3 %)

### Synthesis Example 5. Synthesis of Compound 5

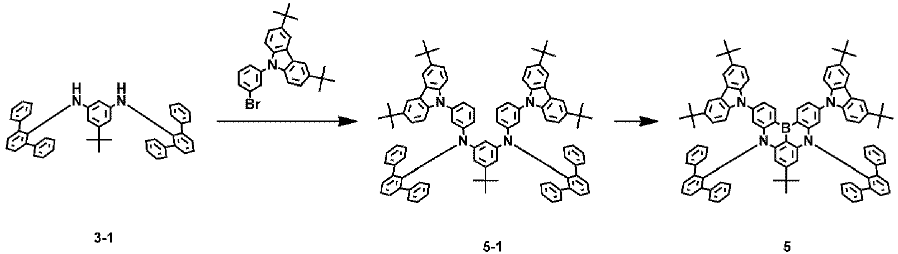

### Synthesis of Intermediate 5-1

Intermediate 3-1 (1 eq), 9-(3-bromophenyl)-3,6-di-tert-butyl-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 5-1. (Yield: 43 %)

### Synthesis of Compound 5

Intermediate 5-1 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 5. (Yield: 6 %)

### Synthesis Example 6. Synthesis of Compound 6

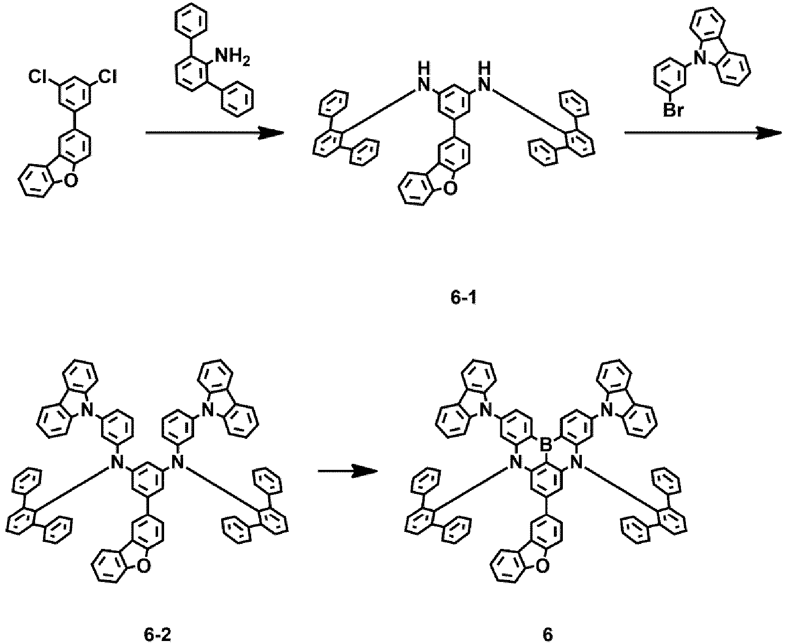

### Synthesis of Intermediate 6-1

2-(3,5-dichlorophenyl)dibenzo[b,d]furan (1 eq), [1,1':3',1"-terphenyl]-2'-amine (2 eq), tris(dibenzylideneacetone)dipalladium(0) (0.05 eq), tri-tert-butylphosphine (0.1 eq), and sodium tert-butoxide (3 eq) were dissolved in o-xylene and stirred at 140 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 6-1. (Yield: 80 %)

### Synthesis of Intermediate 6-2

Intermediate 6-1 (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (4 eq) was dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 6-2. (Yield: 37 %)

### Synthesis of Compound 6

Intermediate 6-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 6. (Yield: 5 %)

### Synthesis Example 7. Synthesis of Compound 7

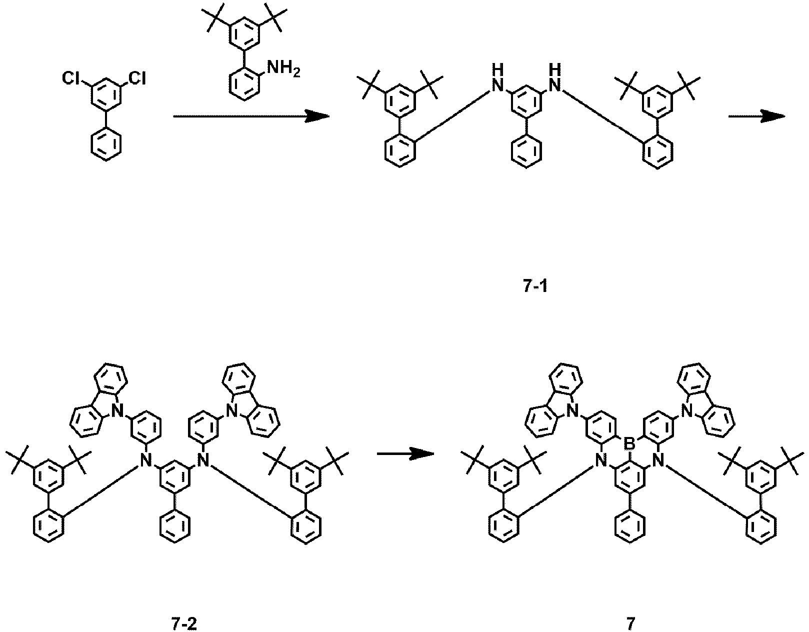

### Synthesis of Intermediate 7-1

3,5-dichloro-1,1'-biphenyl (1 eq), 3',5'-di-tert-butyl-[1,1'-biphenyl]-2-amine (2.2 eq), tris(dibenzylideneacetone)dipalladium (0) (0.05 eq), tri-tert-butylphosphine (0.1 eq), and sodium tert-butoxide (3 eq) were dissolved in toluene and stirred at 100 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 7-1. (Yield: 84 %)

### Synthesis of Intermediate 7-2

Intermediate 7-1 (1 eq), 9-(3-bromophenyl)-9H-carbazole (2.2 eq), tris(dibenzylideneacetone)dipalladium(0) (0.05 eq), tri-tert-butylphosphine (0.1 eq), and sodium tert-butoxide (3 eq) were dissolved in toluene and stirred at 110 °C for 24 hours. After cooling and washing with ethyl acetate and water three times, the organic layer was separated therefrom, and dried over MgSO₄ under reduced pressure. The resulting product was purified by column chromatography with MC and n-hexane to obtain Intermediate 7-2. (Yield: 64 %)

### Synthesis of Compound 7

Intermediate 7-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 7. (Yield: 6 %)

### Synthesis Example 8. Synthesis of Compound 8

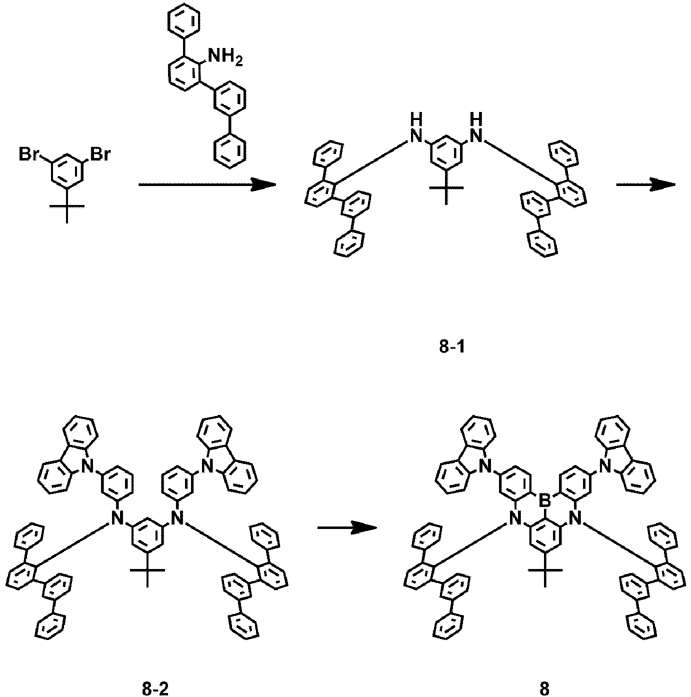

### Synthesis of Intermediate 8-1

1,3-dibromo-5-(tert-butyl)benzene (1 eq), [1,1':3',1":3",1‴-quaterphenyl]-2'-amine (2 eq), tris(dibenzylideneacetone)dipalladium(0) (0.1 eq), tri-tert-butylphosphine (0.2 eq), and sodium tert-butoxide (3 eq) were dissolved in toluene and stirred at 110 °C for 24 hours. After cooling and washing with ethyl acetate and water three times, the organic layer was separated therefrom, and dried over MgSO₄ under reduced pressure. The resulting product was purified by column chromatography with MC and n-hexane to obtain Intermediate 8-1. (Yield: 69 %)

### Synthesis of Intermediate 8-2

Intermediate 8-1 (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 8-2. (Yield: 35 %)

### Synthesis of Compound 8

Intermediate 8-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 8. (Yield: 4 %)

### Synthesis Example 9. Synthesis of Compound 9

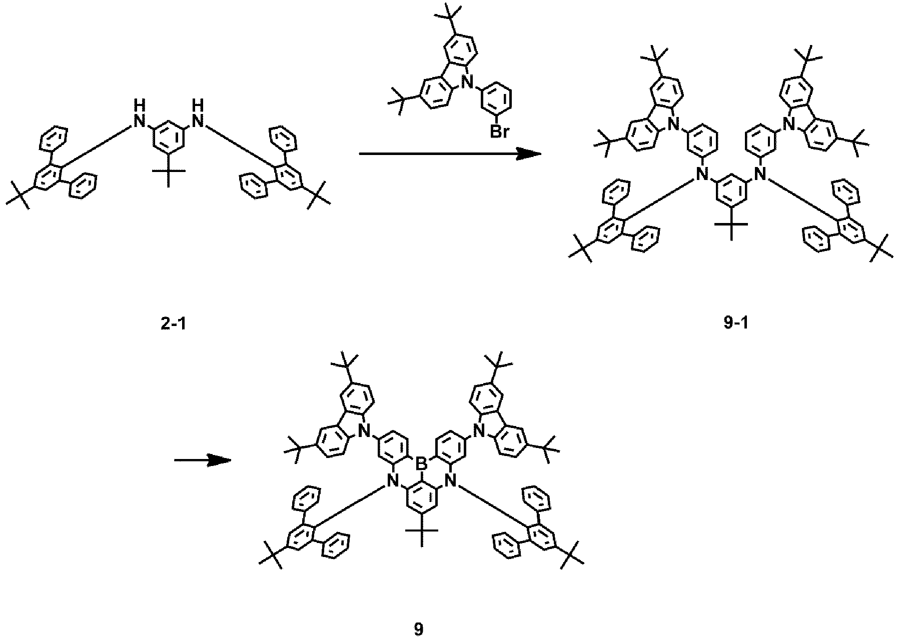

### Synthesis of Intermediate 9-1

Intermediate 2-1 (1 eq), 9-(3-bromophenyl)-3,6-di-tert-butyl-9H-carbazole (1 eq), tris(dibenzylideneacetone)dipalladium(0) (0.15 eq), tri-tert-butylphosphine (0.3 eq), and sodium tert-butoxide (4 eq) were dissolved in toluene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 9-1. (Yield: 31 %)

### Synthesis of Compound 9

Intermediate 9-1 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 9. (Yield: 4 %)

### Synthesis Example 10. Synthesis of Compound 10

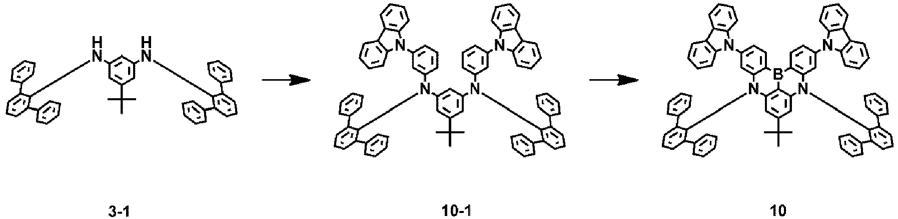

### Synthesis of Intermediate 10-1

Intermediate 3-1 (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 10-1. (Yield: 32 %)

### Synthesis of Compound 10

Intermediate 10-1 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 10. (Yield: 5 %)

### Synthesis Example 11. Synthesis of Compound 11

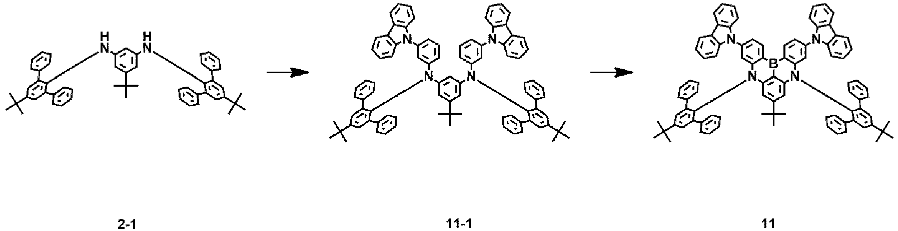

### Synthesis of Intermediate 11-1

Intermediate 2-1 (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 11-1. (Yield: 27 %)

### Synthesis of Compound 11

Intermediate 11-1 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 11. (Yield: 7 %)

### Synthesis Example 12. Synthesis of Compound 12

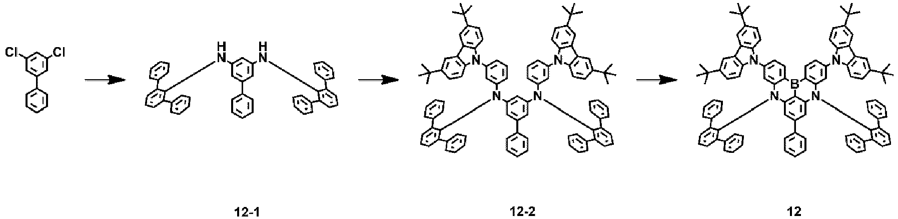

### Synthesis of Intermediate 12-1

3,5-dichloro-1,1'-biphenyl (1 eq), [1,1':3',1"-terphenyl]-2'-amine (2 eq), tris(dibenzylideneacetone)dipalladium(0) (0.05 eq), tri-tert-butylphosphine (0.1 eq), and sodium tert-butoxide (3 eq) were dissolved in o-xylene and stirred at 140 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 12-1. (Yield: 62 %)

### Synthesis of Intermediate 12-2

Intermediate 12-1 (1 eq), 9-(3-bromophenyl)-3,6-di-tert-butyl-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 12-2. (Yield: 41 %)

### Synthesis of Compound 12

Intermediate 12-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 12. (Yield: 4 %)

### Synthesis Example 13. Synthesis of Compound 13

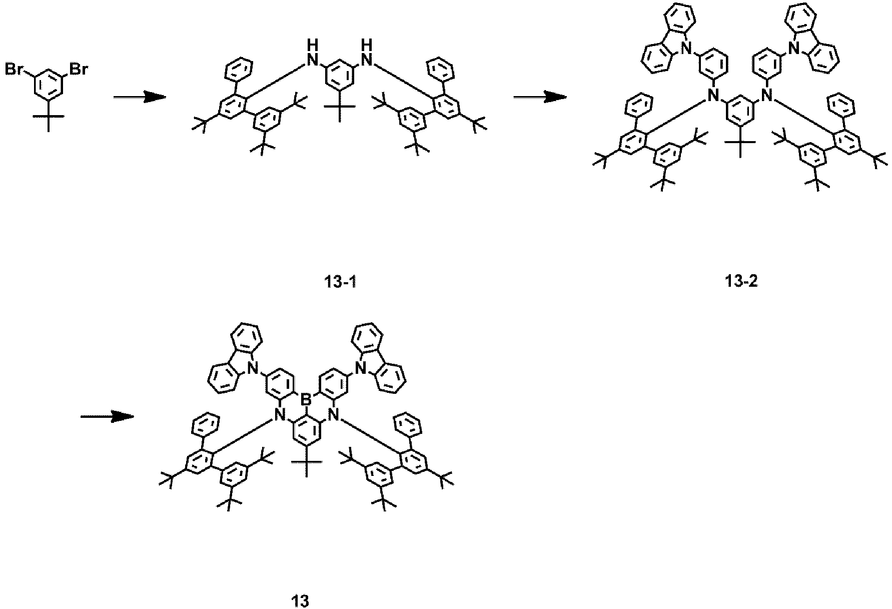

### Synthesis of Intermediate 13-1

1,3-dibromo-5-(tert-butyl)benzene (1 eq), 3,5,5'-tri-tert-butyl-[1,1':3',1"-terphenyl]-2'-amine (2 eq), tris(dibenzylideneacetone)dipalladium(0) (0.15 eq), tri-tert-butylphosphine (0.3 eq), and sodium tert-butoxide (3 eq) were dissolved in o-xylene and stirred at 140 °C for 12 hours. After cooling and washing with ethyl acetate and water three times, the organic layer was separated therefrom, and dried over MgSO₄ under reduced pressure. Intermediate 13-1. (Yield: 53 %)

### Synthesis of Intermediate 13-2

Intermediate 13-1 (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 13-2. (Yield: 35 %)

### Synthesis of Compound 13

Intermediate 13-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 13. (yield: 2 %)

### Synthesis Example 14. Synthesis of Compound 14

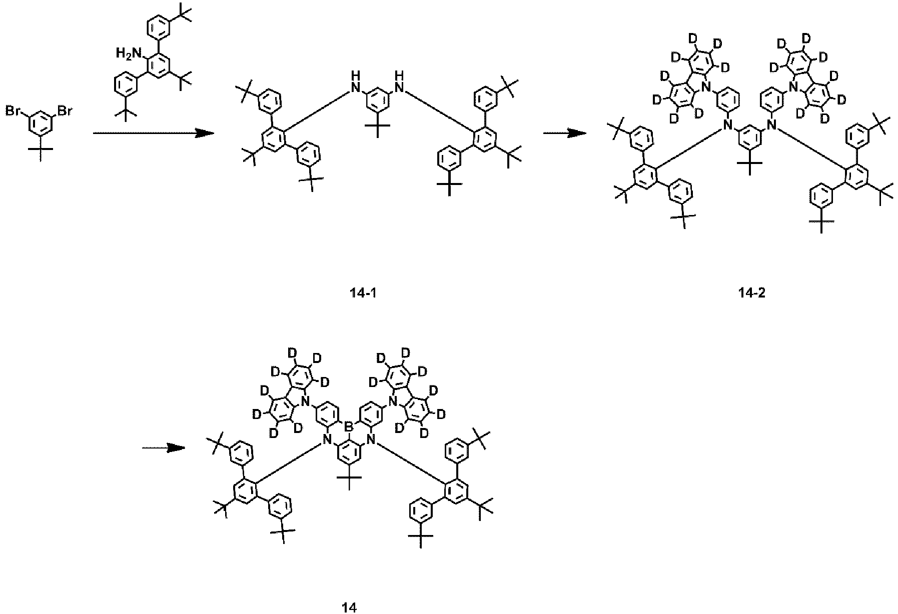

### Synthesis of Intermediate 14-1

1,3-dibromo-5-(tert-butyl)benzene (1 eq), 3,3",5'-tri-tert-butyl-[1,1':3',1"-terphenyl]-2'-amine (2 eq), tris(dibenzylideneacetone)dipalladium(0) (0.15 eq), tri-tert-butylphosphine (0.3 eq), and sodium tert-butoxide (5 eq) were dissolved in o-xylene and stirred at 140 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 14-1. (Yield: 48 %)

### Synthesis of Intermediate 14-2

Intermediate 14-1 (1 eq), 9-(3-bromophenyl)-9H-carbazole-D8 (4 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 14-2. (Yield: 27 %)

### Synthesis of Compound 14

Intermediate 14-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 14. (Yield: 2 %)

### Synthesis Example 15. Synthesis of Compound 15

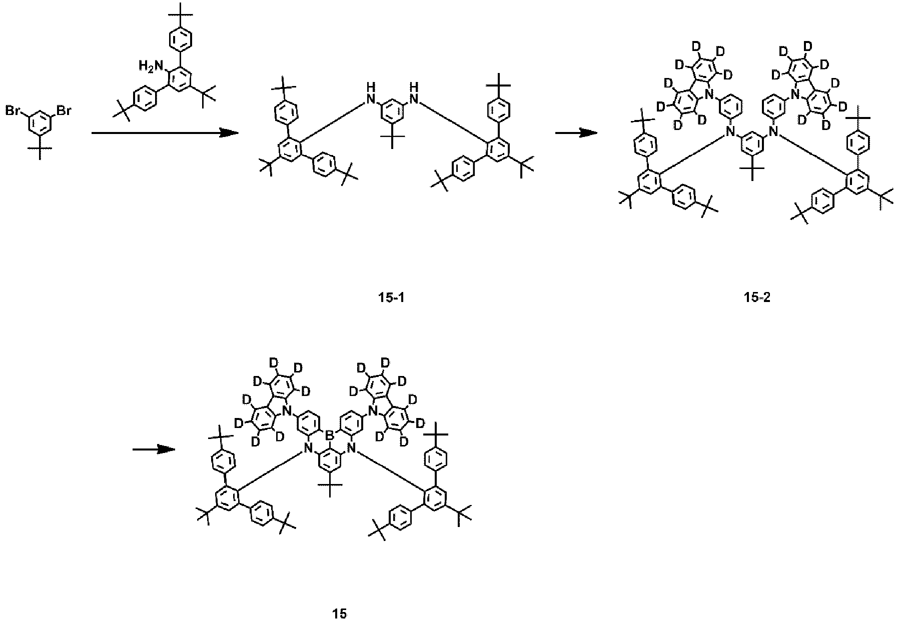

### Synthesis of Intermediate 15-1

1,3-dibromo-5-(tert-butyl)benzene (1 eq), 4,4",5'-tri-tert-butyl-[1,1':3',1"-terphenyl]-2'-amine (2 eq), tris(dibenzylideneacetone)dipalladium(0) (0.15 eq), tri-tert-butylphosphine (0.3 eq), and sodium tert-butoxide (5 eq) were dissolved in o-xylene and stirred at 140 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 15-1. (Yield: 42 %)

### Synthesis of Intermediate 15-2

Intermediate 15-1 (1 eq), 9-(3-bromophenyl)-9H-carbazole-D8 (4 eq), tris(dibenzylideneacetone)dipalladium(0) (0.15 eq), tri-tert-butylphosphine (0.3 eq), and sodium tert-butoxide (4 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 15-2. (Yield: 31 %)

### Synthesis of Compound 15

Intermediate 15-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 15. (Yield: 2 %)

### Synthesis Example 16. Synthesis of Compound 16

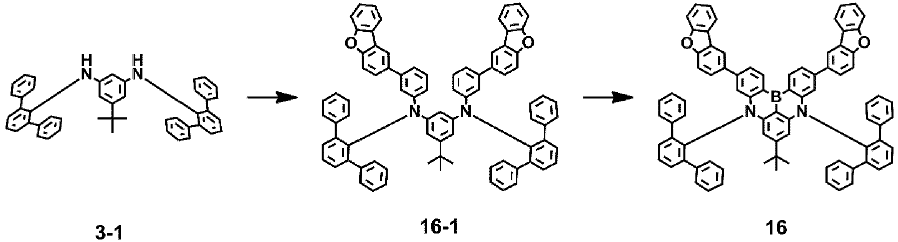

### Synthesis of Intermediate 16-1

Intermediate 3-1 (1 eq), 2-(3-bromophenyl)dibenzo[b,d]furan (4 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 24 hours. After cooling and washing with ethyl acetate and water three times, the organic layer was separated therefrom, and dried over MgSO₄ under reduced pressure. The resulting product was purified by column chromatography with MC and n-hexane to obtain Intermediate 16-1. (Yield: 41 %)

### Synthesis of Compound 16

Intermediate 16-1 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 16. (Yield: 13 %)

### Synthesis Example 17. Synthesis of Compound 17

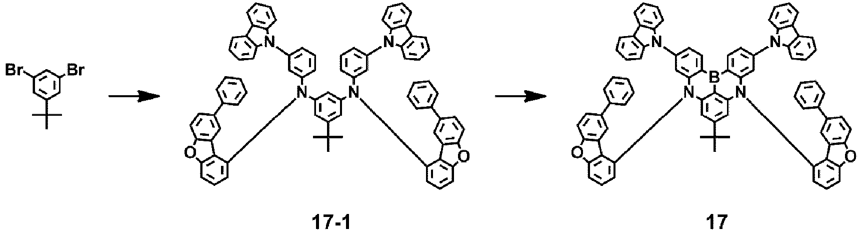

### Synthesis of Intermediate 17-1

1,3-dibromo-5-(tert-butyl)benzene (1 eq), N-(3-(9H-carbazol-9-yl)phenyl)-8-phenyldibenzo[b,d]furan-1-amine(2.2 eq), tris(dibenzylideneacetone)dipalladium(0) (0.05 eq), tri-tert-butylphosphine (0.1 eq), and sodium tert-butoxide (3 eq) were dissolved in toluene and stirred at 100 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 17-1. (Yield: 75 %)

### Synthesis of Compound 17

Intermediate 17-1 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 17. (Yield: 21 %)

### Synthesis Example 18. Synthesis of Compound 18

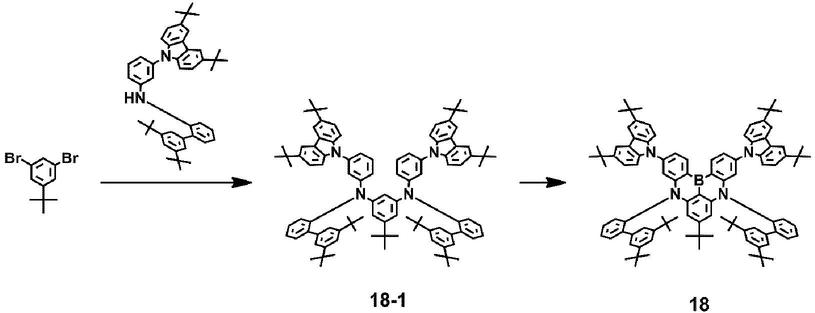

### Synthesis of Intermediate 18-1

1,3-dibromo-5-(tert-butyl)benzene (1 eq), 3',5'-di-tert-butyl-N-(3-(3,6-di-tert-butyl-9H-carbazol-9-yl)phenyl)-[1,1'-biphenyl]-2-amine (2.2 eq), tris(dibenzylideneacetone)dipalladium(0) (0.05 eq), tri-tert-butylphosphine (0.1 eq), and sodium tert-butoxide (3 eq) were dissolved in toluene and stirred at 100 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 18-1. (Yield: 66 %)

### Synthesis of Compound 18

Intermediate 18-1 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 18. (Yield: 17 %)

### Synthesis Example 19. Synthesis of Compound 19

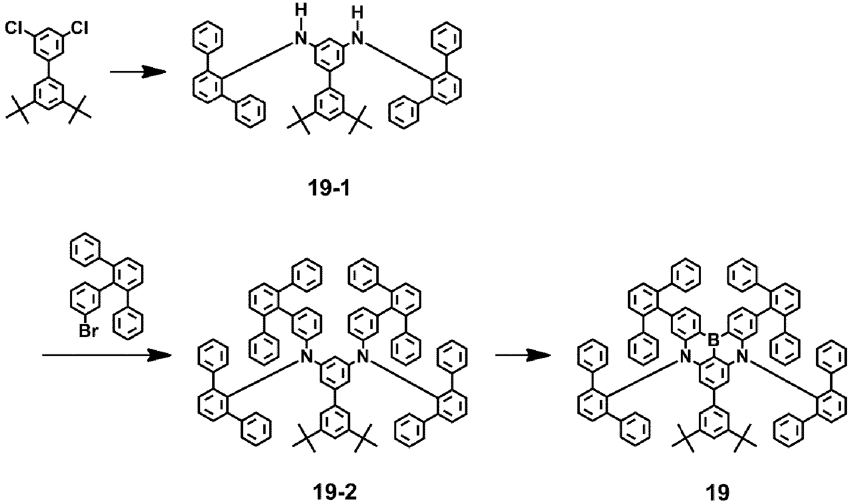

### Synthesis of Intermediate 19-1

3,5-di-tert-butyl-3',5'-dichloro-1,1'-biphenyl (1 eq), [1,1':3',1"-terphenyl]-2'-amine (2 eq), tris(dibenzylideneacetone)dipalladium(0) (0.05 eq), tri-tert-butylphosphine (0.1 eq), and sodium tert-butoxide (3 eq) were dissolved in toluene and stirred at 110 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 19-1. (Yield: 81 %)

### Synthesis of Intermediate 19-2

Intermediate 19-1 (1 eq), 3-bromo-6'-phenyl-1, 1 ':2', 1 "-terphenyl (4 eq), tris(dibenzylideneacetone)dipalladium(0) (0.15 eq), tri-tert-butylphosphine (0.3 eq) and sodium tert-butoxide (5 eq) were dissolved in o-xylene and stirred at 150 °C for 24 hours. After cooling and washing with ethyl acetate and water three times, the organic layer was separated therefrom, and dried over MgSO₄ under reduced pressure. The resulting product was purified by column chromatography with MC and n-hexane to obtain Intermediate 19-2. (Yield: 32 %)

### Synthesis of Compound 19

Intermediate 19-2 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 19. (Yield: 13 %)

### Synthesis Example 20. Synthesis of Compound 20

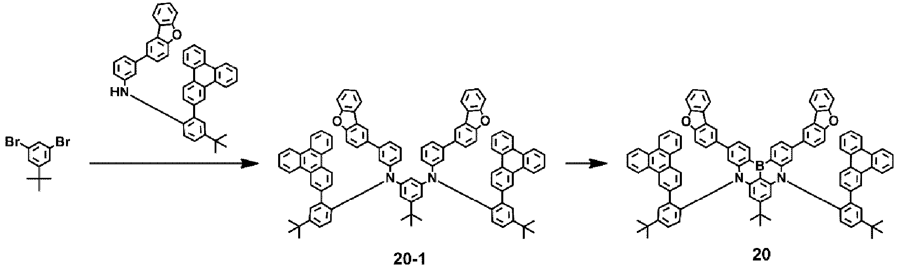

### Synthesis of Intermediate 20-1

1,3-dibromo-5-(tert-butyl)benzene (1 eq), 4-(tert-butyl)-N-(3-(dibenzo[b,d]furan-2-yl)phenyl)-2-(triphenylen-2-yl)aniline (2.2 eq), tris(dibenzylideneacetone)dipalladium(0) (0.05 eq), tri-tert-butylphosphine (0.1 eq), and sodium tert-butoxide (3 eq) were dissolved in toluene and stirred at 100 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 20-1. (Yield: 59 %)

### Synthesis of Compound 20

Intermediate 20-1 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 20. (Yield: 12 %)

### Synthesis Example 21. Synthesis of Compound 21

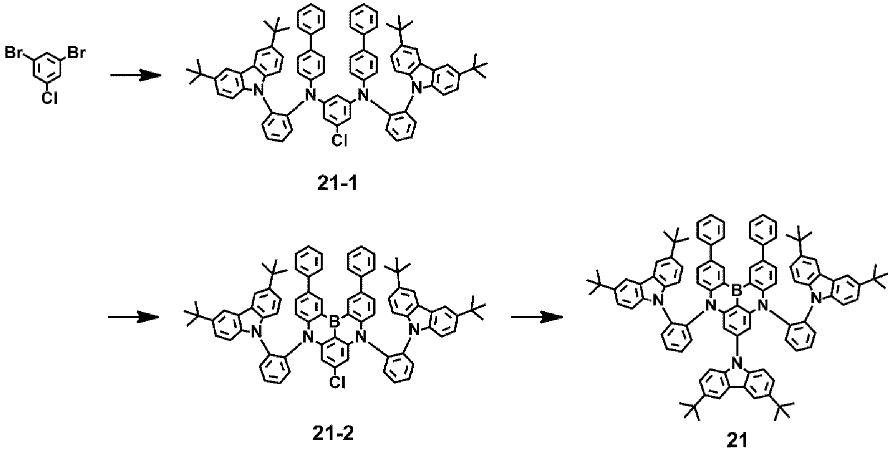

### Synthesis of Intermediate 21-1

1,3-dibromo-5-chlorobenzene (1 eq), N-(2-(3,6-di-tert-butyl-9H-carbazol-9-yl)phenyl)-[1,1'-biphenyl]-4-amine (2 eq), tris(dibenzylideneacetone)dipalladium(0) (0.05 eq), BINAP (0.1 eq), and sodium tert-butoxide (3 eq) were dissolved in toluene and stirred at 85 °C for 8 hours. After cooling and washing with ethyl acetate and water three times, the organic layer was separated therefrom, and dried over MgSO₄ under reduced pressure. The resulting product was purified by column chromatography with MC and n-hexane to obtain Intermediate 21-1. (Yield: 56 %)

### Synthesis of Intermediate 21-2

Intermediate 21-1 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Intermediate 21-2. (Yield: 28 %)

### Synthesis of Compound 21

Intermediate 21-2 (1 eq), 3,6-di-tert-butyl-9H-carbazole (1.5 eq), tris(dibenzylideneacetone)dipalladium(0) (0.05 eq), tri-tert-butylphosphine (0.1 eq), and sodium tert-butoxide (3 eq) were dissolved in toluene and stirred at 110 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Compound 21. (Yield: 77 %)

### Synthesis Example 22. Synthesis of Compound 22

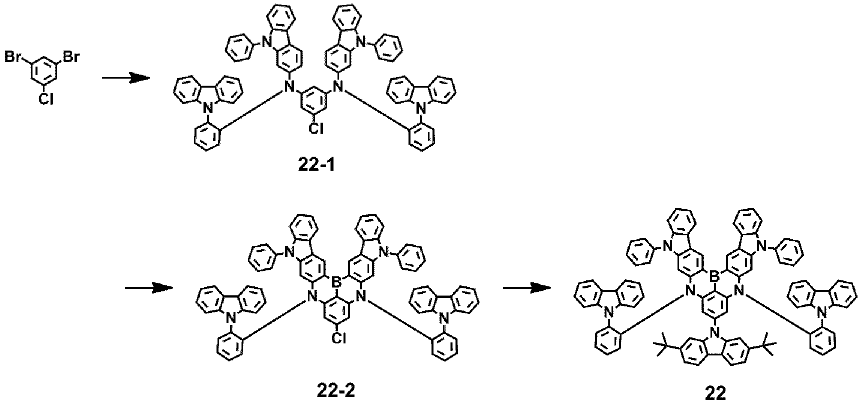

### Synthesis of Intermediate 22-1

1,3-dibromo-5-chlorobenzene (1 eq), N-(2-(9H-carbazol-9-yl)phenyl)-9-phenyl-9H-carbazol-2-amine (2 eq), tris(dibenzylideneacetone)dipalladium (0) (0.05 eq), BINAP (0.1 eq), and sodium tert-butoxide (3 eq) were dissolved in toluene and stirred at 85 °C for 8 hours. After cooling and washing with ethyl acetate and water three times, the organic layer was separated therefrom, and dried over MgSO₄ under reduced pressure. The resulting product was purified by column chromatography with MC and n-hexane to obtain Intermediate 22-1. (Yield: 57 %)

### Synthesis of Intermediate 22-2

Intermediate 22-1 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Intermediate 22-2. (Yield: 23 %)

### Synthesis of Compound 22

Intermediate 22-2 (1 eq), 2,7-di-tert-butyl-9H-carbazole (1.5 eq), tris(dibenzylideneacetone)dipalladium(0) (0.05 eq), tri-tert-butylphosphine (0.1 eq), and sodium tert-butoxide (3 eq) were dissolved in toluene and stirred at 110 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Compound 22. (Yield: 73 %)

### Synthesis Example 23. Synthesis of Compound 23

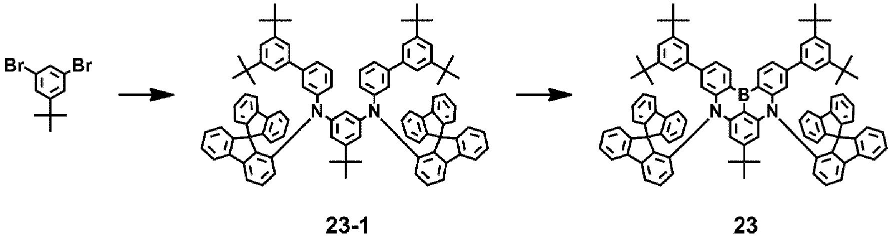

### Synthesis of Intermediate 23-1

1,3-dibromo-5-(tert-butyl)benzene (1 eq), N-(3',5'-di-tert-butyl-[1,1'-biphenyl]-3-yl)-9,9'-spirobi[fluoren]-1-amine (2.2 eq), tris(dibenzylideneacetone)dipalladium(0) (0.05 eq), tri-tert-butylphosphine (0.1 eq), and sodium tert-butoxide (3 eq) were dissolved in toluene and stirred at 100 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 23-1. (Yield: 68 %)

### Synthesis of Compound 23

Intermediate 23-1 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 23. (Yield: 8 %)

### Synthesis Example 24. Synthesis of Compound 24

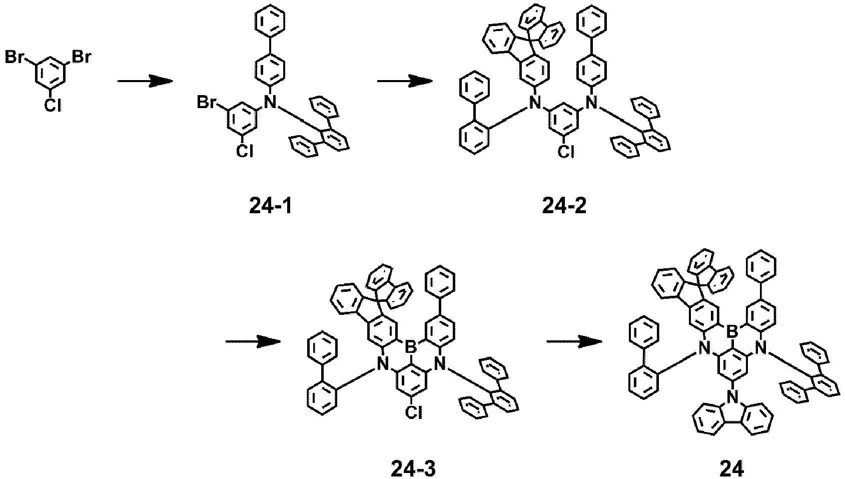

### Synthesis of Intermediate 24-1

1,3-dibromo-5-chlorobenzene (1 eq), N-([1,1'-biphenyl]-4-yl)-[1,1':3',1"-terphenyl]-2'-amine (0.9 eq), tris(dibenzylideneacetone)dipalladium(0) (0.05 eq), BINAP (0.1 eq), and sodium tert-butoxide (3 eq) were dissolved in toluene and stirred at 85 °C for 8 hours. After cooling and washing with ethyl acetate and water three times, the organic layer was separated therefrom, and dried over MgSO₄ under reduced pressure. The resulting product was purified by column chromatography with MC and n-hexane to obtain Intermediate 24-1. (Yield: 48 %)

### Synthesis of Intermediate 24-2

Intermediate 24-1 (1 eq), N-([1,1'-biphenyl]-2-yl)-9,9'-spirobi[fluoren]-3-amine (0.9 eq), tris(dibenzylideneacetone)dipalladium(0) (0.05 eq), BINAP (0.1 eq), and sodium tert-butoxide (3 eq) were dissolved in toluene and stirred at 85 °C for 8 hours. After cooling and washing with ethyl acetate and water three times, the organic layer was separated therefrom, and dried over MgSO₄ under reduced pressure. Intermediate 24-2 was obtained by purifying the organic layer by column chromatography with MC and n-hexane. (Yield: 56 %)

### Synthesis of Intermediate 24-3

Intermediate 24-2 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Intermediate 24-2. (Yield: 18 %)

### Synthesis of Compound 24

Intermediate 24-3 (1 eq), carbazole (1.5 eq), tris(dibenzylideneacetone)dipalladium(0) (0.05 eq), tri-tert-butylphosphine (0.1 eq), and sodium tert-butoxide (3 eq) were dissolved in toluene and stirred at 110 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Compound 24. (Yield: 80 %)

### Synthesis Example 25. Synthesis of Compound 25

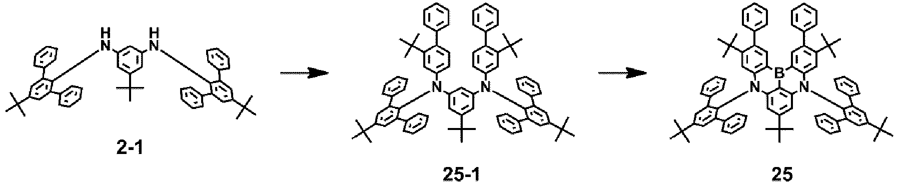

### Synthesis of Intermediate 25-1

Intermediate 2-1 (1 eq), 4-bromo-2-(tert-butyl)-1,1'-biphenyl (3.5 eq), tris(dibenzylideneacetone)dipalladium(0) (0.15 eq), tri-tert-butylphosphine (0.3 eq) and sodium tert-butoxide (5 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 25-1. (Yield: 42 %)

### Synthesis of Compound 25

Intermediate 25-1 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 25. (Yield: 19 %)

### Synthesis Example 26. Synthesis of Compound 26

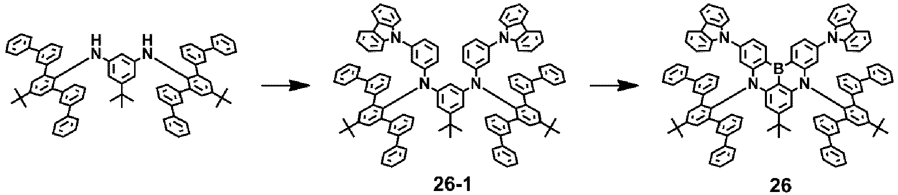

### Synthesis of Intermediate 26-1

5-(tert-butyl)-N1,N3-bis(5"-(tert-butyl)-[1,1':3',1":3",1‴:3‴,1ʺʺ-quinquephenyl]-2"-yl)benzene-1,3-diamine (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (5 eq) were dissolved in toluene and stirred at 150 °C for 60 hours. After cooling and washing with ethyl acetate and water three times, the organic layer was separated therefrom, and dried over MgSO₄ under reduced pressure. The resulting product was purified by column chromatography with MC and n-hexane to obtain Intermediate 26-1. (Yield: 33 %)

### Synthesis of Compound 26

Intermediate 26-1 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 26. (Yield: 14 %)

### Synthesis Example 27. Synthesis of Compound 27

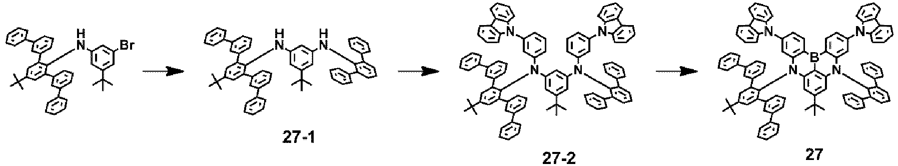

### Synthesis of Intermediate 27-1

N-(3-bromo-5-(tert-butyl)phenyl)-5"-(tert-butyl)-[1,1':3',1":3",1‴:3‴,1ʺʺ-quinquephenyl]-2"-amine (1 eq), [1,1':3',1"-terphenyl]-2'-amine (1 eq), tris(dibenzylideneacetone)dipalladium (0) (0.05 eq), tri-tert-butylphosphine (0.1 eq), and sodium tert-butoxide (3 eq) were dissolved in toluene and stirred at 100 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 27-1. (Yield: 84 %)

### Synthesis of Intermediate 27-2

Intermediate 27-1 (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (5 eq) were dissolved in toluene and stirred at 150 °C for 60 hours. After cooling and washing with ethyl acetate and water three times, the organic layer was separated therefrom, and dried over MgSO₄ under reduced pressure. The resulting product was purified by column chromatography with MC and n-hexane to obtain Intermediate 27-2. (Yield: 33 %)

### Synthesis of Compound 27

Intermediate 27-2 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 27. (Yield: 13 %)

### Synthesis Example 28. Synthesis of Compound 28

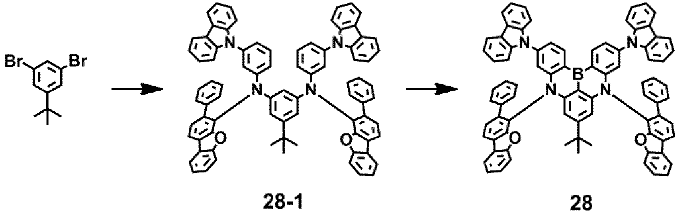

### Synthesis of Intermediate 28-1

1,3-dibromo-5-(tert-butyl)benzene (1 eq), N-(3-(9H-carbazol-9-yl)phenyl)-3-phenyldibenzo[b,d]furan-4-amine (2.2 eq), tris(dibenzylideneacetone)dipalladium(0) (0.05 eq), tri-tert-butylphosphine (0.1 eq), and sodium tert-butoxide (3 eq) were dissolved in toluene and stirred at 110 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 28-1. (Yield: 70 %)

### Synthesis of Compound 28

Intermediate 28-1 (1 eq) was dissolved in ortho dichlorobenzene and cooled to 0 °C, and BBr₃ (3 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 28. (Yield: 15 %)

### Synthesis Example 29. Synthesis of Compound 29

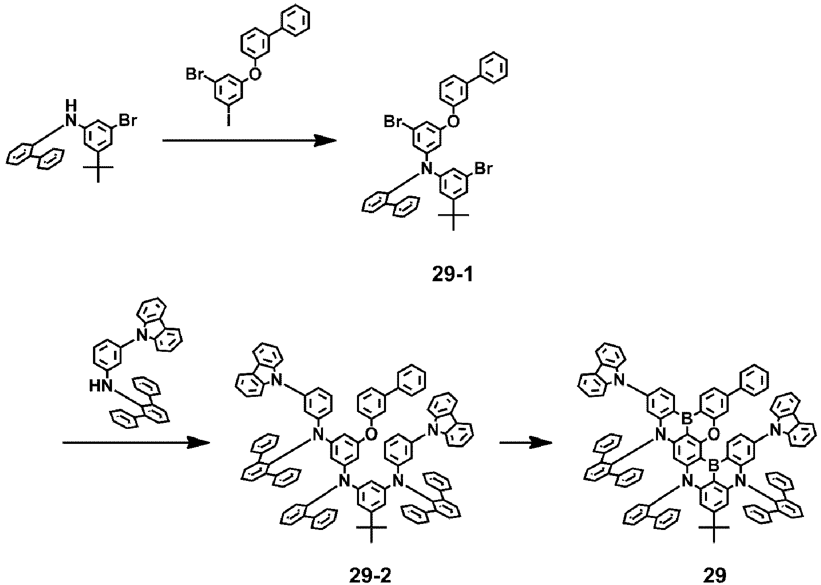

### Synthesis of Intermediate 29-1

N-(3-bromo-5-(tert-butyl)phenyl)-[1,1'-biphenyl]-2-amine (1 eq), 3-(3-bromo-5-iodophenoxy)-1,1'-biphenyl (131 eq), tris(dibenzylideneacetone)dipalladium(0) (0.05 eq), tri-tert-butylphosphine (0.1 eq), and sodium tert-butoxide (3 eq) were dissolved in toluene and stirred at 800 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 29-1 (Yield: 54 %)

### Synthesis of Intermediate 29-2

Intermediate 29-1 (1 eq), N-(3-(9H-carbazol-9-yl)phenyl)-[1,1':3',1"-terphenyl]-2'-amine (3 eq), tris(dibenzylideneacetone)dipalladium(0) (0.15 eq), tri-tert-butylphosphine (0.3 eq), and sodium tert-butoxide (5 eq) were dissolved in toluene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 29-2. (Yield: 31 %)

### Synthesis of Compound 29

Intermediate 29-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 29. (Yield: 25 %)

### Synthesis Example 30. Synthesis of Compound 30

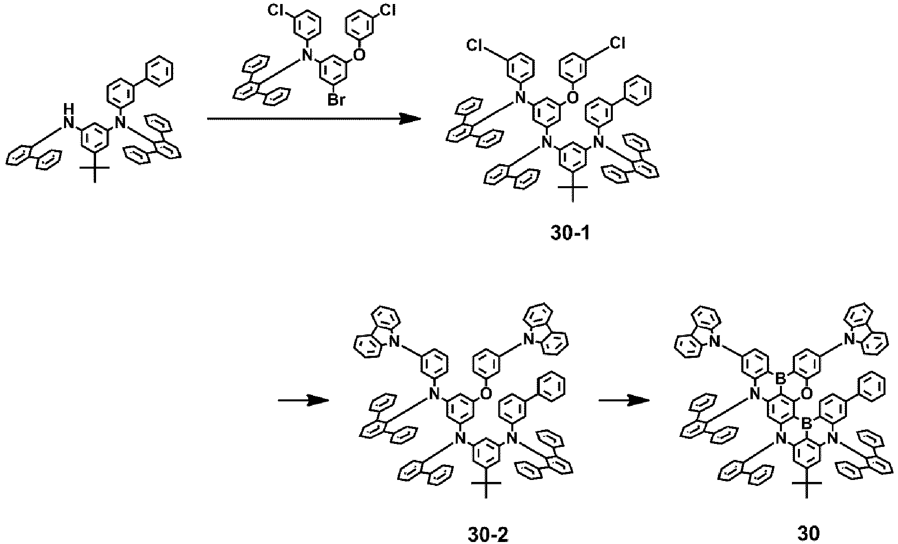

### Synthesis of Intermediate 30-1

N1-([1,1'-biphenyl]-2-yl)-N3-([1,1'-biphenyl]-3-yl)-N3-([1,1':3',1"-terphenyl]-2'-yl)-5-(tert-butyl)benzene-1,3-diamine (1 eq), N-(3-bromo-5-(3-chlorophenoxy)phenyl)-N-(3-chlorophenyl)-[1,1':3',1"-terphenyl]-2'-amine (1.1 eq), tris(dibenzylideneacetone)dipalladium(0) (0.05 eq), BINAP (0.1 eq), and sodium tert-butoxide (3 eq) were dissolved in toluene and stirred at 90 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 30-1. (Yield: 29 %)

### Synthesis of Intermediate 30-2

Intermediate 30-1 (1 eq), carbazole (2.2 eq), tris(dibenzylideneacetone)dipalladium(0) (0.05 eq), tri-tert-butylphosphine (0.1 eq), and sodium tert-butoxide (3 eq) were dissolved in toluene and stirred at 100 °C for 12 hours. After cooling and washing with ethyl acetate and water three times, the organic layer was separated therefrom, and dried over MgSO₄ under reduced pressure. The resulting product was purified by column chromatography with MC and n-hexane to obtain Intermediate 30-2. (Yield: 80 %)

### Synthesis of Compound 30

Intermediate 30-2 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 30. (Yield: 15 %)

### Synthesis Example 31. Synthesis of Compound 31

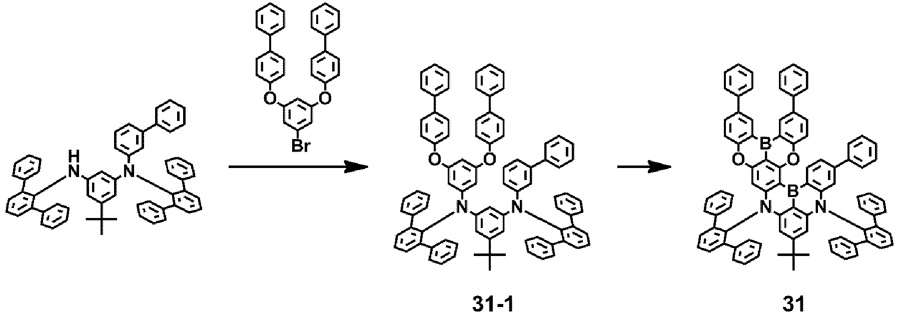

### Synthesis of Intermediate 31-1

N1-([1,1'-biphenyl]-3-yl)-N1,N3-di([1,1':3',1"-terphenyl]-2'-yl)-5-(tert- butyl)benzene-1,3-diamine (1 eq), 4,4"-((5-bromo-1,3-phenylene)bis(oxy))di-1,1'-biphenyl (1.5 eq), tris(dibenzylideneacetone)dipalladium(0) (0.15 eq), tri-tert-butylphosphine (0.3 eq), and sodium tert-butoxide (5 eq) were dissolved in o-xylene and stirred at 150 °C for 48 hours. After cooling and washing with ethyl acetate and water three times, the organic layer was separated therefrom, and dried over MgSO₄ under reduced pressure. The resulting product was purified by column chromatography with MC and n-hexane to obtain Intermediate 31-1. (Yield: 38 %)

### Synthesis of Compound 31

Intermediate 31-1 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 31. (Yield: 29 %)

### Synthesis Example 32. Synthesis of Compound 32

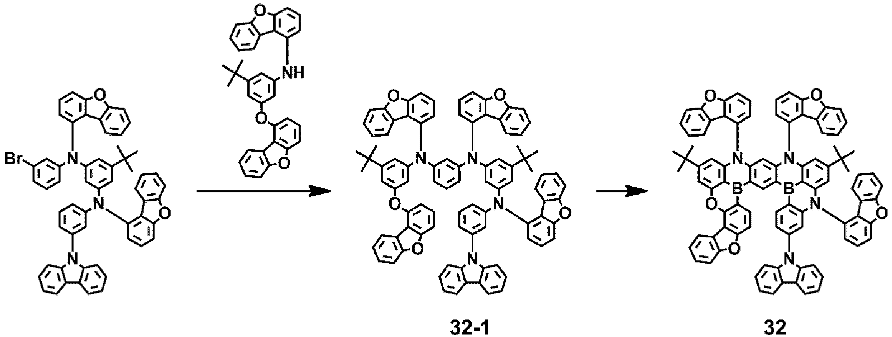

### Synthesis of Intermediate 32-1

N1-(3-(9H-carbazol-9-yl)phenyl)-N3-(3-bromophenyl)-5-(tert-butyl)-N1,N3-bis(dibenzo[b,d]furan-1-yl)benzene-1,3-diamine (1 eq), N-(3-(tert-butyl)-5-(dibenzo[b,d]furan-1-yloxy)phenyl)dibenzo[b,d]furan-1-amine (1 eq), tris(dibenzylideneacetone)dipalladium(0) (0.15 eq), tri-tert-butylphosphine (0.2 eq), and sodium tert-butoxide (5 eq) were dissolved in o-xylene and stirred at 150 °C for 36 hours. After cooling and washing with ethyl acetate and water three times, the organic layer was separated therefrom, and dried over MgSO₄ under reduced pressure. The resulting product was purified by column chromatography with MC and n-hexane to obtain Intermediate 32-1. (Yield: 48 %)

### Synthesis of Compound 32

Intermediate 32-1 (1 eq) was dissolved in ortho dichlorobenzene and cooled to 0 °C, and BBr₃ (5 eq) was slowly injected thereto in a nitrogen atmosphere. After completion by adding dropwise, the temperature was raised to 180 °C, followed by stirring for 24 hours. After cooling, triethylamine was slowly added dropwise into the flask containing the reactant to terminate reaction, and ethyl alcohol was added into the reactant to cause precipitation, thereby obtaining a reaction product. The obtained solid was purified by column chromatography with MC and n-hexane, and recrystallized using toluene and acetone to obtain Compound 32. (Yield: 6 %)

Evaluation Example 1. Surface area to volume values and molecular weight measurements

The surface area and volume values for the above compounds and compounds of comparative examples were measured, and the results of dividing the surface area by the volume and the molecular weight measurements are shown in Tables 1 and 2.

**[Table 1]**

| **Compound No.** | **Surface area (SA) [Å²]** | **Volume (V) [Å³]** | **Surface area/volume (SAN) [Å-1]** | **Molecular weight [MW]** |
|---|---|---|---|---|
| 1 | 906.98 | 1063.32 | 0.8530 | 1042.11 |
| 2 | 986.34 | 1119.71 | 0.8809 | 1045.23 |
| 3 | 921.49 | 1148.45 | 0.8024 | 1113.18 |
| 4 | 915.25 | 1053.11 | 0.8691 | 1022.12 |
| 5 | 1234.06 | 1435.4 | 0.8597 | 1335.64 |
| 6 | 1054.11 | 1212.92 | 0.8691 | 1221.28 |
| 7 | 1371.07 | 1571.34 | 0.8725 | 1203.44 |
| 8 | 1059.43 | 1321.59 | 0.8016 | 1263.41 |
| 9 | 1369.29 | 1576.8 | 0.8684 | 1447.86 |
| 10 | 973.29 | 1141.15 | 0.8529 | 1111.21 |
| 11 | 1104.27 | 1283.27 | 0.8605 | 1223.43 |
| 12 | 1265.11 | 1425.31 | 0.8876 | 1335.63 |
| 13 | 1285.92 | 1620.45 | 0.7936 | 1447.86 |
| 14 | 1310.14 | 1600.55 | 0.8186 | 1463.96 |
| 15 | 1295.66 | 1618.07 | 0.8007 | 1463.96 |
| 16 | 989.59 | 1118.68 | 0.8846 | 1113.18 |
| 17 | 989.19 | 1121.6 | 0.8819 | 1139.18 |
| 18 | 1346.41 | 1561.04 | 0.8625 | 1407.43 |
| 19 | 1187.13 | 1474.91 | 0.8049 | 1369.62 |
| 20 | 1138.74 | 1420.72 | 0.8015 | 1373.56 |
| 21 | 1229.49 | 1549.76 | 0.7933 | 1404.75 |
| 22 | 1089.22 | 1406.65 | 0.7743 | 1358.51 |
| 23 | 1105.28 | 1437.3 | 0.7690 | 1329.64 |
| 24 | 972.55 | 1137.85 | 0.8547 | 1128.20 |
| 25 | 1073.16 | 1286.61 | 0.8341 | 1157.45 |
| 26 | 1343.62 | 1603.21 | 0.838 | 1572.82 |
| 27 | 1137.17 | 1381.49 | 0.8231 | 1319.82 |
| 28 | 999.29 | 1111.31 | 0.8992 | 1139.18 |
| 29 | 1288.07 | 1561.06 | 0.8251 | 1530.50 |
| 30 | 1299.3 | 1561.11 | 0.832 | 1530.50 |
| 31 | 1061.19 | 1227.86 | 0.8643 | 1201.10 |
| 32 | 1103.79 | 1280.26 | 0.8622 | 1325.15 |

**[Table 2]**

| **Compound No.** | **Surface area (SA) [Å²]** | **Volume (V) [Å³]** | **Surface area/volume (SAN) [Å-1]** | **Molecular weight [MW]** |
|---|---|---|---|---|
| DABNA-1 | 403.53 | 409.87 | 0.9845 | 420.32 |
| DABNA-2 | 718.55 | 731.48 | 0.9823 | 739.73 |
| t-DABNA | 661 | 704.63 | 0.9381 | 644.75 |
| CzB | 630.58 | 674.14 | 0.9354 | 640.72 |
| a | 566.32 | 578.49 | 0.9790 | 587.53 |
| b | 1072.89 | 1102.01 | 0.9736 | 1118.20 |
| c | 844.06 | 870.23 | 0.9699 | 902.91 |
| d | 852.45 | 898.86 | 0.9484 | 886.02 |
| e | 877.03 | 1035.57 | 0.8469 | 938.12 |
| f | 775.44 | 890.18 | 0.8711 | 811.04 |
| 9 | 994.73 | 1044.95 | 0.9519 | 997.20 |
| h | 976.73 | 1030.83 | 0.9475 | 1055.10 |
| i | 685.43 | 773.88 | 0.8857 | 724.80 |
| j | 633.18 | 702.98 | 0.9007 | 654.75 |
| k | 835.28 | 875.03 | 0.9546 | 889.91 |
| v-DABNA | 1028.91 | 1073.47 | 0.9585 | 1096.95 |
| l | 835.69 | 990.44 | 0.8438 | 928.04 |
| m | 851.32 | 1029.4 | 0.8270 | 968.11 |
| n | 851.56 | 1072.66 | 0.7939 | 949.15 |
| o | 852.15 | 947.74 | 0.8991 | 919.98 |
| p | 866.18 | 972.01 | 0.8911 | 928.04 |

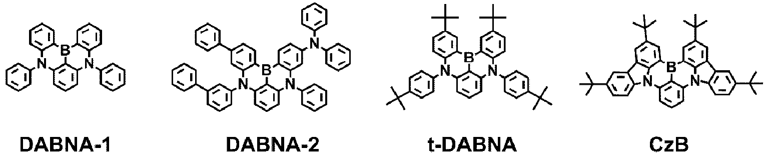

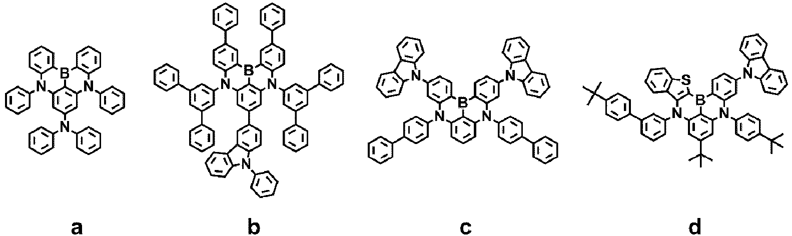

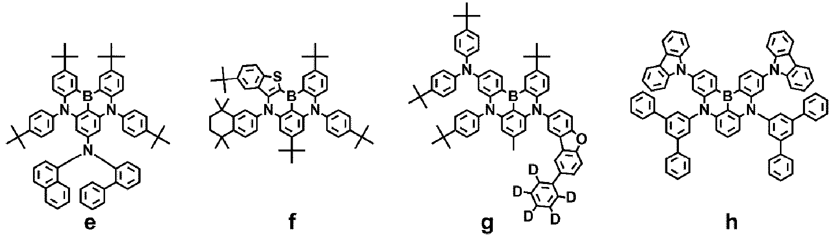

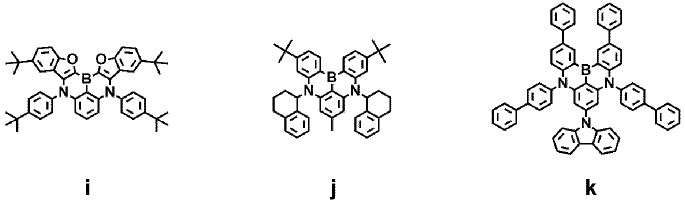

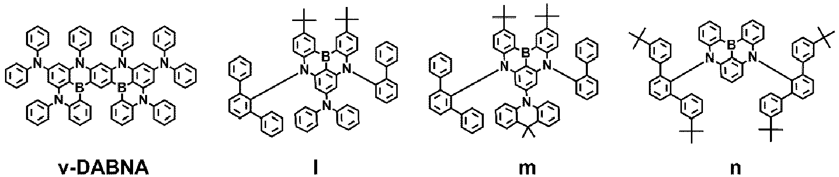

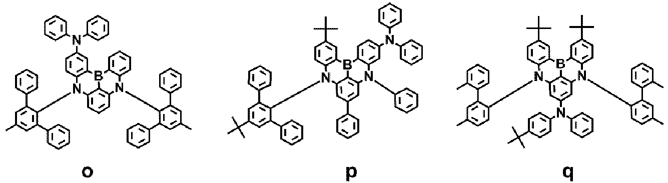

### Evaluation Example 2. Sublimation temperature

1 g of compound powder was placed at one end of a sublimation purification tube, and an additional long tube was connected thereto. The sublimation purification tube was placed into a sublimation purifier, set to high vacuum, and set to high temperature. The part where the compound was located was set to the highest temperature, the temperature in each section was set to decrease as the distance increased, so that the sublimated substances were each formed back into a liquid or solid at a different location depending on the molecular weight. The sublimation temperature was measured. The results are shown in the Table 3.

**[Table 3]**

| **Compound No.** | **Sublimation temperature (°C)** | **Compound No.** | **Sublimation temperature (°C)** |
|---|---|---|---|
| 1 | 325 | DABNA-1 | 230 |
| 2 | 310 | DABNA-2 | 280 |
| 3 | 285 | t-DABNA | 260 |
| 4 | 310 | CzB | 280 |
| 5 | 350 | a | 260 |
| 6 | 355 | b | 390 |
| 7 | 360 | c | 370 |
| 8 | 330 | d | 300 |
| 9 | 330 | e | 290 |
| 10 | 355 | 9 | 280 |
| 11 | 320 | h | 380 |
| 12 | 360 | i | 300 |
| 13 | 330 | j | 260 |
| 14 | 325 | k | 340 |
| 15 | 325 | v-DABNA | 435 |
| 16 | 320 | l | 320 |
| 17 | 340 | m | 320 |
| 18 | 340 | n | 280 |
| 19 | 320 | o | 330 |
| 20 | 360 | p | 310 |
| 21 | 355 | q | 330 |
| 22 | 355 | | |
| 23 | 345 | | |
| 24 | 335 | | |
| 25 | 285 | | |
| 26 | 330 | | |
| 27 | 325 | | |
| 28 | 320 | | |
| 29 | 365 | | |
| 30 | 365 | | |
| 31 | 330 | | |
| 32 | 355 | | |

### Example 1

As an anode, a substrate on which ITO was deposited was cut to a size of 50 mm x 50 mm x 0.5 mm, sonicated with isopropyl alcohol and pure water each for 5 minutes, cleaned by irradiation of ultraviolet rays and exposure to ozone for 30 minutes, and the ITO substrate was installed on a vacuum deposition apparatus.

Compound HT3 doped with HAT-CN was deposited on the ITO substrate to form a hole injection layer with a thickness of 100 Å, and Compound HT3 was vacuum deposited on the hole injection layer to form a hole transport layer with a thickness of 600 Å. An electron blocking layer with a thickness of 50 Å was formed on the hole transport layer by using Compound HTH29.

Compound HTH29 (second compound), Compound ETH66 (third compound), Compound PD38 (fourth compound), and Compound 1 (first compound) were co-deposited on the electron blocking layer with a respective weight ratio of 56.3 wt%:30.3 wt%:13 wt%:0.4 wt%, to form an emission layer with a thickness of 300 Å.

Compound ETH2 was deposited on the emission layer to form a hole blocking layer with a thickness of 50 Å. Compound ETH2:Liq was deposited on the hole blocking layer at a ratio of 5:5 to form an electron transport layer with a thickness of 310 Å.

LiF with a thickness of 15 Å was formed on the electron transport layer, and AI was deposited thereon to form a cathode with a thickness of 800 Å, thereby completing the manufacture of a light-emitting device.

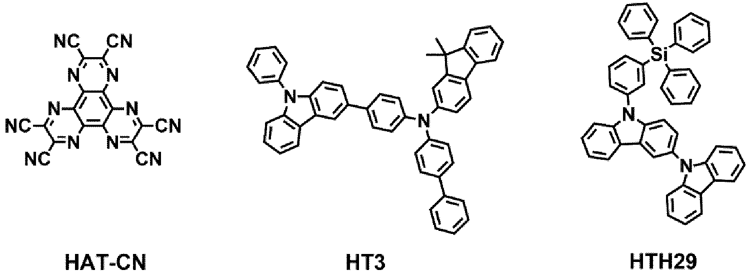

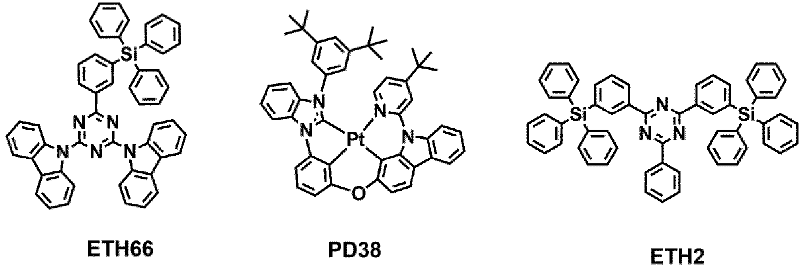

### Examples and Comparative Examples

Light-emitting devices were manufactured using the same method as in Example 1, except that the first to fourth compounds were changed as shown in Table 4 when forming the emission layer.

### Evaluation example 3

The driving voltage (V), luminescence efficiency (cd/A), maximum emission wavelength (nm), and lifespan at a luminance of 1,000 cd/m² of the light-emitting devices manufactured in the examples and comparative examples were each measured by using Keithley SMU 236 and a luminance meter PR650, and the results are shown in Table 4. In Table 4, the lifespan (T₉₅) is a measure of the time taken until the luminance declines to 95 % of the initial luminance, and the lifespan value is expressed based on Comparative Example 3.

**[Table 4]**

| | **First compo und** | **Second compou nd** | **Third compou nd** | **Fourth compo und** | **Driving voltage (V)** | **Luminescence Efficiency (cd/A)** | **Emission wavelength (nm)** | **Lifespa n (T₉₅)** |
|---|---|---|---|---|---|---|---|---|
| Exampl e 1 | 1 | HTH29 | ETH66 | PD38 | 4.3 | 26.6 | 457 | 6.8 |
| Exampl e2 | 2 | HTH29 | ETH66 | PD38 | 4.4 | 28.4 | 463 | 8.1 |
| Exampl e3 | 3 | HTH29 | ETH66 | PD38 | 4.3 | 27.8 | 461 | 8.3 |
| Exampl e 4 | 4 | HTH29 | ETH66 | PD38 | 4.4 | 28.3 | 461 | 7.3 |
| Exampl e5 | 5 | HTH29 | ETH66 | PD38 | 4.1 | 28.2 | 459 | 8.6 |
| Exampl e6 | 6 | HTH29 | ETH66 | PD38 | 4.2 | 27.9 | 460 | 8.2 |
| Exampl e7 | 7 | HTH29 | ETH66 | PD38 | 4.3 | 27.8 | 463 | 6.8 |
| Exampl e8 | 8 | HTH29 | ETH66 | PD38 | 4.3 | 27.5 | 460 | 8.1 |
| Exampl e9 | 9 | HTH29 | ETH66 | PD38 | 4.2 | 27.6 | 459 | 8.3 |
| Exampl e 10 | 10 | HTH29 | ETH66 | PD38 | 4.3 | 28.0 | 461 | 8.4 |
| Exampl e 11 | 11 | HTH29 | ETH66 | PD38 | 4.4 | 27.8 | 461 | 8.5 |
| Exampl e 12 | 12 | HTH29 | ETH66 | PD38 | 4.5 | 27.6 | 462 | 7.4 |
| Exampl e 13 | 13 | HTH29 | ETH66 | PD38 | 4.3 | 28.2 | 460 | 8.4 |
| Exampl e 14 | 14 | HTH29 | ETH66 | PD38 | 4.4 | 28.6 | 461 | 8.6 |
| Exampl e 15 | 15 | HTH29 | ETH66 | PD38 | 4.3 | 28.4 | 459 | 8.0 |
| Exampl e 16 | 16 | HTH29 | ETH66 | PD38 | 4.4 | 27.3 | 462 | 6.5 |
| Exampl e 17 | 17 | HTH29 | ETH66 | PD38 | 4.4 | 27.8 | 464 | 7.7 |
| Exampl e 18 | 18 | HTH29 | ETH66 | PD38 | 4.3 | 27.1 | 462 | 7.1 |
| Exampl e 19 | 19 | HTH29 | ETH66 | PD38 | 4.4 | 27.3 | 465 | 6.6 |
| Exampl e 20 | 20 | HTH29 | ETH66 | PD38 | 4.5 | 27.2 | 464 | 6.8 |
| Exampl e 21 | 21 | HTH29 | ETH66 | PD38 | 4.2 | 26.5 | 458 | 6.4 |
| Exampl e 22 | 22 | HTH29 | ETH66 | PD38 | 4.3 | 26.6 | 460 | 6.8 |
| Exampl e 23 | 23 | HTH29 | ETH66 | PD38 | 4.4 | 26.7 | 459 | 6.4 |
| Exampl e 24 | 24 | HTH29 | ETH66 | PD38 | 4.4 | 27.4 | 461 | 7.1 |
| Exampl e 25 | 25 | HTH29 | ETH66 | PD38 | 4.2 | 26.3 | 459 | 6.9 |
| Exampl e 26 | 26 | HTH29 | ETH66 | PD38 | 4.3 | 28.2 | 461 | 8.5 |
| Exampl e 27 | 27 | HTH29 | ETH66 | PD38 | 4.4 | 27.8 | 460 | 8.5 |
| Exampl e 28 | 28 | HTH29 | ETH66 | PD38 | 4.4 | 28.2 | 459 | 7.9 |
| Exampl e 29 | 29 | HTH29 | ETH66 | PD38 | 4.3 | 27.3 | 456 | 8.3 |
| Exampl e 30 | 30 | HTH29 | ETH66 | PD38 | 4.4 | 27.8 | 464 | 8.8 |
| Exampl e 31 | 31 | HTH29 | ETH66 | PD38 | 4.2 | 27.5 | 458 | 8.5 |
| Exampl e 32 | 32 | HTH29 | ETH66 | PD38 | 4.3 | 26.9 | 464 | 8.8 |
| Compa rative Exampl e1 | DABNA -1 | HTH29 | ETH66 | PD38 | 5.3 | 15.6 | 458 | 0.5 |
| Compa rative Exampl e2 | DABNA -2 | HTH29 | ETH66 | PD38 | 5.5 | 17.6 | 462 | 0.7 |
| Compa rative Exampl e 3 | t-DABNA | HTH29 | ETH66 | PD38 | 5.2 | 16.3 | 463 | 1 |
| Compa rative Exampl e 4 | CzB | HTH29 | ETH66 | PD38 | 4.9 | 13.4 | 483 | 1.5 |
| Compa rative Exampl e5 | a | HTH29 | ETH66 | PD38 | 5.5 | 17.8 | 455 | 2.2 |
| Compa rative Exampl e6 | b | HTH29 | ETH66 | PD38 | 4.9 | 19.6 | 469 | 3.1 |
| Compa rative Exampl e7 | c | HTH29 | ETH66 | PD38 | 4.8 | 19.8 | 461 | 3.6 |
| Compa rative Exampl e8 | d | HTH29 | ETH66 | PD38 | 5.6 | 12.6 | 462 | 0.6 |
| Compa rative Exampl e9 | f | HTH29 | ETH66 | PD38 | 5.6 | 12.1 | 463 | 0.3 |
| Compa rative Exampl e 10 | h | HTH29 | ETH66 | PD38 | 5.0 | 19.3 | 462 | 4.2 |
| Compa rative Exampl e 11 | k | HTH29 | ETH66 | PD38 | 4.8 | 20.2 | 459 | 3.9 |
| Compa rative Exampl e 12 | v-DABNA | HTH29 | ETH66 | PD38 | 5.4 | 21.3 | 468 | 3.1 |
| Compa rative Exampl e 13 | L | HTH29 | ETH66 | PD38 | 5.5 | 18.7 | 460 | 2.0 |
| Compa rative Exampl e 14 | N | HTH29 | ETH66 | PD38 | 5.7 | 15.5 | 458 | 2.1 |
| Compa rative Exampl e 15 | P | HTH29 | ETH66 | PD38 | 5.4 | 17.2 | 462 | 1.7 |

From Table 4, it can be seen that the light-emitting devices according to Examples 1 to 32 have excellent driving voltage, luminescence efficiency, and lifespan characteristics.

From Table 4, it can be seen that the light-emitting devices according to Examples 1 to 32 have improved driving voltage, luminescence efficiency, and lifespan characteristics compared to the light-emitting devices of Comparative Examples 1 to 15.

According to the embodiments, a light-emitting device may have excellent driving voltage, luminescence efficiency, and lifespan characteristics by comprising a condensed cyclic compound represented by Formula 1, and a high-quality electronic apparatus may be manufactured by using the light-emitting device.

Embodiments have been disclosed herein, and although terms are employed, they are used and are to be interpreted in a generic and descriptive sense only and not for purposes of limitation. In some instances, as would be apparent by one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the spirit and scope of the disclosure.

## Claims

**1.** A light-emitting device comprising:
a first electrode;
a second electrode facing the first electrode; and
an interlayer between the first electrode and the second electrode and comprising an emission layer, wherein
the interlayer comprises a condensed cyclic compound,
the condensed cyclic compound comprises a boron (B) atom,
a ratio of a surface area to volume of the condensed cyclic compound has a value less than or equal to about 0.9 Å⁻¹, and
a molecular weight of the condensed cyclic compound is greater than or equal to about 1,000 g/mol.

**2.** The light-emitting device of claim 1, wherein
the first electrode is an anode,
the second electrode is a cathode,
the interlayer further comprises:
a hole transport region between the first electrode and the emission layer; and
an electron transport region between the emission layer and the second electrode,
the hole transport region comprises a hole injection layer, a hole transport layer, an emission auxiliary layer, an electron blocking layer, or a combination thereof, and
the electron transport region comprises a hole blocking layer, an electron transport layer, an electron injection layer, or a combination thereof.

**3.** The light-emitting device of claim 1 or claim 2, wherein:
the emission layer comprises the condensed cyclic compound; OR
the emission layer comprises the condensed cyclic compound and the condensed cyclic compound in the emission layer is a thermally activated delayed fluorescence (TADF) emitter, and the emission layer emits delayed fluorescence.

**4.** The light-emitting device of any preceding claim, comprising:
a first compound comprising the condensed cyclic compound; and
a second compound comprising a group represented by Formula 20, a third compound comprising at least one π electron-deficient nitrogen-containing C₁-C₆₀ cyclic group, a fourth compound comprising a transition metal, or a combination thereof, wherein
the first compound, the second compound, the third compound, and the fourth compound are different from each other: 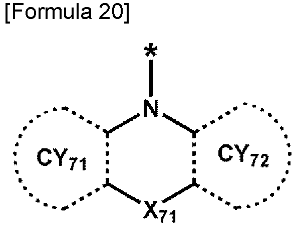
wherein in Formula 20,
ring CY₇₁ and ring CY₇₂ are each independently a π electron-rich C₃-C₆₀ cyclic group or a pyridine group,
X₇₁ is: a single bond; or a linking group comprising O, S, N, B, C, Si, or a combination thereof,
* is a binding site to a neighboring atom, and
CBP and mCBP are excluded from the second compound:

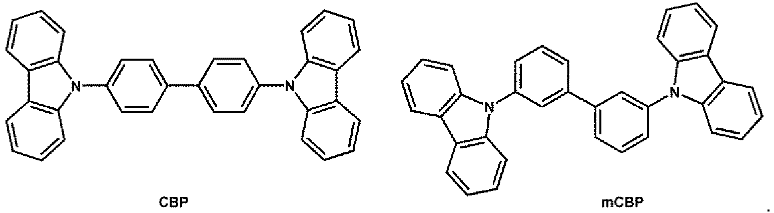

**5.** The light-emitting device of claim 4, wherein
the emission layer comprises:
the first compound comprising the condensed cyclic compound; and
at least one of the second compound and the third compound, and the emission layer optionally further comprises the fourth compound;
AND/OR wherein the third compound comprises a pyridine group, a pyrimidine group, a pyrazine group, a pyridazine group, a triazine group, or a combination thereof.

**5.** An electronic apparatus comprising the light-emitting device of any preceding claim.

**6.** The electronic apparatus of claim 5, further comprising:
a thin-film transistor, wherein
the thin-film transistor comprises a source electrode and a drain electrode, and
the first electrode of the light-emitting device is electrically connected to the source electrode or the drain electrode.

**7.** A condensed cyclic compound comprising:
a core comprising at least one cyclic group comprising a boron (B) atom and a nitrogen (N) atom each as a ring-forming atom, wherein
a ratio of a surface area to volume of the condensed cyclic compound has a value less than or equal to about 0.9 Å⁻¹, and
a molecular weight of the condensed cyclic compound is greater than or equal to about 1,000 g/mol.

**8.** The condensed cyclic compound of claim 7, wherein a sublimation temperature of the condensed cyclic compound is less than or equal to about 370 °C.

**9.** The condensed cyclic compound of claim 7 or 8, wherein at least one of hydrogen atoms of the core of the condensed cyclic compound is substituted with a substituent having a molecular weight greater than or equal to about 153 g/mol.

**10.** The condensed cyclic compound of claim 9, wherein
the core comprises at least two boron (B) atoms,
AND/OR the core comprises at least two nitrogen (N) atoms, and
one of the at least two nitrogen atoms is substituted with a substituent having a molecular weight greater than or equal to about 153 g/mol;
AND/OR the substituent having a molecular weight greater than or equal to about 153 g/mol comprises a group represented by Formula A: 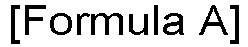 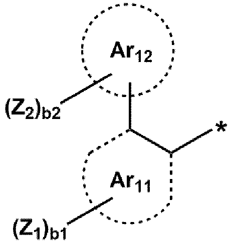
wherein in Formula A,
Ar₁₁ and Ar₁₂ are each independently a C₃-C₆₀ carbocyclic group or a C₁-C₆₀ heterocyclic group,
Z₁ and Z₂ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), -B(Q₁)(Q₂), -C(=O)(Q₁), - S(=O)₂(Q₁), or-P(=O)(Q₁)(Q₂),
two or more neighboring ones of Z₁ in the number of b1 are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of Z₂ in the number of b2 are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of Z₁ and Z₂ are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
b1 and b2 are each independently an integer from 0 to 10,
* indicates a binding site to a neighboring atom,
R₁₀ₐ and R_{10b} are each independently:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or a combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q1 to Q3, Q11 to Q13, Q21 to Q23, and Q31 to Q33 are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or a combination thereof.

**11.** The condensed cyclic compound of any one of claims 7 to 10, wherein
the core comprises a boron (B) atom and at least two nitrogen (N) atoms, and
one of the at least two nitrogen (N) atoms is substituted with a substituent that has a molecular weight greater than or equal to about 153 g/mol, and comprises two or more rings;
AND/OR the core comprises at least two boron (B) atoms and at least two nitrogen (N) atoms, and one of the at least two nitrogen (N) atoms is substituted with a substituent that has a molecular weight greater than or equal to about 153 g/mol, and comprises two or more rings.

**12.** The condensed cyclic compound of claim 11, wherein
in the substituent, the two or more rings comprised in the substituent are each independently a C₆-C₆₀ aryl group unsubstituted or substituted with at least one R₁₀ₐ, a C₁-C₆₀ heteroaryl group unsubstituted or substituted with at least one R₁₀ₐ, a non-aromatic condensed polycyclic group unsubstituted or substituted with at least one R₁₀ₐ, or a non-aromatic condensed heteropolycyclic group unsubstituted or substituted with at least one R₁₀ₐ,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or a combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁₁ to Q₁₃, Q₂₁ to Q₂₃, and Q₃₁ to Q₃₃ are each independently: hydrogen; deuterium; - F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or a combination thereof.

**13.** The condensed cyclic compound of any one of claims 7 to 12, wherein the condensed cyclic compound is represented by Formula 1: 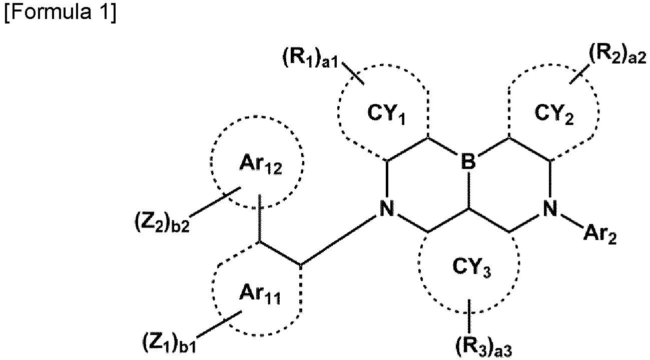
wherein in Formula 1,
ring CY₁ to ring CY₃, Ar₁₁, and Ar₁₂ are each independently a C₃-C₆₀ carbocyclic group or a C₁-C₆₀ heterocyclic group,
Ar₂ is a C₃-C₆₀ carbocyclic group unsubstituted or substituted with at least one R₁₀ₐ or a C₁-C₆₀ heterocyclic group unsubstituted or substituted with at least one R₁₀ₐ,
R₁ to R₃, Z₁, and Z₂ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
two or more neighboring ones of R₁ in the number of a1 are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of R₂ in the number of a2 are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of R₃ in the number of a3 are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of Z₁ in the number of b1 are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of Z₂ in the number of b2 are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of Z₁ and Z₂ are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
a1 to a3, b1, and b2 are each independently an integer from 0 to 10,
R₁₀ₐ and R_{10b} are each independently:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or a combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q1 to Q3, Q11 to Q13, Q21 to Q23, and Q31 to Q33 are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or a combination thereof.

**14.** The condensed cyclic compound of claim 13, wherein Ar₂ is a group represented by Formula B: 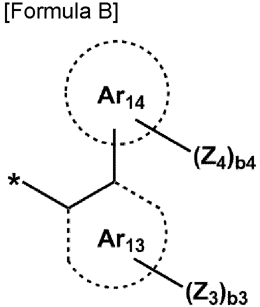
**wherein in** Formula B,
Ar₁₃ and Ar₁₄ are each independently a C₃-C₆₀ carbocyclic group or a C₁-C₆₀ heterocyclic group,
Z₃ and Z₄ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₁-C₆₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
two or more neighboring ones of Z₃ in the number of b3 are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones Z₄ in the number of b4 are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
two or more neighboring ones of Z₃ and Z₄ are optionally bonded to each other to form a C₅-C₃₀ carbocyclic group unsubstituted or substituted with at least one R_{10b} or a C₁-C₃₀ heterocyclic group unsubstituted or substituted with at least one R_{10b},
b3 and b4 are each independently an integer from 0 to 10,
* indicates a binding site to a neighboring atom,
R₁₀ₐ and R_{10b} are each independently:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or a combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q1 to Q3, Q11 to Q13, Q21 to Q23, and Q31 to Q33 are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or a combination thereof.

**15.** The condensed cyclic compound of claim 13 or 14, wherein
Ar₁₁ and Ar₁₂ are each independently a C₆-C₆₀ aryl group, a C₁-C₆₀ heteroaryl group, a non-aromatic condensed polycyclic group, or a non-aromatic condensed heteropolycyclic group;
AND/OR
a1 to a3 are each independently an integer from 1 to 10,
at least one of R₁ in the number of a1 is not hydrogen,
at least one of R₂ in the number of a2 is not hydrogen, and
at least one of R₃ in the number of a3 is not hydrogen.
